Europäisches Patentamt

European Patent Office

Office européen des brevets

(19)

(11) EP 1 523 099 A1

## (12) EUROPEAN PATENT APPLICATION

(43) Date of publication:
13.04.2005 Bulletin 2005/15

(21) Application number: 04009996.2

(22) Date of filing: 27.04.2004

(51) Int Cl.7: **H03M 13/05**, H03M 13/15, H03M 13/25, G06N 3/02, H03M 13/00, H04L 1/00, H04L 27/26, H03M 13/31

| | |
|---|---|
| (84) Designated Contracting States:<br>AT BE BG CH CY CZ DE DK EE ES FI FR GB GR<br>HU IE IT LI LU MC NL PL PT RO SE SI SK TR<br>Designated Extension States:<br>AL HR LT LV MK<br><br>(30) Priority: 13.06.2003 US 478690 P<br>23.09.2003 US 669066<br>19.11.2003 US 523272 P<br><br>(71) Applicant: **Broadcom Corporation**<br>**Irvine, California 92618-7013 (US)**<br><br>(72) Inventors:<br>• **Shen, Ba-Zhong**<br>**Irvine, CA 92606 (US)** | • **Lee, Tak K.**<br>**Irvine, CA, 92618 (US)**<br>• **Cameron, Kelly Brian, Dr.**<br>**Irvine, CA, 92620 (US)**<br>• **Tran, Hau Thien**<br>**Irvine, CA, 92612 (US)**<br><br>(74) Representative: **Jehle, Volker Armin, Dipl.-Ing.**<br>**Patentanwälte**<br>**Bosch, Graf von Stosch, Jehle,**<br>**Flüggenstrasse 13**<br>**80639 München (DE)** |

(54) **Multi-dimensional space gray maps for multi-dimensional phase modulation as applied to LDPC (low density parity check) coded modulation**

(57) Multi-dimensional space gray maps for multi-dimensional phase modulation as applied to LDPC (Low Density Parity Check) coded modulation. A novel approach is provided within LDPC coded modulation communication systems that employ multi-dimensional phase modulation, using $m$-D (multi-dimensional) Gray code maps, to provide for improved performance when compared to communication systems employing 1-D (single-dimensional) Gray code maps. This approach can generate all possible $m$-D Gray code maps for a $2m$-D $M$ PSK modulation system. For example, all of the 2-D Gray code maps may be generated for a communication system using 4-D 8 PSK modulation system (where $m$=2, and $M$=8). A variety decoding processing approaches may be employed to perform LDPC coded modulation decoding of multi-dimensional space Gray code mapped signals. The slightly increased decoding complexity (when compared to decoding 1-D Gray code mapped signals) is the computation of symbol metrics and their decomposition to bit metrics.

satellite communication system
**Fig. 1**

EP 1 523 099 A1

**Description**

**BACKGROUND OF THE INVENTION**

**TECHNICAL FIELD OF THE INVENTION**

The invention relates generally to communication systems; and, more particularly, it relates to coding (either one or both of encoding and decoding) of signals within such communication systems.

**DESCRIPTION OF RELATED ART**

Data communication systems have been under continual development for many years. One such type of communication system that has been of significant interest lately is a communication system that employs turbo codes. Another type of communication system that has also received interest is a communication system that employs LDPC (Low Density Parity Check) code. A primary directive in these areas of development has been to try continually to lower the error floor within a communication system. The ideal goal has been to try to reach Shannon's limit in a communication channel. Shannon's limit may be viewed as being the data rate to be used in a communication channel, having a particular SNR (Signal to Noise Ratio), that achieves error free transmission through the communication channel. In other words, the Shannon limit is the theoretical bound for channel capacity for a given modulation and code rate.

LDPC code has been shown to provide for excellent decoding performance that can approach the Shannon limit in some cases. For example, some LDPC decoders have been shown to come within 0.3 dB (decibels) from the theoretical Shannon limit. While this example was achieved using an irregular LDPC code of a length of one million, it nevertheless demonstrates the very promising application of LDPC codes within communication systems.

Typical encoding of LDPC coded modulation signals is performed by generating a signal that includes symbols each having a common code rate and being mapped to a singular modulation. That is to say, all of the symbols of such an LDPC coded modulation signal have the same code rate and the same modulation (the same constellation having a singular mapping). Oftentimes, such prior art encoding designs are implemented as to maximize the hardware and processing efficiencies of the particular design employed to generate the LDPC coded modulation signal having the single code rate and single modulation for all of the symbols generated therein.

Certain prior art coding approaches have sought to extend modulation coding to multiple dimensions. For example, one prior art approach is to separate a binary symbol into a plurality of parts and then map each of those parts to a corresponding constellation (according to its corresponding mapping). This approach may be viewed as being a joint mapping for multi-dimensional phase modulation based on squared Euclidean distance. This prior art approach was presented with respect to TCM (Trellis Coded Modulation) by Pietrobon et al. (S. S. Pietrobon, R. H. Deng A. Lafanechere, G. Ungerboeck and D. J. Costello, Jr., "Trellis-Coded Multidimensional phase modulation," *IEEE Trans. Inform. Theory,* Vol. 36, pp. 63-89, Jan. 1990). However, this approach does not work well for coded modulation with block codes such as LDPC codes. As such, there is a need in the art to provide a workable solution for the combination of multi-dimensional phase modulation that also combines block codes. More specifically, there is a need in the art to provide a solution that allows the benefits of LDPC codes to be combined with multi-dimensional phase modulation.

**BRIEF DESCRIPTION OF THE SEVERAL VIEWS OF THE DRAWINGS**

FIG. 1 is a system diagram illustrating an embodiment of a satellite communication system that is built according to the invention.
FIG. 2 is a system diagram illustrating an embodiment of an HDTV (High Definition Television) communication system that is built according to the invention.
FIG. 3A and FIG. 3B are system diagrams illustrating embodiment of uni-directional cellular communication systems that are built according to the invention.
FIG. 4 is a system diagram illustrating an embodiment of a bi-directional cellular communication system that is built according to the invention.
FIG. 5 is a system diagram illustrating an embodiment of a uni-directional microwave communication system that is built according to the invention.
FIG. 6 is a system diagram illustrating an embodiment of a bi-directional microwave communication system that is built according to the invention.
FIG. 7 is a system diagram illustrating an embodiment of a uni-directional point-to-point radio communication system that is built according to the invention.

FIG. 8 is a system diagram illustrating an embodiment of a bi-directional point-to-point radio communication system that is built according to the invention.

FIG. 9 is a system diagram illustrating an embodiment of a uni-directional communication system that is built according to the invention.

FIG. 10 is a system diagram illustrating an embodiment of a bi-directional communication system that is built according to the invention.

FIG. 11 is a system diagram illustrating an embodiment of a one to many communication system that is built according to the invention.

FIG. 12 is a diagram illustrating an embodiment of a WLAN (Wireless Local Area Network) that may be implemented according to the invention.

FIG. 13 is a diagram illustrating an embodiment of a DSL (Digital Subscriber Line) communication system that may be implemented according to the invention.

FIG. 14 is a system diagram illustrating an embodiment of a fiber-optic communication system that is built according to the invention.

FIG. 15 is a system diagram illustrating an embodiment of a satellite receiver STB (Set Top Box) system that is built according to the invention.

FIG. 16 is a diagram illustrating an embodiment of an LDPC (Low Density Parity Check) code bipartite graph.

FIG. 17A is a diagram illustrating an embodiment of direct combining of LDPC (Low Density Parity Check) coding and modulation encoding.

FIG. 17B is a diagram illustrating an embodiment of BICM (Bit Interleaved Coded Modulation) that is employed in conjunction with LDPC (Low Density Parity Check) coding and modulation encoding.

FIG. 17C is a diagram illustrating an embodiment of multilevel coded modulation encoding.

FIG. 18 is a diagram illustrating an embodiment of a variable signal mapping LDPC (Low Density Parity Check) coded modulation system that is built in accordance with invention.

FIG. 19 is a diagram illustrating an embodiment of LDPC (Low Density Parity Check) coded modulation decoding functionality using bit metric according to the invention.

FIG. 20 is a diagram illustrating an alternative embodiment of LDPC coded modulation decoding functionality using bit metric according to the invention (when performing n number of iterations).

FIG. 21 is a diagram illustrating an alternative embodiment of LDPC (Low Density Parity Check) coded modulation decoding functionality using bit metric (with bit metric updating) according to the invention.

FIG. 22 is a diagram illustrating an alternative embodiment of LDPC coded modulation decoding functionality using bit metric (with bit metric updating) according to the invention (when performing n number of iterations).

FIG. 23A is a diagram illustrating bit decoding using bit metric (shown with respect to an LDPC (Low Density Parity Check) code bipartite graph) according to the invention.

FIG. 23B is a diagram illustrating bit decoding using bit metric updating (shown with respect to an LDPC (Low Density Parity Check) code bipartite graph) according to the invention.

FIG. 24A is a diagram illustrating an LDPC (Low Density Parity Check) coded modulation tripartite graph with symbol nodes connected to bit nodes according to the invention.

FIG. 24B is a diagram illustrating an LDPC (Low Density Parity Check) coded modulation bipartite graph (or symbol bipartite graph) with symbol nodes connected directly to check nodes according to the invention (this bipartite graph is generated from the tripartite graph shown in FIG. 24A).

FIG. 25A is a diagram illustrating symbol decoding (shown with respect to an LDPC (Low Density Parity Check) coded modulation bipartite graph) according to the invention.

FIG. 25B is a diagram illustrating an embodiment of symbol decoding functionality (supported with an LDPC (Low Density Parity Check) coded modulation bipartite graph) according to the invention.

FIG. 26 is a diagram illustrating an embodiment of hybrid decoding functionality (having a reduced complexity when compared to symbol decoding) of LDPC (Low Density Parity Check) coded modulation signals according to the invention.

FIG. 27 is a diagram illustrating another embodiment of hybrid decoding functionality (having a reduced complexity when compared to symbol decoding) of LDPC coded modulation signals according to the invention.

FIG. 28A is a diagram illustrating an embodiment of a 4-D (4-dimensional) QPSK (Quadrature Phase Shift Key) constellation that is constructed according to the invention.

FIG. 28B is a diagram illustrating an embodiment of a 4-D (4-dimensional) 8 PSK (8 Phase Shift Key) constellation that is constructed according to the invention.

FIG. 29 is a diagram illustrating an alternative representation of the 4-D 8 PSK constellation, shown within FIG. 28B, that is constructed according to the invention.

FIG. 30 is a flowchart illustrating an embodiment of a method for $m$-D ($m$-dimensional) Gray code map construction for 2*m*-D *M* PSK modulation (where *m* and *M* are integers) according to the invention.

FIG. 31A is a diagram illustrating an embodiment of LDPC coded modulation encoding to support 4-D (4-dimensional) phase modulation according to the invention.

FIG. 31B is a diagram illustrating an embodiment of two 1-D (1-dimensional) 3 bit basic Gray code maps (shown using 8 PSK shaped constellation) according to the invention.

FIG. 32 is a diagram illustrating an embodiment of a 2-D (2-dimensional) Gray code map (Gx) for rate 5/6 8PSK LDPC coded modulation according to the invention.

FIG. 33 is a diagram illustrating an embodiment of performance comparison of performance comparison of two LDPC (Low Density Parity Check) coded modulation systems according to the invention.

## DETAILED DESCRIPTION OF THE INVENTION

Various aspects of the invention may be found in any number of devices that perform either one or both of encoding and decoding of LDPC (Low Density Parity Check) coded modulation signals that have been mapped using multi-dimensional space Gray code maps. In some embodiments, the encoding and decoding is implemented by combining LDPC coding and multi-dimensional phase modulation coding to generate an LDPC coded modulation multi-dimensional space Gray code mapped signal. In some instances of the invention, the LDPC coded modulation encoding with multi-dimensional space Gray code maps is implemented to generate a variable modulation signal whose modulation may vary as frequently as on a symbol by symbol basis. That is to say, the constellation and/or mapping of the symbols of an LDPC coded modulation multi-dimensional space Gray code mapped signal may vary as frequently as on a symbol by symbol basis. In addition, the code rate of the symbols of the coded signal may also vary as frequently as on a symbol by symbol basis. In general, an LDPC coded modulation multi-dimensional space Gray code mapped signal generated according to the encoding aspects of the invention may be characterized as a variable code rate and/ or modulation signal.

Various decoding aspects of the invention may be found in devices that perform LDPC coded modulation decoding of multi-dimensional space Gray code mapped signals. It is also noted that any of a variety of LDPC decoding approaches may be implemented to perform the LDPC coded modulation decoding of multi-dimensional space Gray code mapped signals. For example, any of the following LDPC decoding approaches may be employed: LDPC bit decoding only, LDPC bit decoding with update metric, LDPC coded modulation symbol decoding, and LDPC coded modulation hybrid decoding.

The decoding aspects of the invention are adaptable to accommodate decoding of LDPC signals having variable modulation and/or variable code rate. Still, the decoding aspects of the invention are also adaptable to accommodate decoding of LDPC signals that have a single code rate and/or single modulation for all of the symbols of the LDPC signal. For example, for an LDPC signal whose symbols all have a common code rate and a common modulation (constellation and mapping), any of the LDPC decoding approaches enumerated above may be employed to decode such an LDPC coded modulation multi-dimensional space Gray code mapped signal.

Various system embodiments are described below where any of the various aspects of the invention may be implemented. In general, any device that performs encoding and/or decoding of LDPC coded modulation multi-dimensional space Gray code mapped signals may benefit from the invention. Again, this also includes those LDPC coded signals that have variable code rate and/or variable modulation as well as those that include combined LDPC coding and modulation coding.

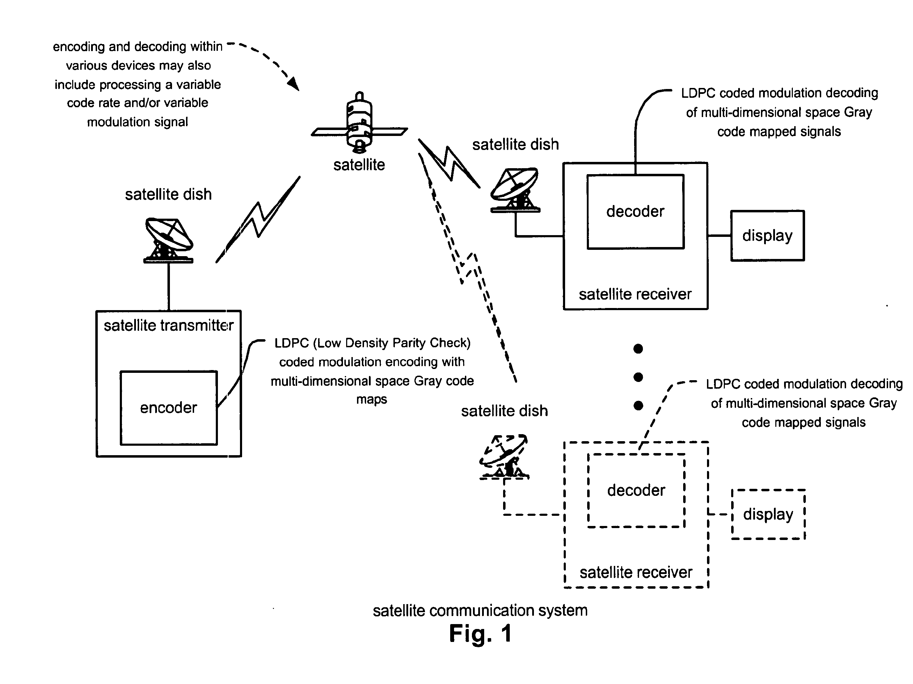

FIG. 1 is a system diagram illustrating an embodiment of a satellite communication system that is built according to the invention. A satellite transmitter is communicatively coupled to a satellite dish that is operable to communicate with a satellite. The satellite transmitter may also be communicatively coupled to a wired network. This wired network may include any number of networks including the Internet, proprietary networks, other wired networks and/ or WANs (Wide Area Networks). The satellite transmitter employs the satellite dish to communicate to the satellite via a wireless communication channel. The satellite is able to communicate with one or more satellite receivers (each having a satellite dish). Each of the satellite receivers may also be communicatively coupled to a display.

Here, the communication to and from the satellite may cooperatively be viewed as being a wireless communication channel, or each of the communication links to and from the satellite may be viewed as being two distinct wireless communication channels.

For example, the wireless communication "channel" may be viewed as not including multiple wireless hops in one embodiment. In other multi-hop embodiments, the satellite receives a signal received from the satellite transmitter (via its satellite dish), amplifies it, and relays it to satellite receiver (via its satellite dish); the satellite receiver may also be implemented using terrestrial receivers such as satellite receivers, satellite based telephones, and/or satellite based Internet receivers, among other receiver types. In the case where the satellite receives a signal received from the satellite transmitter (via its satellite dish), amplifies it, and relays it, the satellite may be viewed as being a "transponder;" this is a multi-hop embodiment. In addition, other satellites may exist that perform both receiver and transmitter operations in cooperation with the satellite. In this case, each leg of an up-down transmission via the wireless communication channel would be considered separately.

In whichever embodiment, the satellite communicates with the satellite receiver. The satellite receiver may be viewed as being a mobile unit in certain embodiments (employing a local antenna); alternatively, the satellite receiver may be viewed as being a satellite earth station that may be communicatively coupled to a wired network in a similar manner in which the satellite transmitter may also be communicatively coupled to a wired network.

The satellite transmitter is operable to encode information (using an encoder) that is to be transmitted to the satellite receiver; the satellite receiver is operable to decode the transmitted signal (using a decoder). The encoder may be implemented to perform LDPC coded modulation encoding with multi-dimensional space Gray code maps. This encoding may also be implemented to generate an LDPC coded signal whose code rate and/or modulation (constellation and mapping) may vary as frequently as on a symbol by symbol basis. The decoders within the satellite receivers may be implemented to perform LDPC coded modulation decoding of multi-dimensional space Gray code mapped signals. Any of a variety of means of LDPC decoding may be employed to support this decoding processing. In addition, this decoding may also be implemented to accommodate decoding processing of an LDPC coded signal whose code rate and/or modulation (constellation and mapping) may vary as frequently as on a symbol by symbol basis. This diagram shows just one of the many embodiments where one or more of the various aspects of the invention may be found.

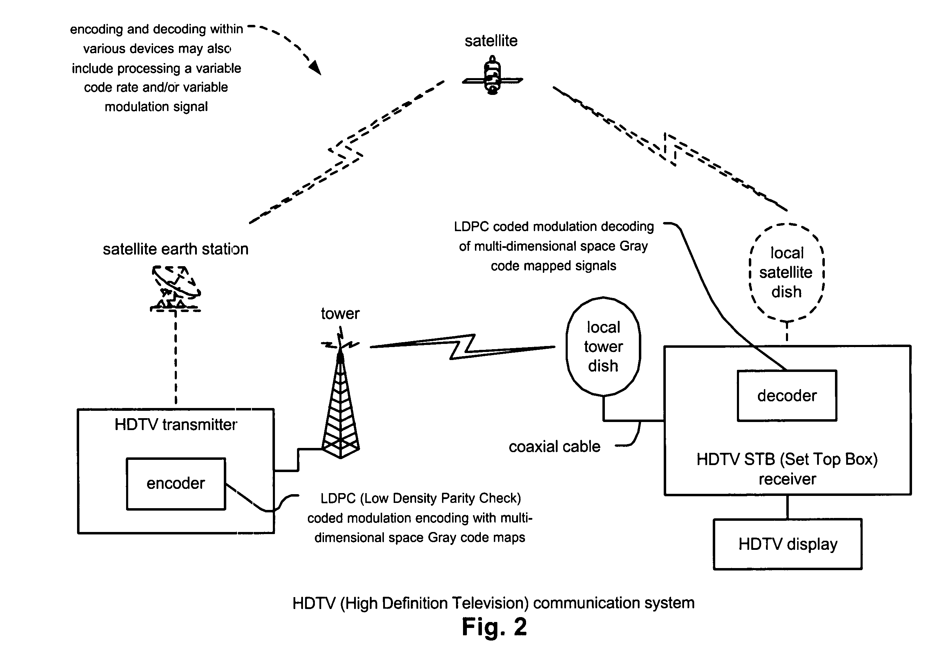

FIG. 2 is a system diagram illustrating an embodiment of an HDTV (High Definition Television) communication system that is built according to the invention. An HDTV transmitter is communicatively coupled to a tower. The HDTV transmitter, using its tower, transmits a signal to a local tower dish via a wireless communication channel. The local tower dish may communicatively couple to an HDTV STB (Set Top Box) receiver via a coaxial cable. The HDTV STB receiver includes the functionality to receive the wireless transmitted signal that has been received by the local tower dish. This functionality may include any transformation and/or downconverting that may be needed to accommodate any up-converting that may have been performed before and during transmission of the signal from the HDTV transmitter and its corresponding tower to transform the signal into a format that is compatible with the communication channel across which it is transmitted.

The HDTV STB receiver is also communicatively coupled to an HDTV display that is able to display the demodulated and decoded wireless transmitted signals received by the HDTV STB receiver and its local tower dish. The HDTV transmitter (via its tower) transmits a signal directly to the local tower dish via the wireless communication channel in this embodiment. In alternative embodiments, the HDTV transmitter may first receive a signal from a satellite, using a satellite earth station that is communicatively coupled to the HDTV transmitter, and then transmit this received signal to the local tower dish via the wireless communication channel. In this situation, the HDTV transmitter operates as a relaying element to transfer a signal originally provided by the satellite that is destined for the HDTV STB receiver. For example, another satellite earth station may first transmit a signal to the satellite from another location, and the satellite may relay this signal to the satellite earth station that is communicatively coupled to the HDTV transmitter. The HDTV transmitter performs receiver functionality and then transmits its received signal to the local tower dish.

In even other embodiments, the HDTV transmitter employs its satellite earth station to communicate to the satellite via a wireless communication channel. The satellite is able to communicate with a local satellite dish; the local satellite dish communicatively couples to the HDTV STB receiver via a coaxial cable. This path of transmission shows yet another communication path where the HDTV STB receiver may communicate with the HDTV transmitter.

In whichever embodiment and whichever signal path the HDTV transmitter employs to communicate with the HDTV STB receiver, the HDTV STB receiver is operable to receive communication transmissions from the HDTV transmitter.

The HDTV transmitter is operable to encode information (using an encoder) that is to be transmitted to the HDTV STB receiver; the HDTV STB receiver is operable to decode the transmitted signal (using a decoder).

As within other embodiments that employ an encoder and a decoder, the encoder may be implemented to perform LDPC coded modulation encoding with multi-dimensional space Gray code maps. This encoding may also be implemented to generate an LDPC coded signal whose code rate and/or modulation (constellation and mapping) may vary as frequently as on a symbol by symbol basis. The decoder may be implemented to perform LDPC coded modulation decoding of multi-dimensional space Gray code mapped signals. Any of a variety of means of LDPC decoding may be employed to support this decoding processing. In addition, this decoding may also be implemented to accommodate decoding processing of an LDPC coded signal whose code rate and/or modulation (constellation and mapping) may vary as frequently as on a symbol by symbol basis. This diagram shows yet another embodiment where one or more of the various aspects of the invention may be found.

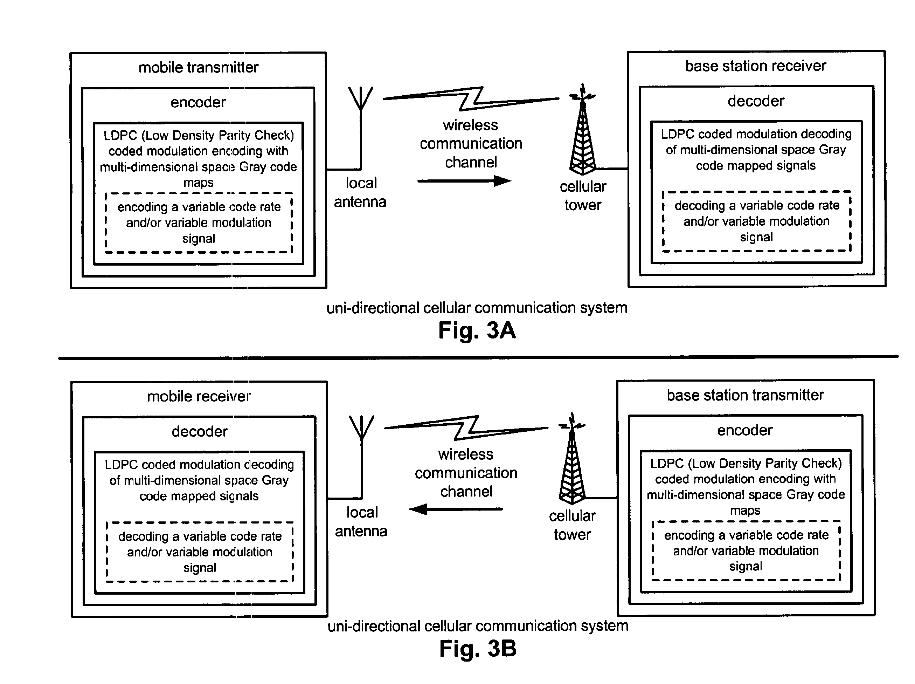

FIG. 3A and FIG. 3B are system diagrams illustrating embodiments of uni-directional cellular communication systems that are built according to the invention.

Referring to the FIG. 3A, a mobile transmitter includes a local antenna communicatively coupled thereto. The mobile transmitter may be any number of types of transmitters including a one way cellular telephone, a wireless pager unit, a mobile computer having transmission functionality, or any other type of mobile transmitter. The mobile transmitter transmits a signal, using its local antenna, to a cellular tower via a wireless communication channel. The cellular tower is communicatively coupled to a base station receiver; the receiving tower is operable to receive data transmission from the local antenna of the mobile transmitter that has been communicated via the wireless communication channel. The cellular tower communicatively couples the received signal to the base station receiver.

The mobile transmitter is operable to encode information (using an encoder) that is to be transmitted to the base station receiver; the base station receiver is operable to decode the transmitted signal (using a decoder).

As within other embodiments that employ an encoder and a decoder, the encoder may be implemented to perform LDPC coded modulation encoding with multi-dimensional space Gray code maps. This encoding may also be implemented to generate an LDPC coded signal whose code rate and/or modulation (constellation and mapping) may vary as frequently as on a symbol by symbol basis. The decoder may be implemented to perform LDPC coded modulation decoding of multi-dimensional space Gray code mapped signals. Any of a variety of means of LDPC decoding may be employed to support this decoding processing. In addition, this decoding may also be implemented to accommodate decoding processing of an LDPC coded signal whose code rate and/or modulation (constellation and mapping) may vary as frequently as on a symbol by symbol basis. This diagram shows yet another embodiment where one or more of the various aspects of the invention may be found.

Referring to the FIG. 3B, a base station transmitter includes a cellular tower communicatively coupled thereto. The base station transmitter, using its cellular tower, transmits a signal to a mobile receiver via a communication channel. The mobile receiver may be any number of types of receivers including a one-way cellular telephone, a wireless pager unit, a mobile computer having receiver functionality, or any other type of mobile receiver. The mobile receiver is communicatively coupled to a local antenna; the local antenna is operable to receive data transmission from the cellular tower of the base station transmitter that has been communicated via the wireless communication channel. The local antenna communicatively couples the received signal to the mobile receiver.

The base station transmitter is operable to encode information (using an encoder) that is to be transmitted to the mobile receiver; the mobile receiver is operable to decode the transmitted signal (using a decoder).

As within other embodiments that employ an encoder and a decoder, the encoder may be implemented to perform LDPC coded modulation encoding with multi-dimensional space Gray code maps. This encoding may also be implemented to generate an LDPC coded signal whose code rate and/or modulation (constellation and mapping) may vary as frequently as on a symbol by symbol basis. The decoder may be implemented to perform LDPC coded modulation decoding of multi-dimensional space Gray code mapped signals. Any of a variety of means of LDPC decoding may be employed to support this decoding processing. In addition, this decoding may also be implemented to accommodate decoding processing of an LDPC coded signal whose code rate and/or modulation (constellation and mapping) may vary as frequently as on a symbol by symbol basis. This diagram shows yet another embodiment where one or more of the various aspects of the invention may be found.

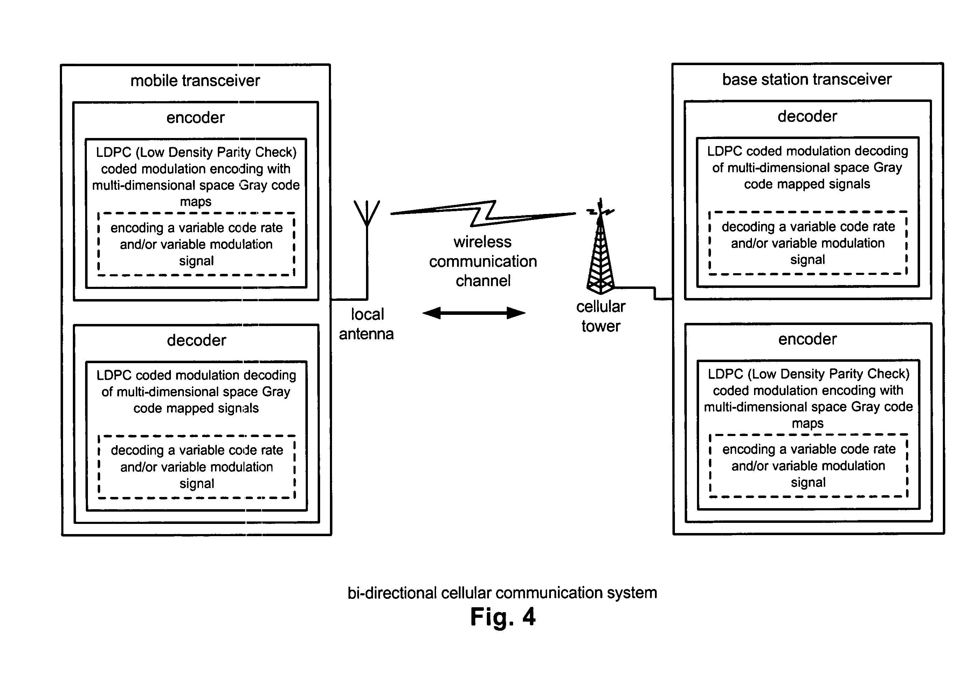

FIG. 4 is a system diagram illustrating an embodiment of a bi-directional cellular communication system, built according to the invention, where the communication can go to and from the base station transceiver and to and from the mobile transceiver via the wireless communication channel.

Referring to the FIG. 4, a base station transceiver includes a cellular tower communicatively coupled thereto. The base station transceiver, using its cellular tower, transmits a signal to a mobile transceiver via a communication channel. The reverse communication operation may also be performed. The mobile transceiver is able to transmit a signal to the base station transceiver as well. The mobile transceiver may be any number of types of transceiver including a cellular telephone, a wireless pager unit, a mobile computer having transceiver functionality, or any other type of mobile transceiver. The mobile transceiver is communicatively coupled to a local antenna; the local antenna is operable to receive data transmission from the cellular tower of the base station transceiver that has been communicated via the wireless communication channel. The local antenna communicatively couples the received signal to the mobile transceiver.

The base station transceiver is operable to encode information (using its corresponding encoder) that is to be transmitted to the mobile transceiver; the mobile transceiver is operable to decode the transmitted signal (using its corresponding decoder). Similarly, mobile transceiver is operable to encode information (using its corresponding encoder) that is to be transmitted to the base station transceiver; the base station transceiver is operable to decode the transmitted signal (using its corresponding decoder).

As within other embodiments that employ an encoder and a decoder, the encoder of either of the base station transceiver or the mobile transceiver may be implemented to perform LDPC coded modulation encoding with multi-dimensional space Gray code maps. This encoding may also be implemented to generate an LDPC coded signal whose code rate and/or modulation (constellation and mapping) may vary as frequently as on a symbol by symbol basis. The decoder of either of the base station transceiver or the mobile transceiver may be implemented to perform LDPC coded modulation decoding of multi-dimensional space Gray code mapped signals. Any of a variety of means of LDPC decoding may be employed to support this decoding processing. In addition, this decoding may also be implemented to accommodate decoding processing of an LDPC coded signal whose code rate and/or modulation (constellation and mapping) may vary as frequently as on a symbol by symbol basis. This diagram shows yet another embodiment where one or more of the various aspects of the invention may be found.

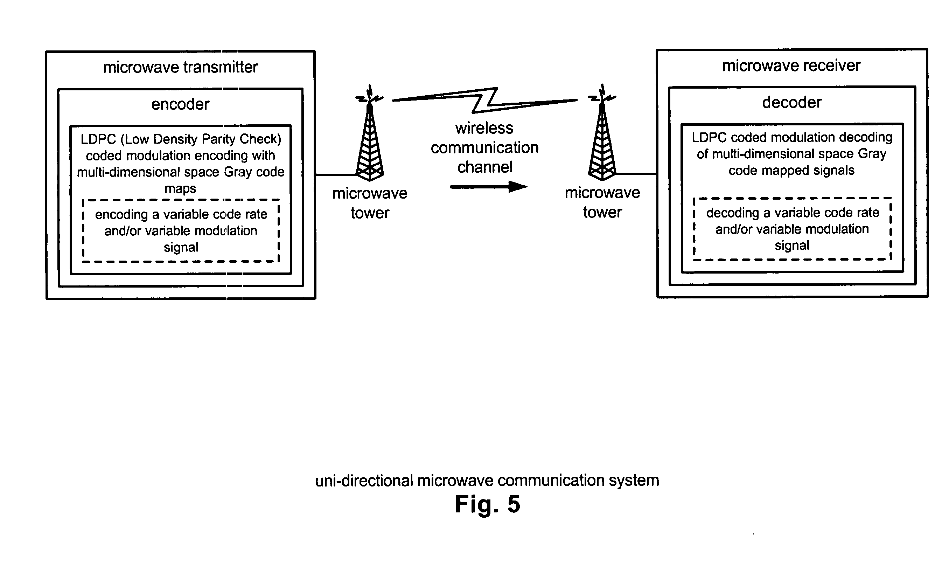

FIG. 5 is a system diagram illustrating an embodiment of a uni-directional microwave communication system that is built according to the invention. A microwave transmitter is communicatively coupled to a microwave tower. The microwave transmitter, using its microwave tower, transmits a signal to a microwave tower via a wireless communication channel. A microwave receiver is communicatively coupled to the microwave tower. The microwave tower is able to receive transmissions from the microwave tower that have been communicated via the wireless communication channel.

The microwave transmitter is operable to encode information (using an encoder) that is to be transmitted to the microwave receiver; the microwave receiver is operable to decode the transmitted signal (using a decoder).

As within other embodiments that employ an encoder and a decoder, the encoder may be implemented to perform LDPC coded modulation encoding with multi-dimensional space Gray code maps. This encoding may also be implemented to generate an LDPC coded signal whose code rate and/or modulation (constellation and mapping) may vary as frequently as on a symbol by symbol basis. The decoder may be implemented to perform LDPC coded modulation decoding of multi-dimensional space Gray code mapped signals. Any of a variety of means of LDPC decoding may be employed to support this decoding processing. In addition, this decoding may also be implemented to accommodate decoding processing of an LDPC coded signal whose code rate and/or modulation (constellation and mapping) may vary as frequently as on a symbol by symbol basis. This diagram shows yet another embodiment where one or more of the various aspects of the invention may be found.

As within other embodiments that employ an encoder and a decoder, the encoder may be implemented to perform encoding using LDPC coded modulation, and the LDPC encoding may be performed to generate an LDPC coded signal whose code rate and/or modulation (constellation and mapping) may vary as frequently as on a symbol by symbol basis. The decoder may be implemented to perform decoding of LDPC coded signals. This LDPC decoding may be implemented to perform hybrid decoding within the iterative decoding processing. In addition, this LDPC decoding may also be implemented to accommodate decoding processing of an LDPC coded signal whose code rate and/or modulation (constellation and mapping) may vary as frequently as on a symbol by symbol basis. This diagram shows yet another embodiment where one or more of the various aspects of the invention may be found.

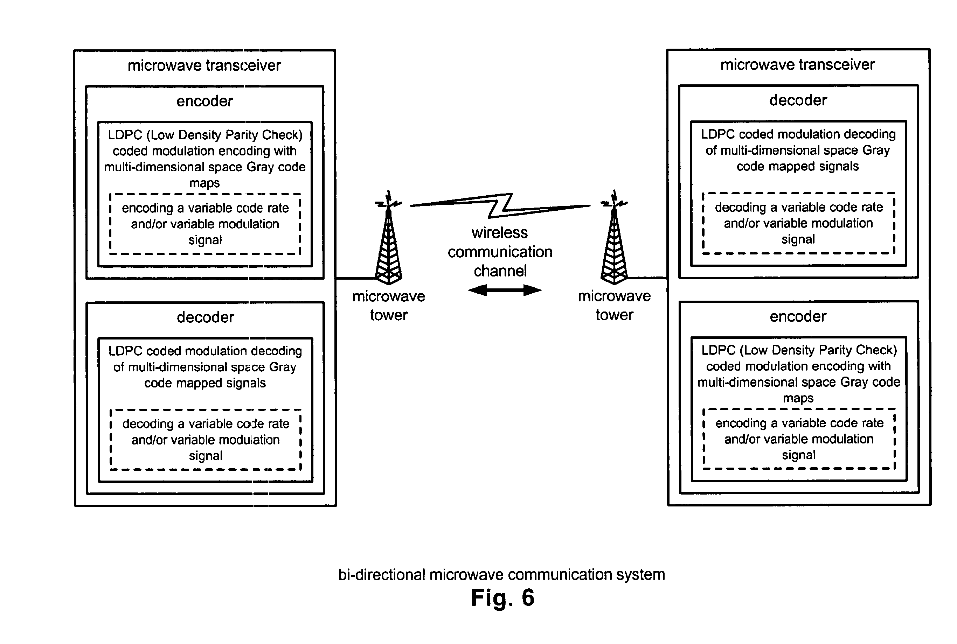

FIG. 6 is a system diagram illustrating an embodiment of a bi-directional microwave communication system that is built according to the invention. Within the FIG. 6, a first microwave transceiver is communicatively coupled to a first microwave tower. The first microwave transceiver, using the first microwave tower (the first microwave transceiver's microwave tower), transmits a signal to a second microwave tower of a second microwave transceiver via a wireless communication channel. The second microwave transceiver is communicatively coupled to the second microwave tower (the second microwave transceiver's microwave tower). The second microwave tower is able to receive transmissions from the first microwave tower that have been communicated via the wireless communication channel. The reverse communication operation may also be performed using the first and second microwave transceivers.

Each of the microwave transceivers is operable to encode information (using an encoder) that is to be transmitted to the other microwave transceiver; each microwave transceiver is operable to decode the transmitted signal (using a decoder) that it receives. Each of the microwave transceivers includes an encoder and a decoder.

As within other embodiments that employ an encoder and a decoder, the encoder of either of the microwave transceivers may be implemented to perform LDPC coded modulation encoding with multi-dimensional space Gray code maps. This encoding may also be implemented to generate an LDPC coded signal whose code rate and/or modulation (constellation and mapping) may vary as frequently as on a symbol by symbol basis. The decoder of either of the microwave transceivers may be implemented to perform LDPC coded modulation decoding of multi-dimensional space Gray code mapped signals. Any of a variety of means of LDPC decoding may be employed to support this decoding processing. In addition, this decoding may also be implemented to accommodate decoding processing of an LDPC coded signal whose code rate and/or modulation (constellation and mapping) may vary as frequently as on a symbol by symbol basis. This diagram shows yet another embodiment where one or more of the various aspects of the invention may be found.

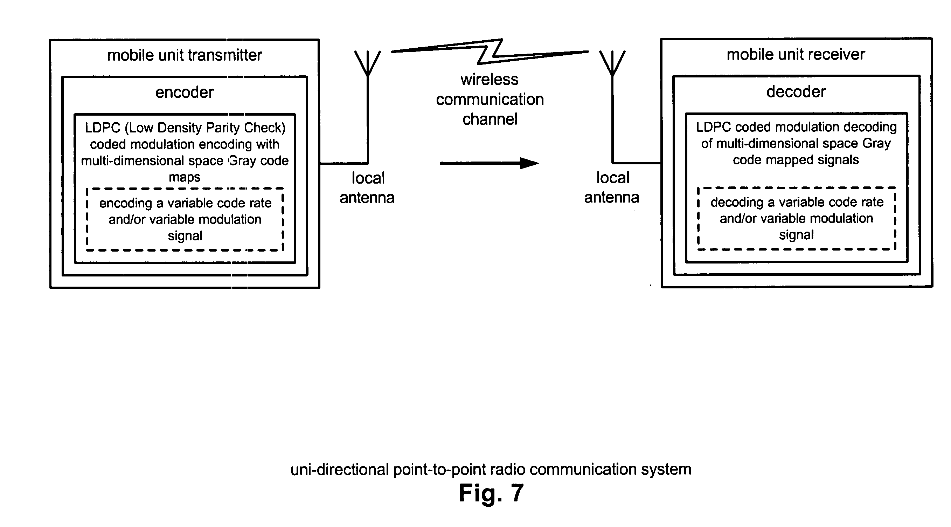

FIG. 7 is a system diagram illustrating an embodiment of a uni-directional point-to-point radio communication system, built according to the invention, where the communication goes from a mobile unit transmitter to a mobile unit receiver via the wireless communication channel.

A mobile unit transmitter includes a local antenna communicatively coupled thereto. The mobile unit transmitter, using its local antenna, transmits a signal to a local antenna of a mobile unit receiver via a wireless communication channel.

The mobile unit transmitter is operable to encode information (using an encoder) that is to be transmitted to the mobile unit receiver; the mobile unit receiver is operable to decode the transmitted signal (using a decoder).

As within other embodiments that employ an encoder and a decoder, the encoder may be implemented to perform LDPC coded modulation encoding with multi-dimensional space Gray code maps. This encoding may also be implemented to generate an LDPC coded signal whose code rate and/or modulation (constellation and mapping) may vary as frequently as on a symbol by symbol basis. The decoder may be implemented to perform LDPC coded modulation decoding of multi-dimensional space Gray code mapped signals. Any of a variety of means of LDPC decoding may be employed to support this decoding processing. In addition, this decoding may also be implemented to accommodate decoding processing of an LDPC coded signal whose code rate and/or modulation (constellation and mapping) may vary as frequently as on a symbol by symbol basis. This diagram shows yet another embodiment where one or more of the various aspects of the invention may be found.

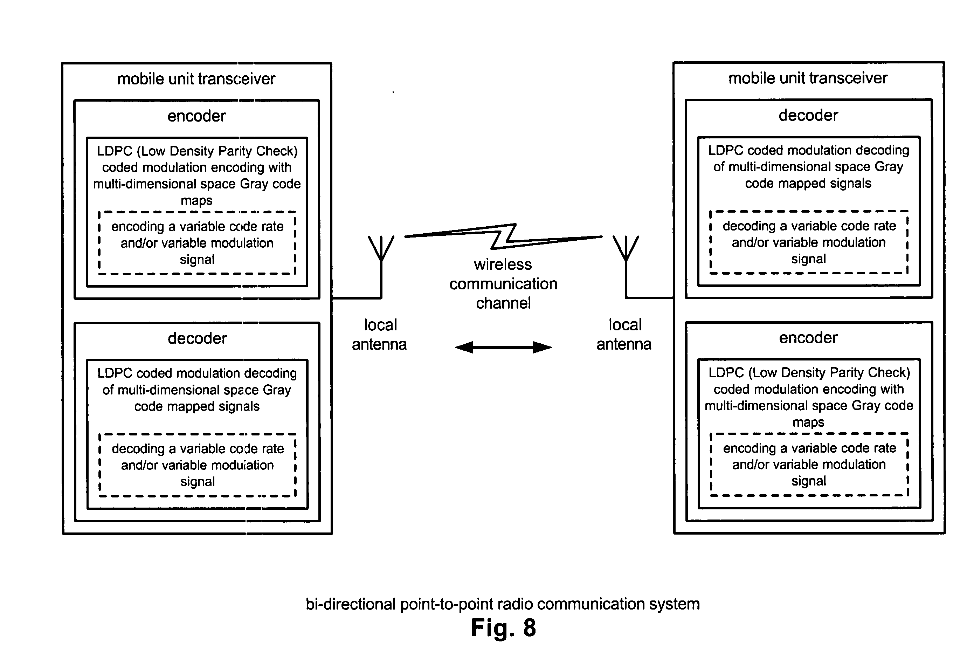

FIG. 8 is a system diagram illustrating an embodiment of a bi-directional point-to-point radio communication system that is built according to the invention. A first mobile unit transceiver is communicatively coupled to a first local antenna. The first mobile unit transceiver, using the first local antenna (the first mobile unit transceiver's local antenna), transmits a signal to a second local antenna of a second mobile unit transceiver via a wireless communication channel. The second mobile unit transceiver is communicatively coupled to the second local antenna (the second mobile unit transceiver's local antenna). The second local antenna is able to receive transmissions from the first local antenna that have been communicated via the communication channel. The reverse communication operation may also be performed using the first and second mobile unit transceivers.

Each mobile unit transceiver is operable to encode information (using its corresponding encoder) that is to be transmitted to the other mobile unit transceiver; each mobile unit transceiver is operable to decode the transmitted signal (using its corresponding decoder) that it receives.

As within other embodiments that employ an encoder and a decoder, the encoder of either of the mobile unit transceivers may be implemented to perform LDPC coded modulation encoding with multi-dimensional space Gray code maps. This encoding may also be implemented to generate an LDPC coded signal whose code rate and/or modulation (constellation and mapping) may vary as frequently as on a symbol by symbol basis. The decoder of either of the mobile unit transceivers may be implemented to perform LDPC coded modulation decoding of multi-dimensional space Gray code mapped signals. Any of a variety of means of LDPC decoding may be employed to support this decoding processing. In addition, this decoding may also be implemented to accommodate decoding processing of an LDPC coded signal whose code rate and/or modulation (constellation and mapping) may vary as frequently as on a symbol by symbol basis. This diagram shows yet another embodiment where one or more of the various aspects of the invention may be found.

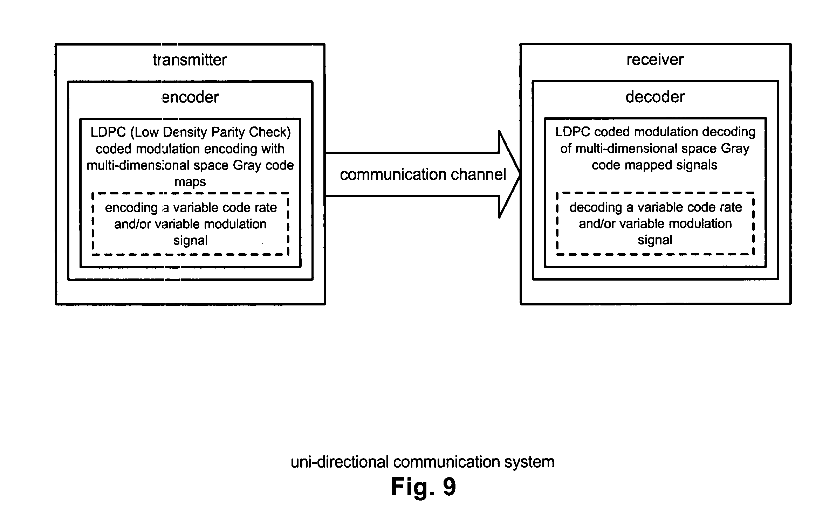

FIG. 9 is a system diagram illustrating an embodiment of a uni-directional communication system that is built according to the invention. A transmitter communicates to a receiver via a uni-directional communication channel. The uni-directional communication channel may be a wireline (or wired) communication channel or a wireless communication channel without departing from the scope and spirit of the invention. The wired media by which the uni-directional communication channel may be implemented are varied, including coaxial cable, fiber-optic cabling, and copper cabling, among other types of "wiring." Similarly, the wireless manners in which the uni-directional communication channel may be implemented are varied, including satellite communication, cellular communication, microwave communication, and radio communication, among other types of wireless communication.

The transmitter is operable to encode information (using an encoder) that is to be transmitted to the receiver; the receiver is operable to decode the transmitted signal (using a decoder).

As within other embodiments that employ an encoder and a decoder, the encoder may be implemented to perform LDPC coded modulation encoding with multi-dimensional space Gray code maps. This encoding may also be implemented to generate an LDPC coded signal whose code rate and/or modulation (constellation and mapping) may vary as frequently as on a symbol by symbol basis. The decoder may be implemented to perform LDPC coded modulation decoding of multi-dimensional space Gray code mapped signals. Any of a variety of means of LDPC decoding may be employed to support this decoding processing. In addition, this decoding may also be implemented to accommodate decoding processing of an LDPC coded signal whose code rate and/or modulation (constellation and mapping) may vary as frequently as on a symbol by symbol basis. This diagram shows yet another embodiment where one or more of the various aspects of the invention may be found.

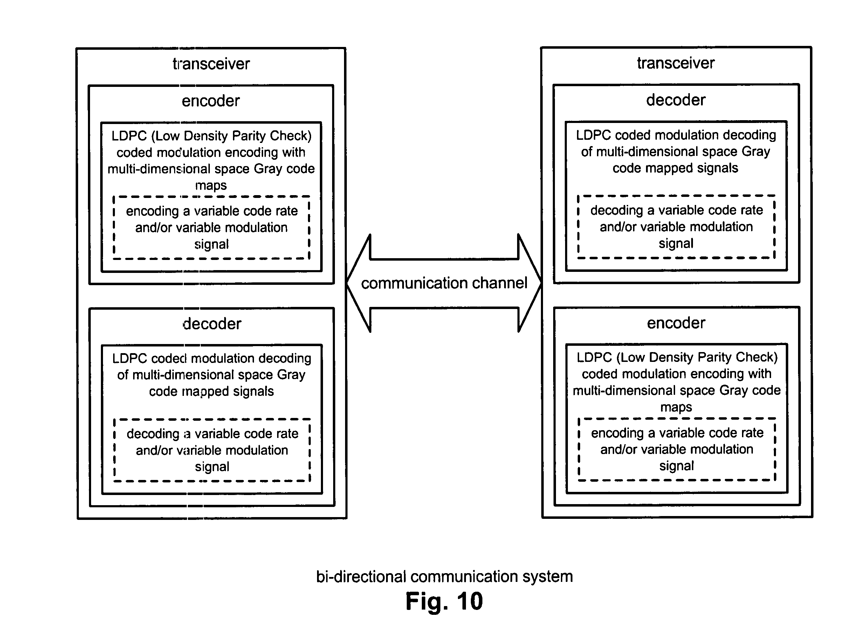

FIG. 10 is a system diagram illustrating an embodiment of a bi-directional communication system that is built according to the invention. A first transceiver is communicatively coupled to a second transceiver via a bi-directional communication channel. The bi-directional communication channel may be a wireline (or wired) communication channel or a wireless communication channel without departing from the scope and spirit of the invention. The wired media by which the bi-directional communication channel may be implemented are varied, including coaxial cable, fiber-optic cabling, and copper cabling, among other types of "wiring." Similarly, the wireless manners in which the bi-directional communication channel may be implemented are varied, including satellite communication, cellular communication, microwave communication, and radio communication, among other types of wireless communication.

Each of the transceivers is operable to encode information (using its corresponding encoder) that is to be transmitted to the other transceiver; each transceiver is operable to decode the transmitted signal (using its corresponding decoder) that it receives.

As within other embodiments that employ an encoder and a decoder, the encoder of either of the transceivers may be implemented to perform LDPC coded modulation encoding with multi-dimensional space Gray code maps. This encoding may also be implemented to generate an LDPC coded signal whose code rate and/or modulation (constellation and mapping) may vary as frequently as on a symbol by symbol basis. The decoder of either of the transceivers may be implemented to perform LDPC coded modulation decoding of multi-dimensional space Gray code mapped signals. Any of a variety of means of LDPC decoding may be employed to support this decoding processing. In addition, this decoding may also be implemented to accommodate decoding processing of an LDPC coded signal whose code rate and/or modulation (constellation and mapping) may vary as frequently as on a symbol by symbol basis. This diagram shows yet another embodiment where one or more of the various aspects of the invention may be found.

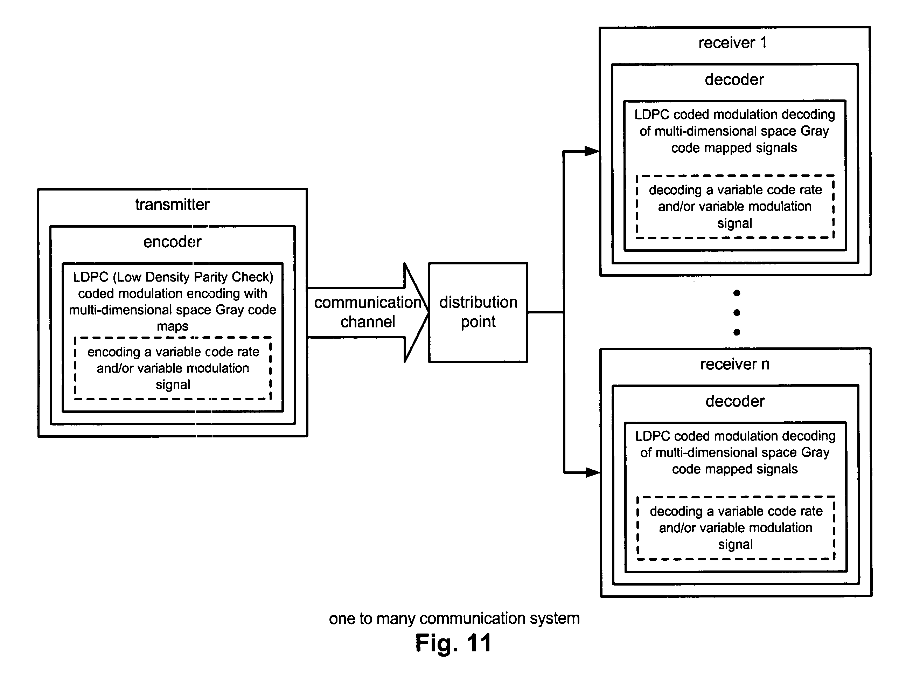

FIG. 11 is a system diagram illustrating an embodiment of a one to many communication system that is built according to the invention. A transmitter is able to communicate, via broadcast in certain embodiments, with a number of receivers, shown as receivers 1, ..., n via a uni-directional communication channel. The uni-directional communication channel may be a wireline (or wired) communication channel or a wireless communication channel without departing from the scope and spirit of the invention. The wired media by which the bi-directional communication channel may be implemented are varied, including coaxial cable, fiber-optic cabling, and copper cabling, among other types of "wiring." Similarly, the wireless manners in which the bi-directional communication channel may be implemented are varied, including satellite communication, cellular communication, microwave communication, and radio communication, among other types of wireless communication.

A distribution point is employed within the one to many communication system to provide the appropriate communication to the receivers 1, ..., and n. In certain embodiments, the receivers 1, ..., and n each receive the same communication and individually discern which portion of the total communication is intended for them.

The transmitter is operable to encode information (using an encoder) that is to be transmitted to the receivers 1, ..., and n; each of the receivers 1, ..., and n is operable to decode the transmitted signal (using a decoder).

As within other embodiments that employ an encoder and a decoder, the encoder may be implemented to perform LDPC coded modulation encoding with multi-dimensional space Gray code maps. This encoding may also be implemented to generate an LDPC coded signal whose code rate and/or modulation (constellation and mapping) may vary as frequently as on a symbol by symbol basis. The decoders of any of the receivers 1, ..., and n may be implemented to perform LDPC coded modulation decoding of multi-dimensional space Gray code mapped signals. Any of a variety of means of LDPC decoding may be employed to support this decoding processing. In addition, this decoding may also be implemented to accommodate decoding processing of an LDPC coded signal whose code rate and/or modulation (constellation and mapping) may vary as frequently as on a symbol by symbol basis. This diagram shows yet another embodiment where one or more of the various aspects of the invention may be found.

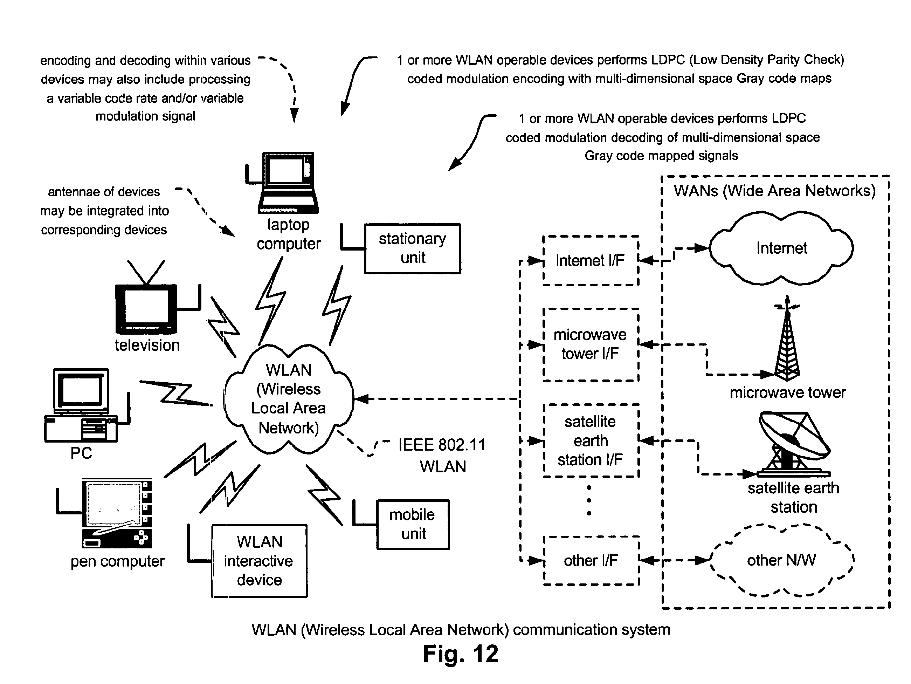

FIG. 12 is a diagram illustrating an embodiment of a WLAN (Wireless Local Area Network) that may be implemented according to the invention. The WLAN communication system may be implemented to include a number of devices that are all operable to communicate with one another via the WLAN. For example, the various devices that each include the functionality to interface with the WLAN may include any 1 or more of a laptop computer, a television, a PC (Personal Computer), a pen computer (that may be viewed as being a PDA (Personal Digital Assistant) in some instances, a personal electronic planner, or similar device), a mobile unit (that may be viewed as being a telephone, a pager, or some other mobile WLAN operable device), and/or a stationary unit (that may be viewed as a device that typically resides in a single location within the WLAN). The antennae of the various WLAN interactive devices may be integrated into the corresponding devices without departing from the scope and spirit of the invention as well.

This illustrated group of devices that may interact with the WLAN is not intended to be an exhaustive list of devices that may interact with a WLAN, and a generic device shown as a WLAN interactive device represents any such generic device that includes the functionality in order to interactive with the WLAN itself and/or the other devices that are associated with the WLAN. Any one of these devices that associate with the WLAN may be viewed generically as being a WLAN interactive device without departing from the scope and spirit of the invention. Each of the devices and the WLAN interactive device may be viewed as being located at nodes of the WLAN.

It is also noted that the WLAN itself may also include functionality to allow interfacing with other networks as well. These external networks may generically be referred to as WANs (Wide Area Networks). For example, the WLAN may include an Internet I/F (interface) that allows for interfacing to the Internet itself. This Internet I/F may be viewed as being a base station device for the WLAN that allows any one of the WLAN interactive devices to access the Internet.

It is also noted that the WLAN may also include functionality to allow interfacing with other networks (e.g., other WANs) besides simply the Internet. For example, the WLAN may include a microwave tower I/F that allows for interfacing to a microwave tower thereby allowing communication with one or more microwave networks. Similar to the Internet I/F described above, the microwave tower I/F may be viewed as being a base station device for the WLAN that allows any one of the WLAN interactive devices to access the one or more microwave networks via the microwave tower.

Moreover, the WLAN may include a satellite earth station I/F that allows for interfacing to a satellite earth station thereby allowing communication with one or more satellite networks. The satellite earth station I/F may be viewed as being a base station device for the WLAN that allows any one of the WLAN interactive devices to access the one or more satellite networks via the satellite earth station I/F.

This finite listing of various network types that may interface to the WLAN is also not intended to be exhaustive. For example, any other network may communicatively couple to the WLAN via an appropriate I/F that includes the functionality for any one of the WLAN interactive devices to access the other network.

Any of the various WLAN interactive devices described within this embodiment may include an encoder and a decoder to allow bi-directional communication with the other WLAN interactive device and/or the WANs.

Again, as within other embodiments that employ an encoder and a decoder, the encoders of any of the various devices may be implemented to perform LDPC coded modulation encoding with multi-dimensional space Gray code maps. This encoding may also be implemented to generate an LDPC coded signal whose code rate and/or modulation (constellation and mapping) may vary as frequently as on a symbol by symbol basis. The decoders of any of the various devices may be implemented to perform LDPC coded modulation decoding of multi-dimensional space Gray code mapped signals. Any of a variety of means of LDPC decoding may be employed to support this decoding processing. In addition, this decoding may also be implemented to accommodate decoding processing of an LDPC coded signal whose code rate and/or modulation (constellation and mapping) may vary as frequently as on a symbol by symbol basis. This diagram shows yet another embodiment where one or more of the various aspects of the invention may be found.

In general, any one of the WLAN interactive devices may be characterized as being an IEEE (Institute of Electrical & Electronics Engineers) 802.11 operable device. For example, such an 802.11 operable device may be an 802.11 a operable device, an 802.11 b operable device, or an 802.11 g operable device. The IEEE 802.11 g specification extends the rates for packet transmission in the 2.4 GHz frequency band. This is achieved by allowing packets, also known as frames, of two distinct types to coexist in this band. Frames utilizing DSSS/CCK (Direct Sequence Spread Spectrum with Complementary Code Keying) have been specified for transmission in the 2.4 GHz band at rates up to 11 Mbps (Mega-bits per second) as part of the 802.11b standard. The 802.11a standard uses a different frame format with OFDM (Orthogonal Frequency Division Multiplexing) to transmit at rates up to 54 Mbps with carrier frequencies in the 5 GHz range. The 802.11g specification allows for such OFDM frames to coexist with DSSS/CCK frames at 2.4 GHz.

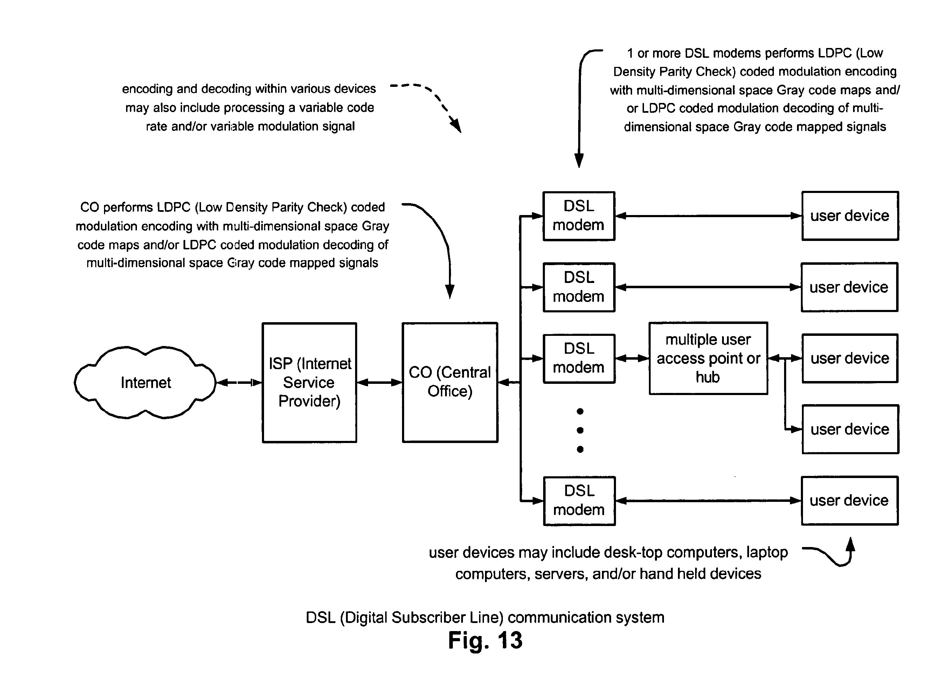

FIG. 13 is a diagram illustrating an embodiment of a DSL (Digital Subscriber Line) communication system that may be implemented according to the invention. The DSL communication system includes an interfacing to the Internet (or some other WAN). In this diagram, the Internet itself is shown, but other WANs may also be employed without departing from the scope and spirit of the invention. An ISP (Internet Service Provider) is operable to communicate data to and from the Internet. The ISP communicatively couples to a CO (Central Office) that is typically operated by a telephone services company. The CO may also allow for the providing of telephone services to one or more subscribers. However, the CO may also be implemented to allow interfacing of Internet traffic to and from one or more users (whose interactive devices are shown as user devices). These user devices may be a wide variety of devices including desk-top computers, laptop computers, servers, and/or hand held devices without departing from the scope and spirit of the invention. Any of these user devices may be wired or wireless typed devices as well. Each of the user devices is operably coupled to the CO via a DSL modem. The DSL modem may also be communicatively coupled to a multiple user access point or hub to allow more than one user device to access the Internet.

The CO and the various DSL modems may also be implemented to include an encoder and a decoder to allow bi-directional communication therein. For example, the CO is operable to encode and decode data when communicating to and from the various DSL modems and the ISP. Similarly, each of the various DSL modems is operable to encode and decode data when communicating to and from the CO and its respective one or more user devices.

Again, as within other embodiments that employ an encoder and a decoder, the encoder of any of the CO and the various DSL modems may be implemented to perform LDPC coded modulation encoding with multi-dimensional space Gray code maps. This encoding may also be implemented to generate an LDPC coded signal whose code rate and/or modulation (constellation and mapping) may vary as frequently as on a symbol by symbol basis. The decoder of any of the CO and the various DSL modems may be implemented to perform LDPC coded modulation decoding of multi-dimensional space Gray code mapped signals. Any of a variety of means of LDPC decoding may be employed to support this decoding processing. In addition, this decoding may also be implemented to accommodate decoding processing of an LDPC coded signal whose code rate and/or modulation (constellation and mapping) may vary as frequently as on a symbol by symbol basis. This diagram shows yet another embodiment where one or more of the various aspects of the invention may be found.

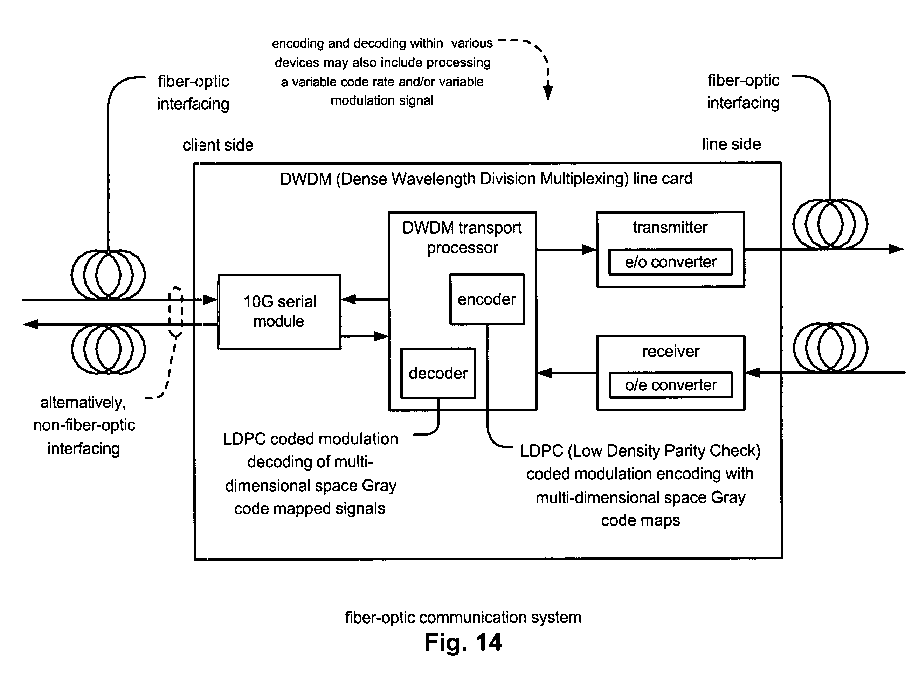

FIG. 14 is a system diagram illustrating an embodiment of a fiber-optic communication system that is built according to the invention. The fiber-optic communication system may be implemented to support encoding and/or decoding of LDPC coded modulation multi-dimensional space Gray code mapped signals. In some instances, these signals include a code rate and/or modulation (constellation and mapping) that may vary as frequently as on a symbol by symbol basis.

The fiber-optic communication system includes a DWDM (Dense Wavelength Division Multiplexing (within the context of fiber optic communications)) line card that is interposed between a line side and a client side. DWDM is a technology that has gained increasing interest recently. From both technical and economic perspectives, the ability to provide potentially unlimited transmission capacity is the most obvious advantage of DWDM technology. The current investment already made within fiber-optic infrastructure can not only be preserved when using DWDM, but it may even be optimized by a factor of at least 32. As demands change, more capacity can be added, either by simple equipment upgrades or by increasing the number of wavelengths (lambdas) on the fiber-optic cabling itself, without expensive upgrades. Capacity can be obtained for the cost of the equipment, and existing fiber plant investment is retained. From the bandwidth perspective, some of the most compelling technical advantage of DWDM can be summarized as follows:

The transparency of DWDM: Because DWDM is a PHY (physical layer) architecture, it can transparently support both TDM (Time Division Multiplexing) and data formats such as ATM (Asynchronous Transfer Mode), Gigabit Ethernet, ESCON (Enterprise System CONnection), and Fibre Channel with open interfaces over a common physical layer.

The scalability of DWDM: DWDM can leverage the abundance of dark fiber in many metropolitan area and enterprise networks to quickly meet demand for capacity on point-to-point links and on spans of existing SONET/SDH (Synchronous Optical NETwork)/(Synchronous Digital Hierarchy) rings.

The dynamic provisioning capabilities of DWDM: the fast, simple, and dynamic provisioning of network connections give providers the ability to provide high-bandwidth services in days rather than months.

Fiber-optic interfacing is employed at each of the client and line sides of the DWDM line card. The DWDM line card includes a transport processor that includes functionality to support DWDM long haul transport, DWDM metro transport, next-generation SONET/SDH multiplexers, digital cross-connects, and fiber-optic terminators and test equipment. On the line side, the DWDM line card includes a transmitter, that is operable to perform electrical to optical conversion for interfacing to an optical medium, and a receiver, that is operable to perform optical to electrical conversion for interfacing from the optical medium. On the client side, the DWDM line card includes a 10G serial module that is operable to communicate with any other devices on the client side of the fiber-optic communication system using a fiber-optic interface. Alternatively, the interface may be implemented using non-fiber-optic media, including copper cabling and/or some other type of interface medium.

The DWDM transport processor of the DWDM line card includes a decoder that is used to decode received signals from either one or both of the line and client sides and an encoder that is used to encode signals to be transmitted to either one or both of the line and client sides.

As within other embodiments that employ an encoder and a decoder, the encoder may be implemented to perform LDPC coded modulation encoding with multi-dimensional space Gray code maps. This encoding may also be implemented to generate an LDPC coded signal whose code rate and/or modulation (constellation and mapping) may vary as frequently as on a symbol by symbol basis. The decoder may be implemented to perform LDPC coded modulation decoding of multi-dimensional space Gray code mapped signals. Any of a variety of means of LDPC decoding may be employed to support this decoding processing. In addition, this decoding may also be implemented to accommodate decoding processing of an LDPC coded signal whose code rate and/or modulation (constellation and mapping) may vary as frequently as on a symbol by symbol basis. This diagram shows yet another embodiment where one or more of the various aspects of the invention may be found.

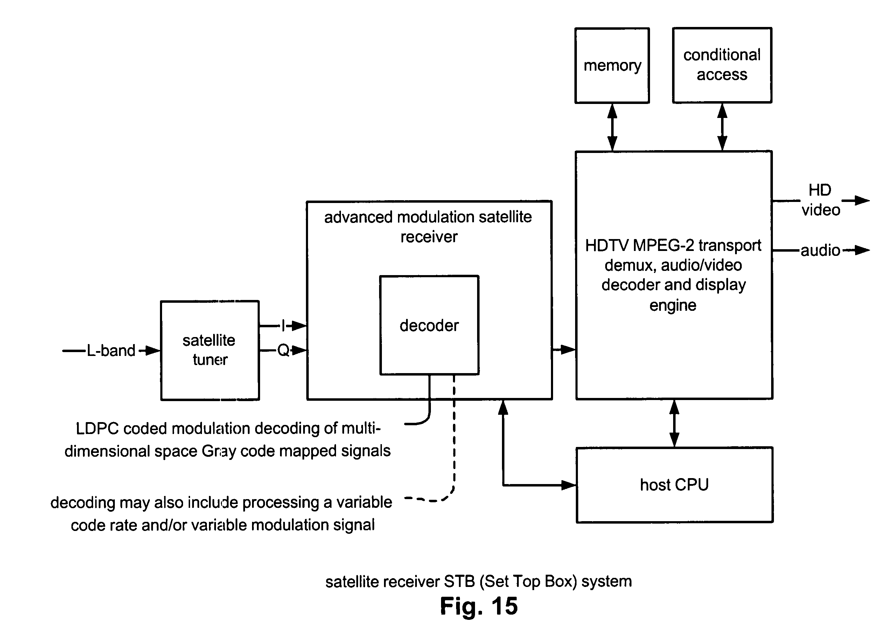

FIG. 15 is a system diagram illustrating an embodiment of a satellite receiver STB (Set Top Box) system that is built according to the invention. The satellite receiver STB system includes an advanced modulation satellite receiver that is implemented in an all digital architecture. Moreover, the advanced modulation satellite receiver may be implemented within a single integrated circuit in some embodiments. The satellite receiver STB system includes a satellite tuner that receives a signal via the L-band (e.g., within the frequency range between 390-1550 MHz (Mega-Hertz) in the ultrahigh radio frequency range). The satellite tuner extracts I, Q (in-phase and quadrature) components from a signal received from the L-band and provides them to the advanced modulation satellite receiver. The advanced modulation satellite receiver includes a decoder.

As within other embodiments that employ a decoder, the decoder may be implemented to perform LDPC coded modulation decoding of multi-dimensional space Gray code mapped signals. Any of a variety of means of LDPC decoding may be employed to support this decoding processing. In addition, this decoding may also be implemented to accommodate decoding processing of an LDPC coded signal whose code rate and/or modulation (constellation and mapping) may vary as frequently as on a symbol by symbol basis.

The advanced modulation satellite receiver may be implemented to communicatively couple to an HDTV MPEG-2 (Motion Picture Expert Group, level 2) transport de-mux, audio/video decoder and display engine. The advanced modulation satellite receiver and the HDTV MPEG-2 transport de-mux, audio/video decoder and display engine communicatively couple to a host CPU (Central Processing Unit). The HDTV MPEG-2 transport de-mux, audio/video decoder and display engine also communicatively couples to a memory module and a conditional access functional block. The HDTV MPEG-2 transport de-mux, audio/video decoder and display engine provides HD (High Definition) video and audio output that may be provided to an HDTV display.

The advanced modulation satellite receiver may be implemented as a single-chip digital satellite receiver supporting the decoder that performs decoding of LDPC coded modulation multi-dimensional space Gray code mapped signals according to the invention. The advanced modulation satellite receiver is operable to receive communication provided to it from a transmitter device that includes an encoder as well.

In addition, several of the following Figures describe particular embodiments that may be used to implement some of the various aspects of encoding and/or decoding LDPC coded modulation multi-dimensional space Gray code mapped signals according to the invention. Several details of these various aspects are provided below.

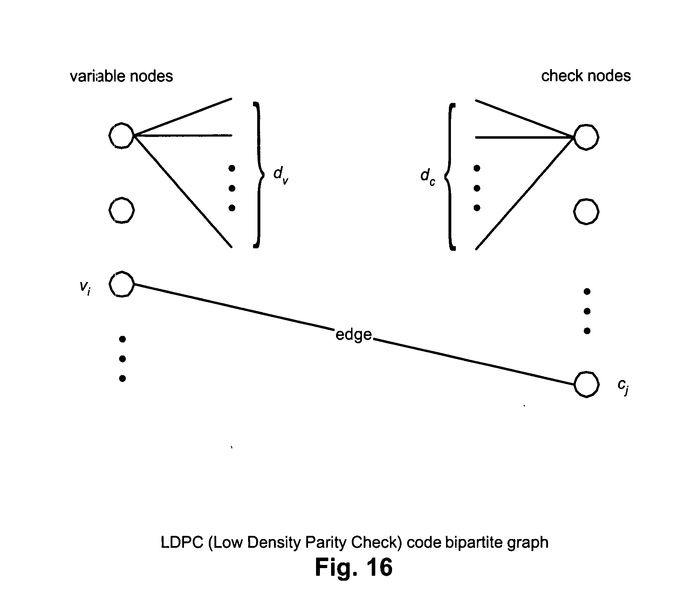

FIG. 16 is a diagram illustrating an embodiment of an LDPC (Low Density Parity Check) code bipartite graph. An LDPC code may be viewed as being a code having a binary parity check matrix such that nearly all of the elements of the matrix have values of zeros. For example, $H = (h_{i,j})_{MxN}$ may be viewed as being a parity check matrix of an LDPC code with block length N. If every column of the matrix has $d_v$ 1's, and every row of the matrix has $d_c$ 1's, then this code is referred to as a $(d_v, d_c)$ regular LDPC code. For example, a regular (4,72) LDPC code would be viewed as being a code whose binary parity check matrix would have 4 1's in every column and 72 1's in every row. These regular LDPC codes were introduced in R. Gallager, *Low-Density Parity-Check Codes,* Cambridge, MA: MIT Press, 1963.

A regular LDPC code can be represented as a bipartite graph by its parity check matrix with left side nodes representing variable of the code bits, and the right side nodes representing check equations. The bipartite graph of the code defined by *H* may be defined by *N* variable nodes and *M* check nodes. Every variable node of the *N* variable nodes has exactly $d_v$ edges connecting this node to one or more of the check nodes (within the check *M* nodes). This number of $d_v$ edges may be referred to as the degree of a variable node. Analogously, every check node of the *M* check nodes has exactly $d_c$ edges connecting this node to one or more of the variable nodes. This number of $d_c$ edges may be referred to as the degree of a check node.

An edge between a variable node $v_i$ and check node $c_j$ may be defined by $e = (i, j)$. However, on the other hand, given an edge $e = (i, j)$, the nodes of the edge may alternatively be denoted as by $e = (v(e),c(e))$. Given a variable node $v_i$, one may define the set of edges emitting from the node $v_i$ by $E_v(i) = \{e| v(e) = i\}$. Given a check node $c_j$, one may define the set of edges emitting from the node $c_j$ by $E_c(j)=\{e|c(e)=j\}$. Continuing on, the derivative result will be $|E_v(i)| = d_v$ and $|E_c(j)|=d_c$.

An irregular LDPC code may also described using a bipartite graph. However, the degree of each set of nodes within an irregular LDPC code may be chosen according to some distribution. Therefore, for two different variable nodes, $v_{i_1}$ and $v_{i_2}$, of an irregular LDPC code, $|E_v(i_1)|$ may not equal to $|E_v(i_2)|$. This relationship may also hold true for two check nodes. The concept of irregular LDPC codes was originally introduced within M. Lugy, M. Mitzenmacher, A. Shokrollahi, D. Spielman and V. Stemann, "Practical loss-resilient codes," *IEEE Trans. Inform. Theory,* Vol. 47, pp. 569-584, Feb. 2001.

In general, with a graph of an LDPC code, the parameters of an LDPC code can be defined by a degree of distribution, as described within M. Lugy, *et al.* (referenced above) and also within T. J. Richardson and R. L. Urbanke, "The capacity of low-density parity-check code under message-passing decoding,"' *IEEE Trans Inform. Theory,* Vol. 47, pp. 599-618, Feb. 2001. This distribution may be described as follows:

Let $\lambda_i$ represent the fraction of edges emanating from variable nodes of degree *i* and let $\rho_i$ represent the fraction of edges emanating from check nodes of degree *i*. Then, a degree distribution pair $(\lambda,\rho)$ is defined as follows:

$$\lambda(x) = \sum_{i=2}^{M_v} \lambda_i x^{i-1} \text{ and } \rho(x) = \sum_{i=2}^{M_c} \rho_i x^{i-1} ,$$

where $M_v$ and $M_c$ represent the maximal degrees for variable nodes and check nodes, respectively.

From certain perspectives, the invention may be implemented within communication systems that involve combining modulation coding with LDPC coding to generate LDPC coded signals. These LDPC coded signals may be such that they have a code rate and/or modulation (constellation and mapping) that varies as frequently as on a symbol by symbol basis. Up to now, there have been some attempts to combine modulation encoding with LDPC coding, yet they are all limited to employing only a single code rate or modulation (constellation and mapping) symbols generated thereby. Nevertheless, some of the possible approaches to combine modulation coding and LDPC coding are described below.

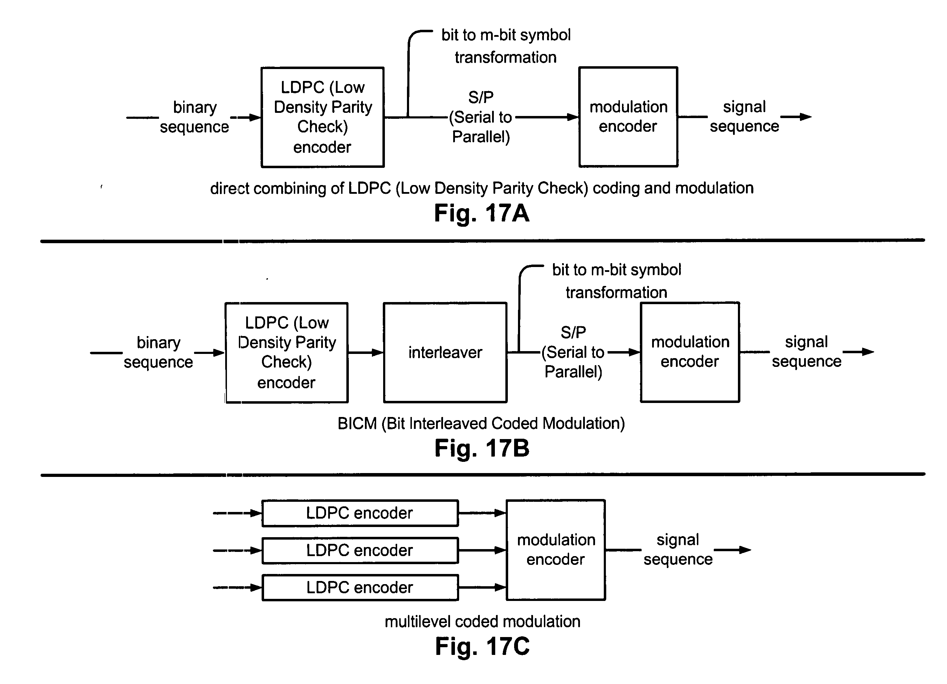

FIG. 17A is a diagram illustrating an embodiment of direct combining of LDPC (Low Density Parity Check) coding and modulation encoding. A binary sequence (e.g., a bit stream) is provided to an LDPC (Low Density Parity Check) encoder. The LDPC encoder introduces a degree of redundancy (or parity) within the bit sequence provided thereto. These LDPC coded bits are then provided to a S/P (Serial to Parallel) path such that the output symbols may be provided to a modulation encoder. This S/P path performs the bit to m-bit symbol transformation. The modulation encoder outputs a signal sequence that includes symbols (composed of LDPC coded bits) that correspond to a modulation having a constellation and a mapping.

FIG. 17B is a diagram illustrating an embodiment of BICM (Bit Interleaved Coded Modulation) that is employed in conjunction with LDPC (Low Density Parity Check) coding and modulation encoding. This embodiment is similar to the embodiment described above that performs direct combining of LDPC coding and modulation encoding, with the exception that an interleaver is interposed between the LDPC encoder and the modulation encoder.

A binary sequence (e.g., a bit stream) is provided to an LDPC encoder. The LDPC encoder introduces a degree of redundancy (or parity) within the bit sequence provided thereto. These LDPC coded bits are then provided to an interleaver to generate a degree of randomness within the LDPC coded bits thereby (hopefully) making that LDPC coded bit sequence to be more robust to interference, noise, and other deleterious effects. This LDPC coded bit sequence that has been interleaved is then provided to a S/P (Serial to Parallel) path such that the output symbols may be provided to a modulation encoder. Again, this S/P path performs the bit to m-bit symbol transformation. The modulation encoder outputs a signal sequence that includes symbols (composed of the interleaved LDPC coded bits) that correspond to a modulation having a constellation and a mapping.

FIG. 17C is a diagram illustrating an embodiment of multilevel coded modulation encoding. Rather than require a S/P (Serial to Parallel) path between a single LDPC encoder and a modulation encoder, this embodiment shows a plurality of LDPC encoders operating in parallel such that the outputs of each of the LDPC encoder is already within parallel format (thereby obviating the need for the S/P (Serial to Parallel) path employed within the embodiments described above). The outputs of these LDPC encoders are provided to a modulation encoder. The modulation encoder outputs a signal sequence that includes symbols (composed of the LDPC coded bits provided by the various LDPC encoders) that correspond to a modulation having a constellation and a mapping.

All 3 of these embodiments, described above that perform the combination of LDPC coding and modulation encoding, typically operate using a single code rate and also use a single modulation (constellation and mapping) to map the binary bits to a given constellation. That is to say, they all typically employ a single code rate and a single modulation (having a single constellation type and a single mapping) for that single constellation. This approach inherently limits the maximal performance that may be achieved using these approaches. In contradistinction, the invention is operable to operate on LDPC coded signals having a code rate and/or a modulation (constellation and mapping) that may vary as frequently as on a symbol by symbol basis. To illustrate further the single modulation approach of these 3 embodiments, a specific implementation that performs such a single mapping is described below.

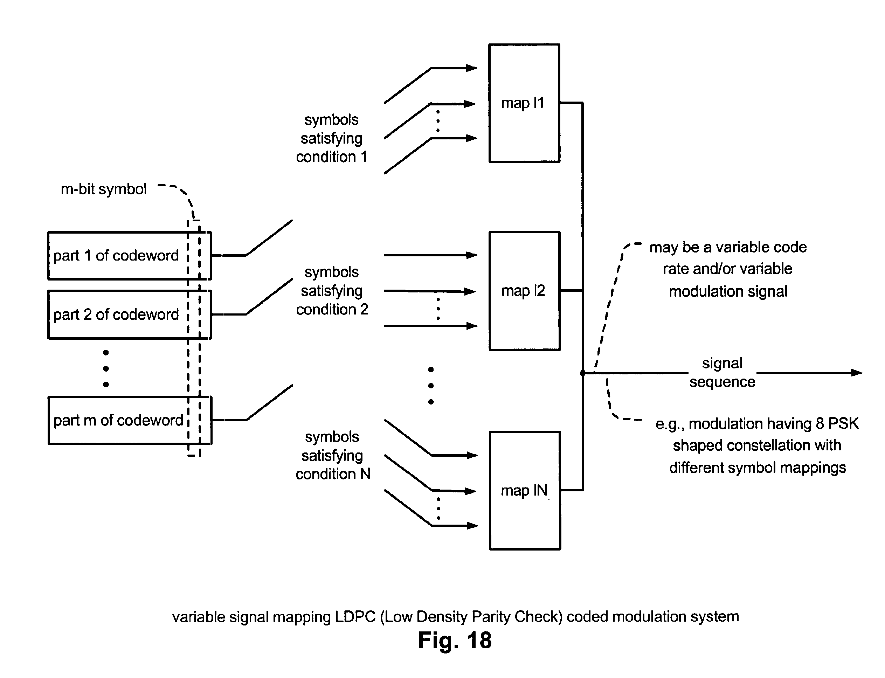

FIG. 18 is a diagram illustrating an embodiment of a variable signal mapping LDPC (Low Density Parity Check) coded modulation system that is built in accordance with invention. This embodiment shows how a general implementation may be made for mapping an LDPC block coded modulation signal thereby generating LDPC coded signals having a modulation (constellation and mapping) that may vary as frequently as on a symbol by symbol basis.

In general, for any modulation, one can select as many as possible constellations and corresponding mappings, to construct an LDPC coded signal having a modulation (constellation and mapping) that may vary as frequently as on a symbol by symbol basis. This diagram illustrates a possible implementation for an m-bit constellation modulation. Moreover, it is also noted that the code can be any one of a variety of block codes.

In a very general illustration, a plurality of different encoders is employed. A first encoder employs a part 1 of a codeword, a second encoder employs a part 2 of a codeword, ..., and a final encoder (of the plurality of encoders) employs a part m of a codeword. Those symbols that satisfy a condition 1 are provided to a map I1. Similarly, those symbols that satisfy a condition 2 are provided to a map I2, and those symbols that satisfy a condition N are provided to a map IN. The various conditions employed to govern the direction of which mapping to which the symbols are provided may be selected by a designer implementing the invention.

The signal sequence generated by this embodiment, or any of the other embodiments for which the decoding approaches of the invention may operate, may be a variable code rate and/or a variable modulation signal. For example, the code rate of the symbols of the signal sequence may vary as frequently as on a symbol by symbol basis. A first symbol may be encoded according to a first code rate, and a second symbol may be encoded according to a second code rate.

In addition, the modulation of the symbols of the signal sequence may vary as frequently as on a symbol by symbol basis. More specifically, for the variable modulation type signal, either one or both of the constellation or mapping of the symbols of the signal sequence may vary as frequently as on a symbol by symbol basis. As yet another example, multiple symbols of the signal sequence may all be mapped to a similarly shaped constellation, yet various symbols may also have different mappings to the same constellation. As one specific example, two symbols may each be associated with an 8 PSK (8 Phase Shift Key) shaped constellation, yet each of the symbols may be mapped differently within that 8 PSK shaped constellation. Clearly, other types of modulations may also be employed without departing from the scope and spirit of the invention.

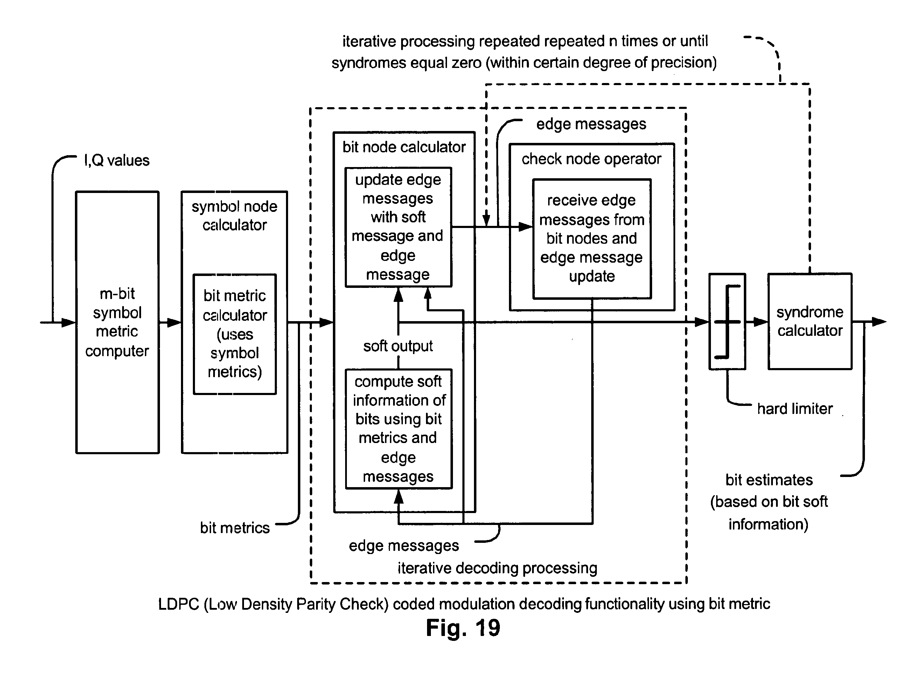

FIG. 19 is a diagram illustrating an embodiment of LDPC (Low Density Parity Check) coded modulation decoding functionality using bit metric according to the invention. To perform decoding of an LDPC coded modulation signal having an m-bit signal sequence, the functionality of this diagram may be employed. After receiving the I, Q (In-phase, Quadrature) values of a signal at the symbol nodes, an m-bit symbol metric computer functional block calculates the corresponding symbol metrics. At the symbol nodes, these symbol metrics are then passed to a symbol node calculator functional block that uses these received symbol metrics to calculate the bit metrics corresponding to those symbols. These bit metrics are then passed to the bit nodes connected to the symbol nodes.

Thereafter, at the bit nodes, a bit node calculator functional block operates to compute the corresponding soft messages of the bits. Then, in accordance with iterative decoding processing, the bit node calculator functional block receives the edge messages from a check node operator functional block and updates the edge messages with the bit metrics received from the symbol node calculator functional block. These edge messages, after being updated, are then passed to the check node operator functional block.

At the check nodes, the check node operator functional block then receives these edge messages sent from the bit nodes (from the bit node calculator functional block) and updates them accordingly. These updated edge messages are then passed back to the bit nodes (e.g., to the bit node calculator functional block) where the soft information of the bits is calculated using the bit metrics and the current iteration values of the edge messages. Thereafter, using this just calculated soft information of the bits (shown as the soft message), the bit node calculator functional block updates the edge messages using the previous values of the edge messages (from the just previous iteration) and the just calculated soft message. The iterative processing continues between the bit nodes and the check nodes according to the LDPC code bipartite graph that was employed to encode the signal that is being decoded.

These iterative decoding processing steps, performed by the bit node calculator functional block and the check node operator functional block, are repeated a predetermined number of iterations (e.g., repeated n times, where n is selectable). Alternatively, these iterative decoding processing steps are repeated until the syndromes of the LDPC code are all equal to zero (within a certain degree of precision).

Soft output information is generated within the bit node calculator functional block during each of the decoding iterations. In this embodiment, this soft output may be provided to a hard limiter where hard decisions may be made, and that hard information may be provided to a syndrome calculator to determined whether the syndromes of the LDPC code are all equal to zero (within a certain degree of precision). That is to say, the syndrome calculator determines whether each syndrome associated with the LDPC code is substantially equal to zero as defined by some predetermined degree of precision. For example, when a syndrome has a mathematically non-zero value that is less than some threshold as defined by the predetermined degree of precision, then that syndrome is deemed to be substantially equal to zero. When a syndrome has a mathematically non-zero value that is greater than the threshold as defined by the predetermined degree of precision, then that syndrome is deemed to be substantially not equal to zero.

When the syndromes are not substantially equal to zero, the iterative decoding processing continues again by appropriately updating and passing the edge messages between the bit node calculator functional block and the check node operator functional block.

After all of these iterative decoding processing steps have been performed, then the best estimates of the bits are output based on the bit soft information. In the approach of this embodiment, the bit metric values that are calculated by the symbol node calculator functional block are fixed values and used repeatedly in updating the bit node values.

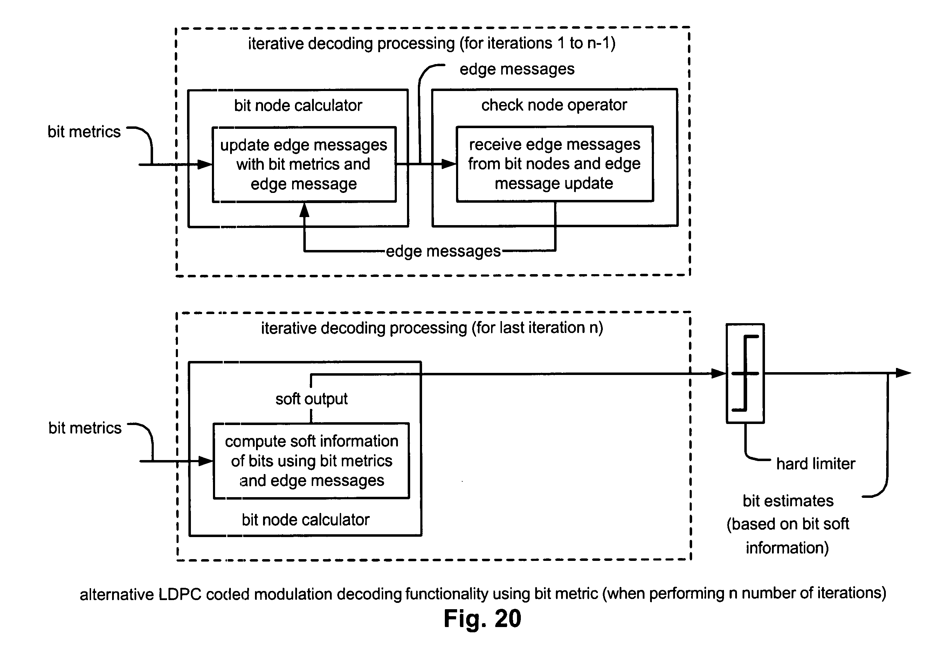

FIG. 20 is a diagram illustrating an alternative embodiment of LDPC coded modulation decoding functionality using bit metric according to the invention (when performing n number of iterations). This embodiment shows how the iterative decoding processing may be performed when a predetermined number of decoding iterations, shown as n, is performed. If the number of decoding iterations is known beforehand, as in a predetermined number of decoding iterations embodiment, then the bit node calculator functional block may perform the updating of its corresponding edge messages using the bit metrics themselves (and not the soft information of the bits as shown in the previous embodiment and described above). This processing may be performed in all but the last decoding iteration (e.g., for iterations 1 through n-1). However, during the last iteration, the bit node calculator functional block calculated the soft information of the bits (shown as soft output). The soft output is then provided to a hard limiter where hard decisions may be made of the bits. The syndromes need not be calculated in this embodiment since only a predetermined number of decoding iterations are being performed.

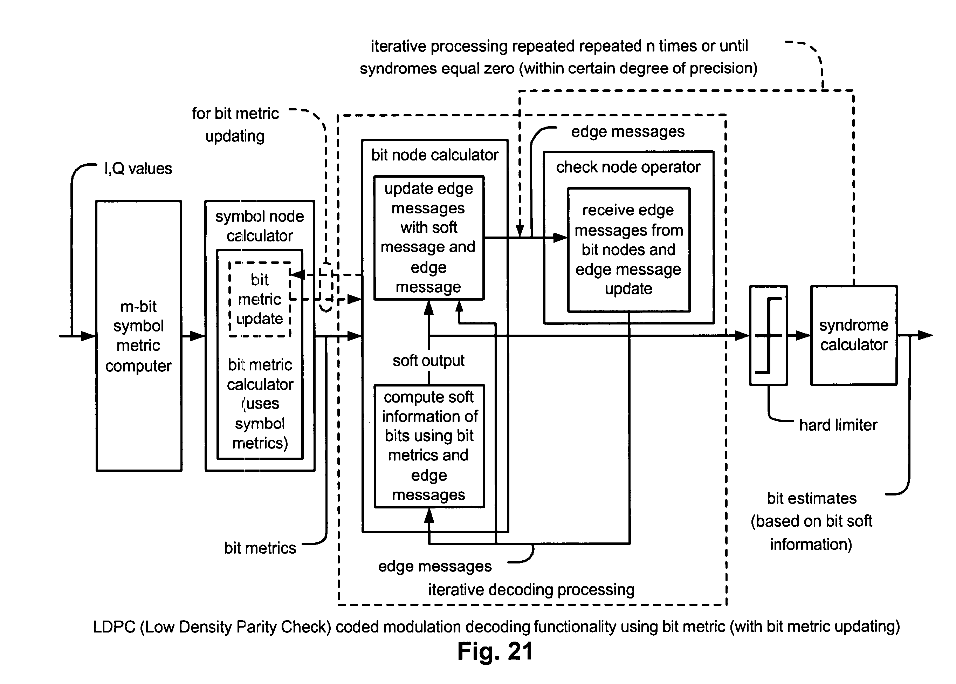

FIG. 21 is a diagram illustrating an alternative embodiment of LDPC (Low Density Parity Check) coded modulation decoding functionality using bit metric (with bit metric updating) according to the invention. To perform decoding of an LDPC coded modulation signal having an m-bit signal sequence, the functionality of this diagram may be employed. After receiving the I, Q (In-phase, Quadrature) values of a signal at the symbol nodes, an m-bit symbol metric computer functional block calculates the corresponding symbol metrics. At the symbol nodes, these symbol metrics are then passed to a symbol node calculator functional block that uses these received symbol metrics to calculate the bit metrics corresponding to those symbols. These bit metrics are then passed to the bit nodes connected to the symbol nodes. The symbol node calculator functional block is also operable to perform bit metric updating during subsequent decoding iterations.

Thereafter, at the bit nodes, a bit node calculator functional block operates to compute the corresponding soft messages of the bits. Then, in accordance with iterative decoding processing, the bit node calculator functional block receives the edge messages from a check node operator functional block and updates the edge messages with the bit metrics received from the symbol node calculator functional block. This updating of the edge messages may be performed using the updated bit metrics during subsequent iterations. These edge messages, after being updated, are then passed to the check node operator functional block.

At the check nodes, the check node operator functional block then receives these edge messages sent from the bit nodes (from the bit node calculator functional block) and updates them accordingly. These updated edge messages are then passed back to the bit nodes (e.g., to the bit node calculator functional block) where the soft information of the bits is calculated using the bit metrics and the current iteration values of the edge messages. Thereafter, using this just calculated soft information of the bits (shown as the soft message), the bit node calculator functional block updates the edge messages using the previous values of the edge messages (from the just previous iteration) and the just calculated soft message. At the same time, as the just calculated soft information of the bits (shown as the soft message) has been calculated, this information may be passed back to the symbol nodes (e.g., to the symbol node calculator functional block) for updating of the bit metrics employed within subsequent decoding iterations. The iterative processing continues between the bit nodes and the check nodes according to the LDPC code bipartite graph that was employed to encode the signal that is being decoded (by also employing the updated bit metrics during subsequent decoding iterations).

These iterative decoding processing steps, performed by the bit node calculator functional block and the check node operator functional block, are repeated a predetermined number of iterations (e.g., repeated n times, where n is selectable). Alternatively, these iterative decoding processing steps are repeated until the syndromes of the LDPC code are all equal to zero (within a certain degree of precision).

Soft output information is generated within the bit node calculator functional block during each of the decoding iterations. In this embodiment, this soft output may be provided to a hard limiter where hard decisions may be made, and that hard information may be provided to a syndrome calculator to determined whether the syndromes of the LDPC code are all equal to zero (within a certain degree of precision). When they are not, the iterative decoding processing continues again by appropriately updating and passing the edge messages between the bit node calculator functional block and the check node operator functional block.

After all of these iterative decoding processing steps have been performed, then the best estimates of the bits are output based on the bit soft information. In the approach of this embodiment, the bit metric values that are calculated by the symbol node calculator functional block are fixed values and used repeatedly in updating the bit node values.

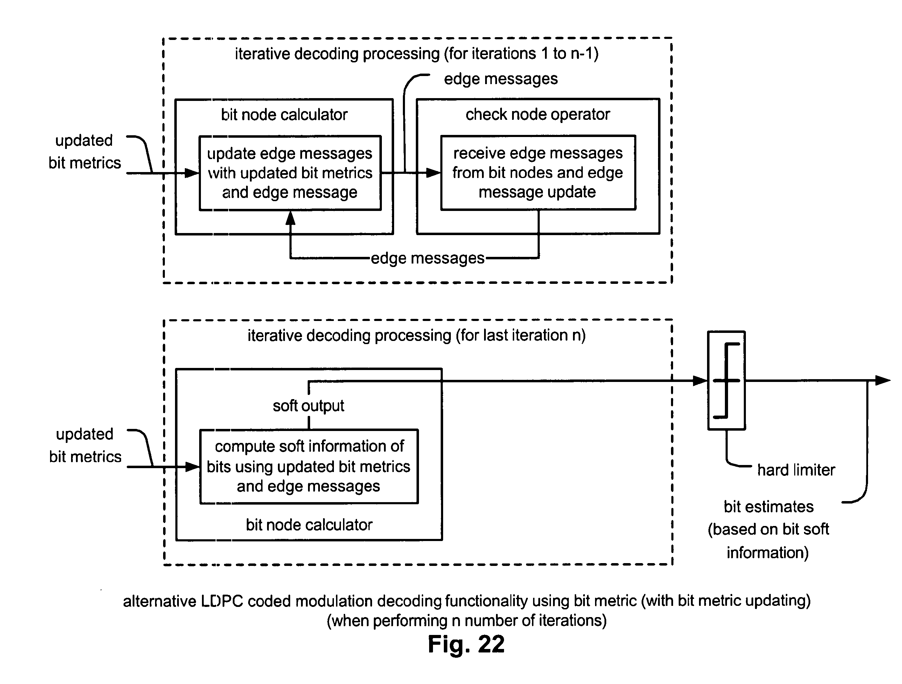

FIG. 22 is a diagram illustrating an alternative embodiment of LDPC coded modulation decoding functionality using bit metric (with bit metric updating) according to the invention (when performing n number of iterations). This embodiment shows how the iterative decoding processing may be performed when a predetermined number of decoding iterations, shown as n, is performed (again, when employing bit metric updating). If the number of decoding iterations is known beforehand, as in a predetermined number of decoding iterations embodiment, then the bit node calculator functional block may perform the updating of its corresponding edge messages using the bit metrics/updated bit metrics themselves (and not the soft information of the bits as shown in the previous embodiment and described above). This processing may be performed in all but the last decoding iteration (e.g., for iterations 1 through n-1). However, during the last iteration, the bit node calculator functional block calculated the soft information of the bits (shown as soft output). The soft output is then provided to a hard limiter where hard decisions may be made of the bits. The syndromes need not be calculated in this embodiment since only a predetermined number of decoding iterations are being performed.

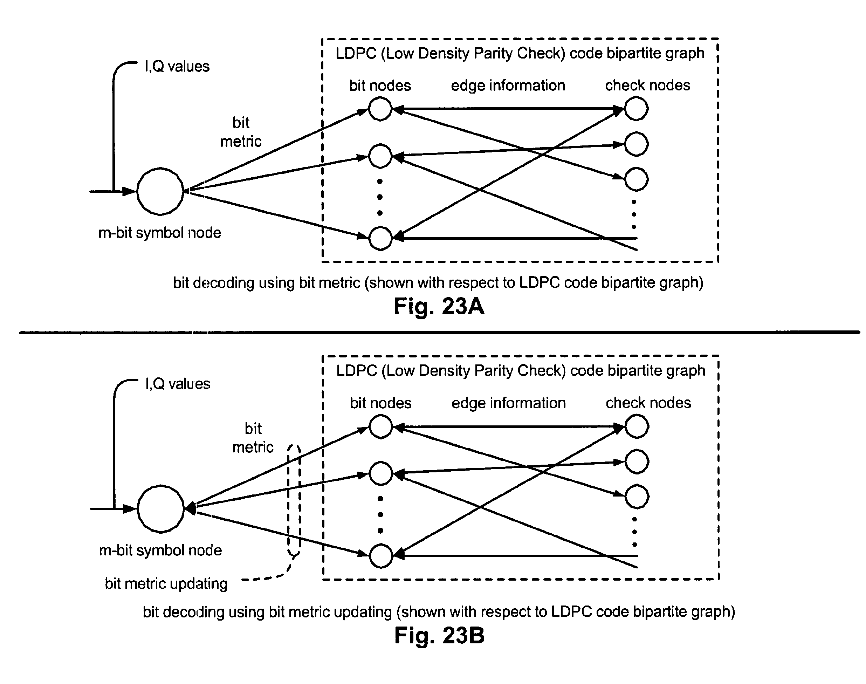

FIG. 23A is a diagram illustrating bit decoding using bit metric (shown with respect to an LDPC (Low Density Parity Check) code bipartite graph) according to the invention. Generally speaking, after receiving I, Q values of a signal at a symbol nodes, the m-bit symbol metrics are computed. Then, at the symbol nodes, the symbol metric is used to calculate the bit metric. The bit metric is then passed to the bit nodes connected to the symbol nodes. At the bit nodes, the soft messages of the bits are computed, and they are used to update the edge message sent from the check nodes with the bit metric. These edge messages are then passed to the check nodes. At the check nodes, updating of the edge messages sent from the bit nodes is performed, and these values are pass back the bit nodes.

As also described above with respect to the corresponding functionality embodiment, after all of these iterative decoding processing steps have been performed, then the best estimates of the bits are output based on the bit soft information. In the approach of this embodiment, the bit metric values that are calculated by the symbol node calculator functional block are fixed values and used repeatedly in updating the bit node values.

FIG. 23B is a diagram illustrating bit decoding using bit metric updating (shown with respect to an LDPC (Low Density Parity Check) code bipartite graph) according to the invention. With respect to this LDPC code bipartite graph that performs bit metric updating, the decoding processing may be performed as follows:

After receiving the I, Q value of the signal at the symbol nodes, the m-bit symbol metrics are computed. Then, at the symbol nodes, the symbol metrics are used to calculate the bit metrics. These values are then passed to the bit nodes connected to the symbol nodes. At the bit nodes, the edge message sent from the check nodes are updated with the bit metrics, and these edge messages are passed to the check nodes. In addition, at the same time the soft bit information is updated and passed back to the symbol nodes. At the symbol nodes, the bit metrics are updated with the soft bit information sent from the bit nodes, and these values are passed back to the variable nodes. At the check nodes, the edge information sent from the bit nodes is updated, and this information is passed back to the bit nodes,

As also described above with respect to the corresponding functionality embodiment, after all of these iterative decoding processing steps have been performed, then the best estimates of the bits are output based on the bit soft information. Again, it is shown in this embodiment that the bit metric values are not fixed; they are updated for use within subsequent decoding iterations. This is again in contradistinction to the embodiment described above where the bit metric values that are calculated only once and remain fixed values for all of the decoding iterations.

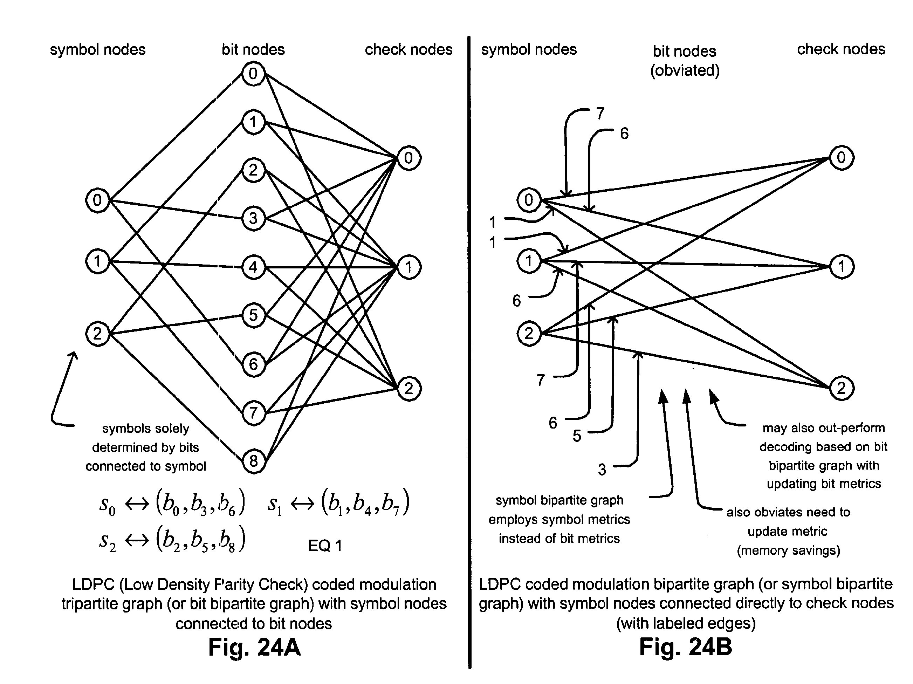

FIG. 24A is a diagram illustrating an LDPC (Low Density Parity Check) coded modulation tripartite graph with symbol nodes connected to bit nodes according to the invention. In this embodiment, it can be seen that the bit nodes are connected to the symbol nodes. The appropriately corresponding bit nodes are also connected to the check nodes according to the LDPC code being employed. However, it is noted that the symbols to be decoded are solely determined by the bits connected to the corresponding symbol. This property is capitalized upon such that the bit nodes may be removed from the LDPC tripartite graph, so that the symbol nodes may be directly connected to the check nodes thereby generating an LDPC coded modulation bipartite graph.

As one example, 3 symbol nodes, $s_0$, $s_1$, $s_2$, are connected to the 9 bit nodes, $b_0$, $b_1$, $b_2$,...,$b_8$, according to the following mapping:

$$s_0 \leftrightarrow (b_0, b_3, b_6)$$
$$s_1 \leftrightarrow (b_1, b_4, b_7) \qquad\qquad (EQ\ 1)$$
$$s_2 \leftrightarrow (b_2, b_5, b_8)$$

The connections between the 9 bit nodes, $b_0$, $b_1$, $b_2$,...,$b_8$, and the 3 check nodes, $c_0$, $c_1$, $c_2$, are made according to the following mapping:

$$b_0 \leftrightarrow (c_0, c_2)$$
$$b_1 \leftrightarrow (c_0, c_1)$$
$$b_2 \leftrightarrow (c_1, c_2)$$
$$b_3 \leftrightarrow (c_0, c_1)$$
$$b_4 \leftrightarrow (c_1, c_2)$$
$$b_5 \leftrightarrow (c_0, c_2)$$
$$b_6 \leftrightarrow (c_0, c_1)$$
$$b_7 \leftrightarrow (c_1, c_1)$$
$$b_8 \leftrightarrow (c_0, c_1)$$

FIG. 24B is a diagram illustrating an LDPC (Low Density Parity Check) coded modulation bipartite graph (or symbol bipartite graph) with symbol nodes connected directly to check nodes according to the invention (this bipartite graph is generated from the tripartite graph shown in FIG. 24A). One aspect of the invention is the ability to reduce the number of nodes within an LDPC bipartite graph by directly connecting the symbols nodes to the check nodes (e.g., by modifying an LDPC coded modulation tripartite graph to generate an LDPC coded modulation bipartite graph). However, this must be performed very carefully to ensure proper decoding of such LDPC coded signals. As is described herein, the labeling of the edges connected the symbols nodes to the check nodes needs to be done carefully to ensure proper decoding of symbols.

Within this LDPC code bipartite graph, the edges are only connected between the symbol nodes and the check nodes. In doing so, every edge connecting the symbol nodes and the check nodes is labeled by a value according to EQ 1 shown above. In some embodiments, these edges are labeled using octal values.

For example, using an octal labeling approach, the edge connecting the symbol node $s_0$ to the check node $c_0$, depicted as $(s_0, c_0)$, is labeled as 7 since all three bits $b_0$, $b_3$, $b_6$ are connected to $c_0$ (e.g., labeled as 7 because $b_0$, $b_3$, $b_6$ = 111). Similarly, the edge connecting the symbol node $s_0$ to the check node $c_1$, depicted as $(s_0, c_1)$, is labeled as 6 since only the two bits $b_0$, $b_3$ are connected to $c_1$ (e.g., labeled as 6 because $b_0$, $b_3$, $b_6$ = 110). As another example, , the edge connecting the symbol node $s_0$ to the check node $c_2$, depicted as $(s_0, c_2)$, is labeled as 1 since only the one bit $b_0$ is connected to $c_2$ (e.g., labeled as 1 because $b_0$, $b_3$, $b_6$ = 100). The additional edges that communicatively couple the symbols nodes to the check nodes may also be labeled according to this convention.

One of the advantages of the symbol node to check node LDPC code bipartite graph is that a decoder may use symbol metrics when performing the decoding processing of the LDPC coded symbols instead of bit metrics. In this way of performing the decoding processing, there is therefore no need to perform metric updating; the metric updating within the decoding processing may have the undesirable effect of requiring an increased amount of memory to be used. Moreover, the decoding based on the LDPC code bipartite graph (sometimes referred to as a symbol LDPC code bipartite graph) actually out-performs decoding processing that is based on an LDPC code tripartite graph (whose bit nodes are connected to check nodes). In addition, the LDPC symbol decoding provides comparable or better performance of LDPC bit decoding that involves updating of the bit metrics.

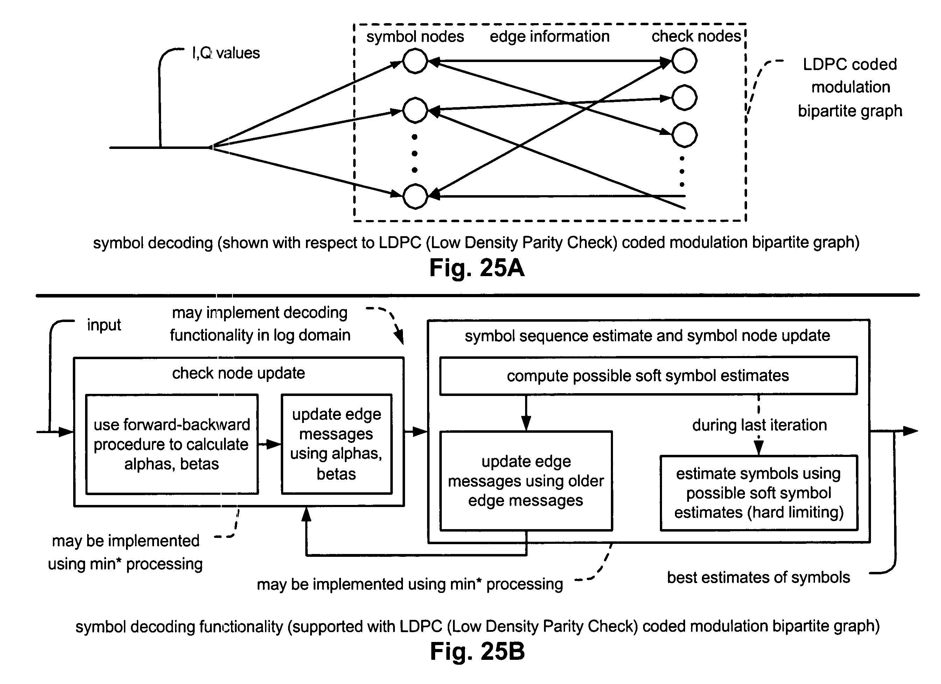

FIG. 25A is a diagram illustrating symbol decoding (shown with respect to an LDPC (Low Density Parity Check) coded modulation bipartite graph) according to the invention. The symbol decoding processing performed according to the invention may be performed using an LDPC coded modulation bipartite graph in which the symbol nodes are connected directly to the check nodes. In general, the I, Q values of a symbol are provided to the symbol nodes, and the iterative decoding processing is performed according to the manner in which the labeled edges communicatively couple the symbol nodes to the check nodes.

As an example of how the decoding processing may be performed using such an LDPC coded modulation bipartite graph, a rate 2/3 LDPC code with an 8 PSK (8 Phase Shift Key) modulation signal is decoded and explained in detail. This LDPC code may be a regular LDPC code or an irregular LDPC code without departing from the scope and spirit of the invention. The block length of the LDPC code is $3N$ and a 3 bit symbol $s_i$ is mapped (e.g., using a symbol mapper) according to the following notation:

$$s_i = (b_i, b_{N+i}, b_{2N+i})$$

The parity check matrix of the LDPC code may be represented as $[h_{ij}]_{N \times 3N}$. The estimated symbols $r_i$ corresponding to the 3 bit symbol $s_i$ may be represented as $r_i = (r_{0i}, r_{1i}, r_{2i})$. The partial syndromes $S^m(i)$ and $S_m(i)$ (which may generally be referred to as syndromes, as they are up above in other embodiments) that are calculated using the estimated symbols and the parity check matrix of the LDPC code may be represented as follows:

$$S^m(i) = \sum_{j=0}^{m-1} \left( r_{0j} h_{ij} + r_{1j} h_{i(N+j)} + r_{2j} h_{i(2N+j)} \right)$$

$$\text{(EQ 2)}$$

$$S_m(i) = \sum_{j=m}^{N-1} \left( r_{0j} h_{ij} + r_{1j} h_{i(N+j)} + r_{2j} h_{i(2N+j)} \right)$$

The following decoding processing description is described as being performed on a signal sequence $Y$. The probability of the signal sequence $Y$ satisfying the partial syndrome,

$$p\left( S^j(i) = m \mid Y \right),$$

to be equal to $A_{i,j}(m)$ is calculated (e.g., the probability of

$$p\left( S^j(i) = m \mid Y \right) = A_{i,j}(m) ).$$

In addition, other probabilities are calculated; namely, the probability of the signal sequence $Y$ satisfying the partial syndrome,

$$p\left( S_j(i) = m \mid Y \right),$$

to be equal to $B_{i,j}(m)$ is calculated (e.g., the probability of

$$p\big(S_j(i) = m \mid Y\big) = B_{i,j}(m).$$

These probabilities are all calculated based on the following conditions:

$$A_{i,0}(0) = 1$$

$$B_{i,\deg(c_i)-1}(0)=1$$

, and

$$A_{i,0}(m) = 0$$

$$B_{i,\deg(c_i)-1}(m)=0,$$

where $m \neq 0$.

Since the decoding may be performed in the logarithmic domain thereby enabling multiplication operations to be performed using addition and division operations to be performed using subtraction, these variables may be redefined within the logarithmic domain as follows:

$$\alpha_{i,j}(m) = \log(A_{i,j}(m))$$

$$\beta_{i,j}(m) = \log(B_{i,j}(m)).$$

These values may be referred to as the alphas, or forward metrics, ($\alpha_{i,j}(m)$) and betas, or backward metrics, ($\beta_{i,j}(m)$) to be employed within the decoding processing.

The edge messages being passed from the check nodes to the symbol nodes may be represented as *Medge* [*i*][*j*][*k*], where *i* runs according to the appropriately labeled edges within the LDPC coded modulation bipartite graph.

As some examples:

    1. if the label is 7, then *k* runs from 0 to 7,
    2. if the label is 3, 5, or 6, then *k* runs from 0 to 3, and
    3. if the label is 1,2, or 6, then *k* runs between 0 to 1.

In addition, a new function $x(v)$ that varies from {0,...,7} to {0,1} may be employed. The value *v* may be viewed as being an integer represented in octal. Then, the value of *v* may be represented as $v = (v_0, v_1, v_2)$. This new function $x(v)$ may be represented as follows:

$$x(v) = v_0 \oplus v_1 \oplus v_2 \tag{EQ 3}$$

where $\oplus$ is an exclusive-or function (e.g., binary addition).

The notation and definitions provided above are also employed to describe the symbol decoding processing in other embodiments whose decoding processing and/or functionality are described in more detail below. More specifically, the embodiments described in more detail below show how the check node updating and symbol sequence estimation, as well as symbol node updating, is performed using these various values.

FIG. 25B is a diagram illustrating an embodiment of symbol decoding functionality (supported with an LDPC (Low Density Parity Check) coded modulation bipartite graph) according to the invention. This embodiment shows in more detail how the check node updating and symbol sequence estimation, as well as symbol node updating, is performed.

The decoding processing described in this embodiment may be better understood in the context of the check node updating and symbol sequence estimation, including the symbol node updating, that may be performed within in at least 2 different embodiments that are described herein in accordance with the invention: (1) symbol decoding and (2) hybrid decoding (that performs a combination of bit level and symbol level decoding). One possible embodiment of symbol decoding is described in this diagram (FIG. 25B), and various possible embodiments by which hybrid decoding may be implemented are described below with respect to the remaining diagrams of this disclosure.

Beginning from the left hand side of the diagram, input information corresponding to the calculated partial syndromes, that also includes the initial values of the alphas ($\alpha_{i,j}(m)$) and the betas ($\beta_{i,j}(m)$) (e.g., forward and backward metrics), are provided to a check node update functional block. Iterative decoding processing is performed within the check node update functional block over the total number of check nodes. For example, $M$ iterations are performs over $i$ (where $i$ varies from 0 to $M$ -1, and where $M$ is the total number of check nodes of the LDPC bipartite graph).

In doing this iterative decoding processing, the check node updating initially involves calculating the values of the alphas ($\alpha_{i,j}(m)$) and the betas ($\beta_{i,j}(m)$) (beyond merely the initial values that are provided during the initial iteration) for each of the symbols of a received symbol block. This iterative decoding processing in calculating the alphas and betas may be performed using a forward-backward procedure through the received symbol block.

The calculation of the alphas and betas is described below.

For $j = 0$ to deg($c_i$)-1 and $m = 0,1$, the forward-backward processing procedure may be employed to calculate the alphas ($\alpha_{i,j}(m)$) and the betas ($\beta_{i,j}(m)$) as follows:

$$\alpha_{i,j}(m) = \text{min*} \{Medge[i][j\text{-}1][k] + \alpha_{i,j\text{-}1}(m \oplus x(k)) \mid \text{all possible } k\}$$

$$\beta_{i,j}(m) = \text{min*} \{Medge[i][j + 1][k] + \beta_{i,j+1}(m \oplus x(k)) \mid \text{all possible } k\}$$

Now that these values of alpha and beta are available for each of the symbols within a received symbol block, the edge messages $Medge[i][j][k]$ (that communicatively couple the symbol nodes to the check nodes) are updated using these calculated alphas and betas values.

For $j = 0$ to deg($c_i$)-1 and all possible $k$, the updating of the edge messages $Medge[i][j][k]$ may be performed as follows:

$$Medge[i][j][k] = \text{min*}\left\{\left[\alpha_{i,j}(0) + \beta_{i,j}(x(k))\right], \left[\alpha_{i,j}(1) + \beta_{i,j}(x(k) \oplus 1)\right]\right\}$$

The min* processing functionality described herein may be better understood by the following description. The min* processing includes determining a minimum value from among two values (e.g., shown as min(A,B) in min* processing) as well as determining a logarithmic correction factor (e.g., shown as

$$\ln\left(1 + e^{-|A-B|}\right)$$

in min* processing) in selecting the smaller metric. In addition, it is also noted that max* processing may alternatively be performed in place of min* processing. The max* processing operation also includes a logarithmic correction in selecting the larger metric. It is noted that the various embodiments of the invention may be implemented using the max* operations in lieu of the min* operation when preferred in a given implementation.

The min* processing, when operating on inputs $A$ and $B$, may be expressed as follows:

$$\text{min*}(A, B) = \min(A, B) - \ln\left(1 + e^{-|A-B|}\right)$$

Again, the min* processing may alternatively be performed using max* processing. The max* processing, when operating on inputs $A$ and $B$, may be expressed as follows:

$$\text{max*}(A, B) = \max(A, B) + \ln\left(1 + e^{-|A-B|}\right)$$

Moreover, when multiple min* operations are to be performed on multiple values (e.g., more than 2), the min* processing may be expressed as follows:

$$\min^* (x_1,...,x_N) = \min^* (\min^* (x_1,...,x_{N-1}), x_N) \qquad\qquad \text{(EQ 4)}$$

After the check node processing has been completed, a symbol sequence estimate and symbol node update functional block operates using the check node update messages to continue the decoding processing.

Since the total number of edges is the same count from either side (e.g., from either the symbol node side or the check node side), the edges are intrinsically re-ordered according to the symbols that are being decoded. This re-ordering may be intrinsically performed using a LUT (Look-Up Table) to ensure the proper ordering of the check node updating. In other words, the LUT may be implemented to perform the function of which edge information to take when performing the symbol sequence estimate and symbol node update. In addition, this re-ordering functionality may be inherently implemented in hardware for proper ordering of the check node updating such that it corresponds to an order that is appropriate to the symbol node updating. For proper decoding of the symbols of the sequence (e.g., first symbol to last symbol) there needs to be some ordering of the symbols. However, this symbol ordering is not critical when performing the check node updating. That is to say, the ordering of the check node updating may then be performed according to any desired ordering, and to ensure proper decoding of the symbols according to the desired order (e.g., first symbol to last symbol), the check node updating is performed to ensure that the edge messages are inherently appropriately ordered according to the desired order for the decoding processing.

More specifically, this decoding processing may be understood with respect to the edge messages $Medge[i]$ $[j][k]$, where $i$ runs across all of the symbol nodes, where $j$ runs according to the degree of the edges from the symbol nodes, and where $k$ runs according to the labels of the LDPC bipartite graph.

This embodiment described with respect to this diagram is shown with respect to a code that includes 3 bit symbols, coded according to 8 PSK (8 Phase Shift Key) modulation. However, it is noted that such a decoding approach may also be adapted very easily to decoding signals having an even larger number of bits. For example, this decoding approach may be adapted to perform decoding of signals having symbols of higher order modulations including 16 QAM (16 Quadrature Amplitude Modulation), 16 APSK (16 Asymmetric Phase Shift Keying), 64 QAM, and even other modulation types without departing from the scope and spirit of the invention.

The label on the $j$-th edge from the check node $i$ may be denoted as $L_{i,j}$. A new function, $sh(L,v)$, may be defined and employed to assist in the decoding processing describer herein. This new function $sh(L,v)$ may be defined as follows:

$$sh\left(L,\left(v_0,v_1,v_2\right)\right) = \begin{cases} v_2 & L=1 \\ v_1 & L=2 \\ \left(v_1,v_2\right) & L=2 \\ v_0 & L=4 \\ \left(v_0,v_2\right) & L=5 \\ \left(v_0,v_1\right) & L=6 \\ \left(v_0,v_1,v_2\right) & L=7 \end{cases} \qquad\qquad \text{(EQ 5)}$$

After the edge messages have been intrinsically and appropriately re-ordered using the approach described above, the symbol sequence estimate and symbol node update functional block continues to operate according to the following procedure.

For m = 0,...,7, the possible values for the soft symbol estimates are computed (e.g., the possible values for the soft information of the symbols is calculated) as follows:

$$p_i(m) = Metric_i[m] + \sum_{j=0}^{\deg(s_i)-1}\left(\sum_{Li_j} Medge[i][j][sh(L_{i,j},m)]\right),$$

where $Metric_i[m]$ is the appropriate symbol metric obtained from the received signal according to its appropriate modulation (constellation and mapping values).

The symbol sequence estimate and symbol node update functional block continues by estimating the symbols using the soft symbol estimates. More specifically, the estimate of the symbol $s_i$ to $m$ is made such that $p_i(m)$ is the smallest value selected from among all of the possible values of $p_i(0)$, $p_i(1)$,..., $p_i(7)$.

After the estimate of the symbols is made using the soft symbol estimates, the edge messages are updated within the symbol sequence estimate and symbol node update functional block using the older edge messages. More specifically, the edge message are updated as follows:

The processing may be better understood by considering the edge label $L_{i,j}$,

1. if $L_{i,j} = 7$ , then for $m = 0,...,7$, $Medge[i][j][k] = p_i[m]-Medge[i][j][m]$.
2. alternatively, if $L_{i,j} = 3,5,6$ , then for $m_0$, $m_1 \in \{0,1\}$, then the values of the edge messages may be defined as:

$$Medge[i][j](m_0,m_1)]$$
$$= \begin{cases} \min^*\left(p_i(0,m_0,m_1), p_i(1,m_0,m_1)\right) - Medge[i][j](m_0,m_1)] & L_{i,j} = 3 \\ \min^*\left(p_i(m_0,0,m_1), p_i(m_0,1,m_1)\right) - Medge[i][j](m_0,m_1)] & L_{i,j} = 5 \\ \min^*\left(p_i(m_0,m_1,0), p_i(m_0,m_1,1)\right) - Medge[i][j](m_0,m_1)] & L_{i,j} = 6 \end{cases}$$

3. alternatively, if $L_{i,j} = 1,2,4$ , then for $m = 0,1$, then the values of the edge messages may be defined as:

$$Medge[i][j](m)]$$
$$= \begin{cases} \min^*\left\{p_i(k_0,k_1,m)\,|\,k_0,k_1 \in \{0,1\}\right\} - Medge[i][j][m] & L_{i,j} = 1 \\ \min^*\left\{p_i(k_0,m,k_1)\,|\,k_0,k_1 \in \{0,1\}\right\} - Medge[i][j][m] & L_{i,j} = 2 \\ \min^*\left\{p_i(m,k_0,k_1)\,|\,k_0,k_1 \in \{0,1\}\right\} - Medge[i][j][m] & L_{i,j} = 4 \end{cases}$$

where the right hand side edge of these equations is the old edge message passed from the check node.

Continuing on with the iterative decoding processing, using the updated edge messages (that are updated either a predetermined number of times and/or until convergence of the edge messages has been met within a certain degree of precision), then the best estimates of the symbols of a received symbol block may be made.

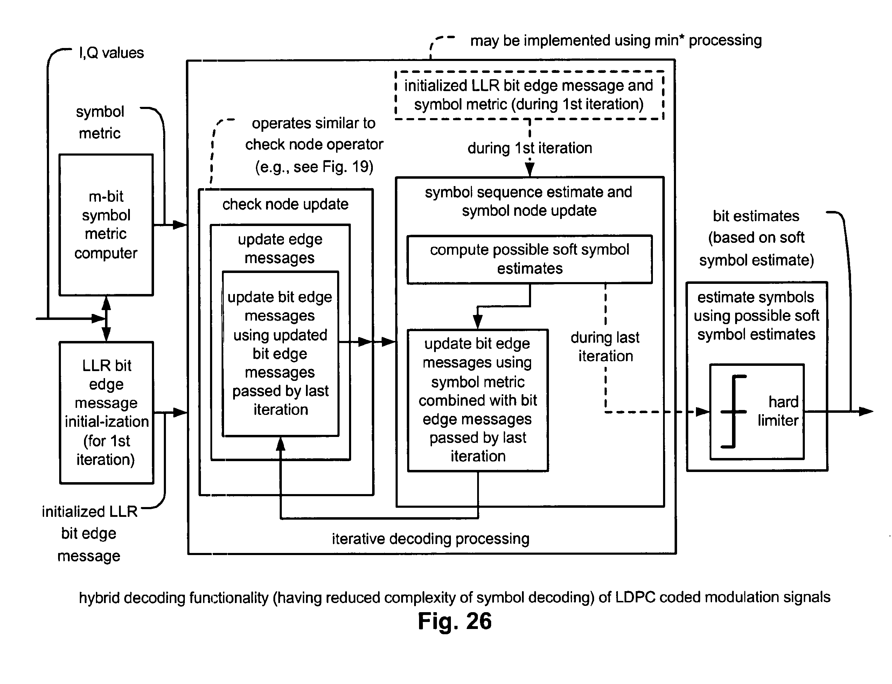

FIG. 26 is a diagram illustrating an embodiment of hybrid decoding functionality (having a reduced complexity when compared to symbol decoding) of LDPC (Low Density Parity Check) coded modulation signals according to the invention. This embodiment showing hybrid decoding processing may be viewed as being a modification (e.g., a departure) of the previous decoding processing approaches described up to now. In general, similar decoding functional blocks are employed within the iterative decoding processes as shown within the symbol decoding embodiments described above, but the manner in which these functional blocks operate is different; these differences provide for a less complex decoding approach, and (as is seen below with respect to comparing the performance of various decoding approaches) the hybrid decoding approach also provides for a significant improvement in performance (e.g., when compared to bit decoding only).

This hybrid decoding functionality begins by receiving the I, Q values of the received signal. Thereafter, an m-bit symbol metric computer functional block caicuiates the corresponding symbol metrics using the I, Q values. Also, a functional block performs the LLR (log likelihood ratio) bit edge message initialization for use in the first decoding iteration; this initialization need only be performed once. If desired, this initial LLR bit edge message may be initialized to a value of 0 for the initial iteration (e.g., iteration i=0). From these functional blocks, the symbol metric and the initialized LLR bit edge message are passed to an iterative decoding processing functional block that includes a check node update functional block and a symbol sequence estimate and symbol node update functional block. These initial conditions (or initial values) of the LLR bit edge message and the symbol metric are employed by the symbol sequence estimate and symbol node update functional block during a 1st decoding iteration of the iterative decoding processing.

The check node update functional block operates in a relatively similar manner as the check node operator functional block that is described above with respect to the LDPC coded modulation decoding functionality using bit metric approach (e.g., see FIG. 19). In general, the check node update functional block performs updating of the edge messages received from a symbol sequence estimate and symbol node update functional block. This symbol sequence estimate and symbol node update functional block (of the hybrid decoding approach) differs from the symbol sequence estimate and symbol node update functional block (of the symbol decoding approach).

When performing the update of the edge messages within the check node update functional block, the check node update functional block updates the bit edge messages using the updated bit edge messages passed by the last iteration. During a first decoding iteration, this may include using the initialized values of the bit edge message. However, during the iterative decoding processing, the check node update functional block passed the updated edge messages to the symbol sequence estimate and symbol node update functional block.

Again, it is noted that the symbol sequence estimate and symbol node update functional block uses the initial conditions of the LLR bit edge message during its first iteration of the iterative decoding processing. It also uses the initially received symbol metric value during subsequent iterations of the iterative decoding processing. The symbol sequence estimate and symbol node update functional block initially performs computation of the possible soft symbol estimates. Then, the symbol sequence estimate and symbol node update functional block uses this information to assist in the updating of the edge messages. More specifically, the symbol sequence estimate and symbol node update functional block updates the bit edge messages using the computed symbol metric (from the m-bit symbol metric computer) combined with the bit edge message passed by the last iteration from the check node update functional block. From one perspective, this shows the hybrid decoding functionality such that a combined use of bit level information and symbol level information are both used in a manner that (as is also described below) that provides a significant reduction in complexity and ease of implementation while providing performance that may be as good as the symbol decoding approach in some embodiments. In general, the performance of the hybrid decoding approach is as good as or worse than the symbol decoding approach; however, the hybrid decoding approach may be implemented significantly easier than the symbol decoding approach (e.g., with significantly reduced processing, memory, and memory management resources).

The iterative decoding processing continues between the symbol sequence estimate and symbol node update functional block and the check node update functional block such that the edge messages are continually, successively and alternatively updated in an effort to converge on a final value of the bit edge messages (either after performing a predetermined number of iterations or after a sufficient degree of accuracy is achieved and the bit edge messages have converged on a final value, that meets the sufficient degree of accuracy). The updating is successive and alternative from the perspective that the symbol sequence estimate and symbol node update functional block performs an updating, and then the check node update functional block performs an updating, and then the iterative decoding processing continues.

During a last decoding iteration, the symbol sequence estimate and symbol node update functional block may be implemented to perform an estimate of the symbols using the possible soft symbol estimates that have been calculated. This soft symbol estimate is then output from the symbol sequence estimate and symbol node update functional block to a hard limiter where hard decisions may be made for the individual bits within the soft symbol estimate. This final output may be viewed as being the individual bit estimates of the bits within the symbol that is being decoded using the hybrid decoding approach. That is to say, the hard limiter makes bit estimates based on the best estimate for each of the symbols such that the bit estimates are hard decisions for each of the individual bits of those respective symbols.

In one implementation (described here with respect to the FIG. 26), these iterative decoding processing steps, performed by the symbol sequence estimate and symbol node update functional block and the check node update functional block, are repeated a predetermined number of iterations (e.g., repeated n times, where n is selectable).

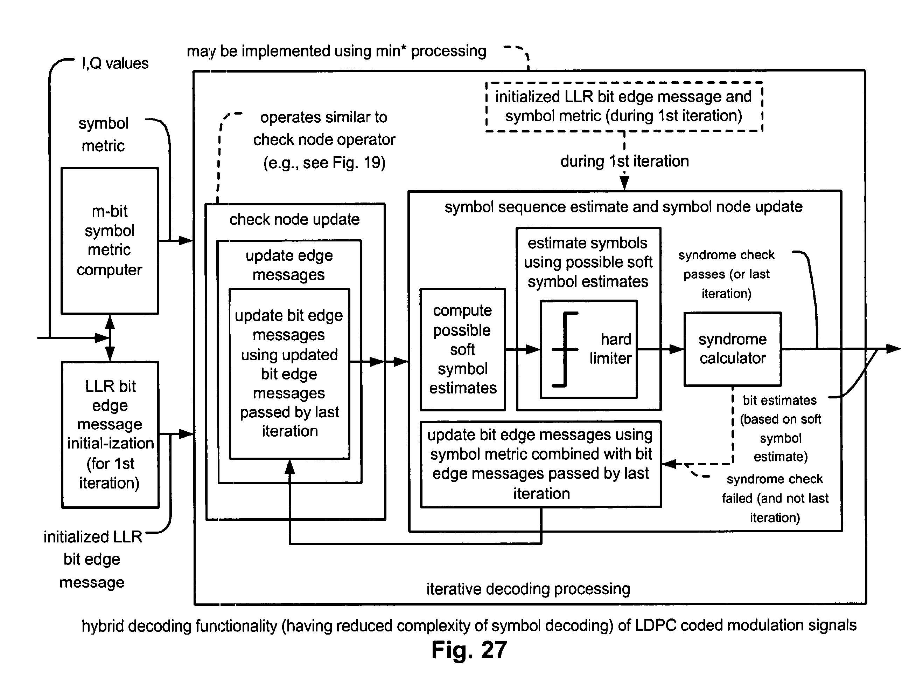

FIG. 27 is a diagram illustrating another embodiment of hybrid decoding functionality (having a reduced complexity when compared to symbol decoding) of LDPC coded modulation signals according to the invention. In this alternative implementation, these iterative decoding processing steps are repeated until the syndromes of the LDPC code are all equal to zero (within a certain degree of precision). As mentioned above, soft symbol estimate is generated within the symbol sequence estimate and symbol node update functional block. This soft output information may be provided to a hard limiter where hard decisions may be made, and that hard information may be provided to a syndrome calculator to determined whether the syndromes of the LDPC code are all equal to zero (within a certain degree of precision). When they are not, a syndrome check failed signal may be provided to the iterative decoding processing functional block (and when it is determined that this decoding iteration is not the last decoding iteration), and the iterative decoding processing continues again by appropriately updating and passing the bit edge messages between the check node update functional block and the symbol sequence estimate and symbol node update functional block. After all of these iterative decoding processing steps have been performed, then the best estimates of the bits are output based on the soft symbol estimates. It is also noted that some additional decisions and/or operations may be implemented when the situation arises where the syndromes of the LDPC code are not converging substantially to zero (within a certain degree of precision) and yet the last decoding iteration has in fact been performed.

This functionality diagrams described above with respect to the FIG. 26 and the FIG. 27 show at least two possible ways in which the hybrid decoding approach may be performed to allow for the decoding of LDPC coded signals using both bit level and symbol level information (e.g., thereby being hybrid). Other possible embodiments are also described below to show how this type of hybrid decoding may be performed.

It is also noted that this functionality (within the FIG. 26 and/or FIG. 27) may be implemented in the logarithmic domain thereby enabling multiplication operations to be performed using addition and division operations to be performed using subtraction. Moreover, many of the calculations may be performed using min* processing as is also described in greater detail below in other of the various embodiments.

With respect to each of the decoding approaches described above within FIG. 19-27, it is noted that any of these decoding approaches may be employed to perform LDPC coded modulation decoding of multi-dimensional space Gray code mapped signals according to the invention. That is to say, any of the various means of performing LDPC decoding may be employed with the exception that the bit metric needs to be obtained from the symbol metric obtained with respect to the multi-dimensional constellation set. That is to say, the symbol metrics must be decomposed to generate the bit metrics.

In the remaining discussion, more detail is provided as how to construct multi-dimensional space Gray code maps for multi-dimensional modulation and how they may be applied to LDPC coded modulation systems. In one possible embodiment that is described in detail, a rate 5/6 LDPC coded modulation system with a 2-D (2-dimensional) Gray code map is presented that provides for better performance than LDPC coded modulation systems using a single-dimensional (e.g., 1-D) space Gray code map. Since the core features of the iterative decoding processing that may be employed is similar to that employed with respect to LDPC coded modulation systems using a 1-D space Gray code map, the complexity of LDPC coded modulation decoding of multi-dimensional space Gray code mapped signals only increases slightly (e.g., with respect to the bit metric decomposition from the symbol metrics that accommodate for the 2-D).

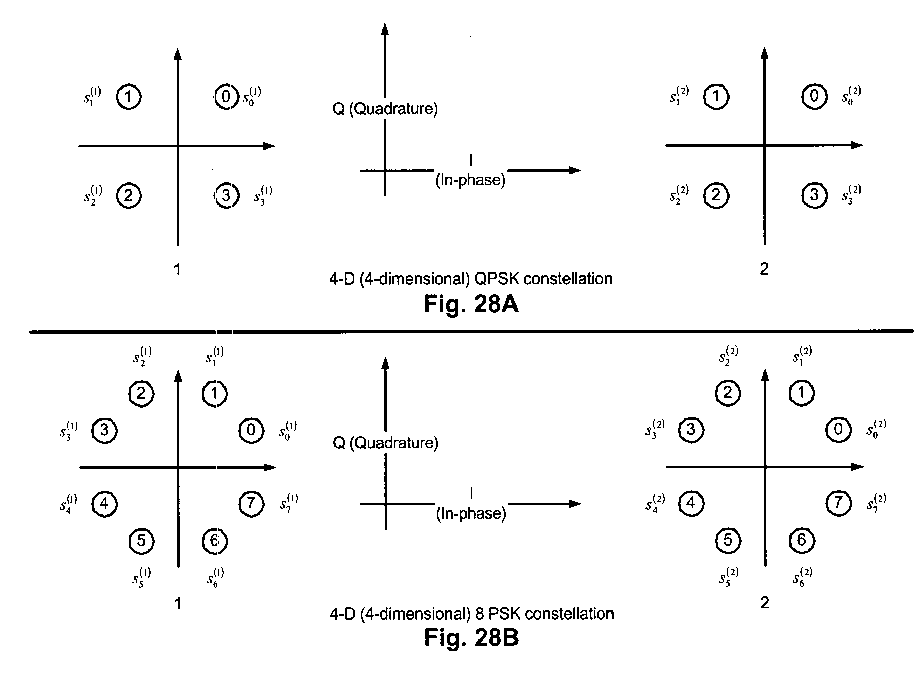

FIG. 28A is a diagram illustrating an embodiment of a 4-D (4-dimensional) QPSK (Quadrature Phase Shift Key) constellation that is constructed according to the invention. This 4-D QPSK constellation embodiment is provided to show the general construction of a 4-D constellation type. The I, Q (In-phase, Quadrature) axes form 2 of the dimensions in a 2-D Euclidean space (I being a first dimension, and Q being a second dimension), which constellation is being referenced (e.g., the QPSK constellation the left or the right hand side of the diagram) is a third dimension, and time is the fourth dimension of the 4-D QPSK constellation. For example, a symbol may be formed to include 4 bits. These 4 bits may be decomposed to form 2 sets of 2 bits each. The first set of 2 bits may correspond to the QPSK constellation on the left hand side of the diagram, and the second set of 2 bits may correspond to the QPSK constellation on the right hand side of the diagram.

Each of the constellation points is indexed. For example, the constellation points on the QPSK constellation on the left hand side of the diagram are indexed as follows: 0 constellation point ($s_0^{(1)}$), 1 constellation point ($s_1^{(1)}$), 2 constellation point ($s_2^{(1)}$), and 3 constellation point ($s_3^{(1)}$). The constellation points on the QPSK constellation on the right hand side of the diagram are indexed as follows: 0 constellation point($s_0^{(2)}$), 1 constellation point ($s_1^{(2)}$), 2 constellation point ($s_2^{(2)}$), and 3 constellation point ($s_3^{(2)}$). The superscript indicates to which constellation the set of bits corresponds, and the subscript indicates which constellation point within that particular constellation. This example shows a very generic manner by which constellation shape may be extended to be support multi-dimensional phase modulation coding. This diagram is provided to show the generic applicability of multi-dimensional phase modulation and the adaptability of it to a variety of constellation shapes. Many of the examples provided below are illustrated using a 4-D 8 PSK, but it is noted that the multi-dimensional aspects of the invention may be extended to a wide variety of constellation shapes.

FIG. 28B is a diagram illustrating an embodiment of a 4-D (4-dimensional) 8 PSK (8 Phase Shift Key) constellation that is constructed according to the invention. An 8 PSK modulation is shown to have 8 2-D signals in a 2-D Euclidean space. Any such signal may be represented as a 3-tuple binary symbol (e.g., 3 bit symbols). Then, in order to represent a 6 bit symbol using this 8 PSK modulation scheme, 2 consecutive 8 PSK constellation signals are needed. These 2 consecutive 8 PSK cont signals become a 4-D signal. Therefore, this entire modulation scheme is in fact a 4-D modulation scheme.

Each of the constellation points of these 2 8 PSK constellation is indexed. For example, the constellation points on the 8 PSK constellation on the left hand side of the diagram are indexed as follows: 0 constellation point ($s_0^{(1)}$), constellation point ($s_1^{(1)}$), 2 constellation point ($s_2^{(1)}$), 3 constellation point ($s_3^{(1)}$), 4 constellation point ($s_4^{(1)}$), 5 constellation point ($s_5^{(1)}$), 6 constellation point ($s_6^{(1)}$), and 7 constellation point ($s_7^{(1)}$). The constellation points on the 8 PSK constellation on the right hand side of the diagram are indexed as follows: 0 constellation point ($s_0^{(2)}$), 1 constellation point ($s_1^{(2)}$), 2 constellation point ($s_2^{(2)}$), 3 constellation point ($s_3^{(2)}$), 4 constellation point ($s_4^{(2)}$), 5 constellation point ($s_5^{(2)}$), 6 constellation point ($s_6^{(2)}$), and 7 constellation point ($s_7^{(2)}$),. As with the embodiment described above, the superscript indicates to which constellation the set of bits corresponds, and the subscript indicates which constellation point within that particular constellation. This example shows a very generic manner by which constellation shape may be extended to be support multi-dimensional phase modulation coding.

The constellation signals of 2 8 PSK constellation sets are provided as follows:

$$S_0^{(v)}, S_1^{(v)}, S_2^{(v)}, S_3^{(v)}, S_4^{(v)}, S_5^{(v)}, S_6^{(v)}, S_7^{(v)},$$

where $v =1,2$ .

Adjacent signals may be represented as being separated by 1 in the subscript notation. For example, $S_j^{(v)}$ is adjacent to $S_{j+1}^{(v)}$, where $(i)_8 = i \bmod(8)$. In addition, it is noted that the 4-D 8 PSK constellation set shown within the FIG. 28B may be viewed as having 64 points that may be denoted as follows:

$$\left(S_i^{(1)}, S_j^{(2)}\right),$$

where $i, j \in \{0,1,2,...,7\}$. Every point

$$\left(S_i^{(1)}, S_j^{(2)}\right)$$

( has 4 adjacent points which may be denoted as follows:

$$\left(S_{(i-1)_8}^{(1)}, S_j^{(2)}\right), \left(S_{(i+1)_8}^{(1)}, S_j^{(2)}\right), \left(S_i^{(1)}, S_{(j-1)_8}^{(2)}\right), \left(S_i^{(1)}, S_{(j+1)_8}^{(2)}\right).$$

In fact, it is also noted that these 4 points are the only points that have a minimum Euclidean distance to

$$\left(S_i^{(1)}, S_j^{(2)}\right)$$

in the 4-D Euclidean space. From certain perspectives, this 64 4-D 8 PSK constellation set may be viewed as being a 64 QAM (64 Quadrature Amplitude Modulation) constellation set with top and bottom edges that are connected as well as left and right edges.

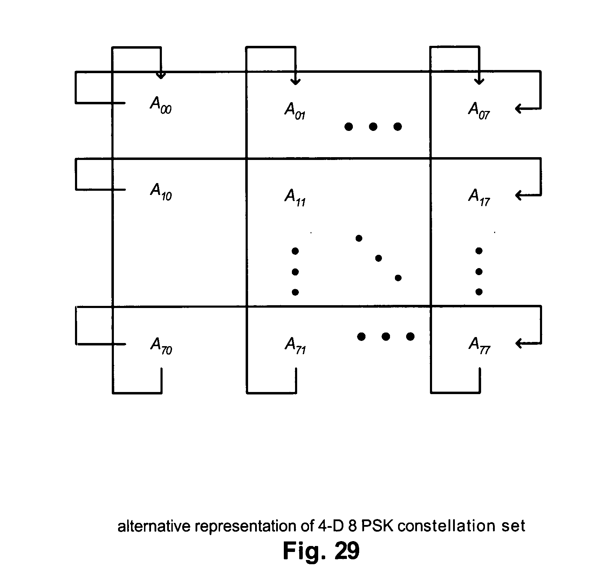

FIG. 29 is a diagram illustrating an alternative representation of the 4-D 8 PSK constellation, shown within FIG. 28B, that is constructed according to the invention. For example, the top edge of the constellation point, $A_{00}$, is connected to the bottom edge of the constellation point, $A_{70}$. Similarly, the top edge of the constellation point, $A_{01}$, is connected to the bottom edge of the constellation point, $A_{71}$. Analogously, the left edge of the constellation point, $A_{00}$, is connected to the right edge of the constellation point, $A_{07}$, and the left edge of the constellation point, $A_{10}$, is connected to the bottom edge of the constellation point, $A_{17}$. Also, any of the constellation points may be represented using the convention introduced above as shown below:

$$A_{i,j} = \left(S_i^{(1)}, S_j^{(2)}\right)$$

In general, a $2m$-D ($2m$-dimensional) $M$ PSK modulation scheme (where $m$ and $M$ are integers) with its constellation signals in a $2m$-D Euclidean space may be constructed using the principles presented herein. In addition, a $2m$-D modulation signal may be denoted as follows:

$A_{s_1,...,s_m}$, where $0 \leq s_l \leq M$ -1 and $0 \leq l \leq m$. The signal, $A_{s_l,...,s_m}$, has $2m$ adjacent signals which are shown as follows: $A_{s_l,...,(s_k-1)_M,...,s_m}$, and $A_{s_1,...,(s_k+1)_M,...,s_m}$, where $k = 1,...,m$.

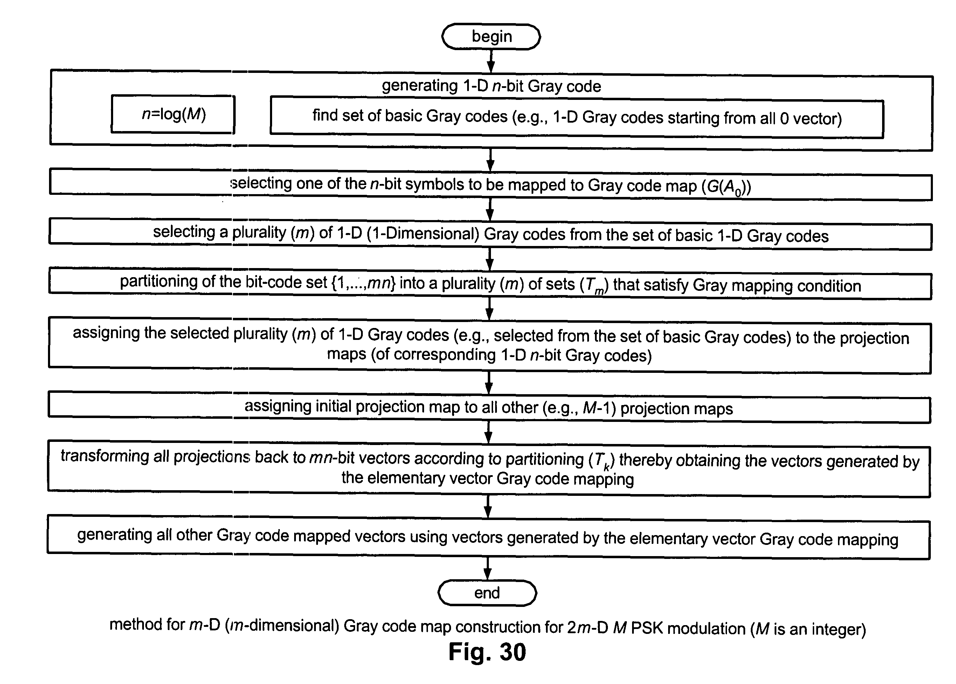

A great deal of description is provided below showing a manner in which a Gray code map may be constructed to support LDPC coded modulation signals that to be mapped using multi-dimensional space Gray code maps. A more compressed description is provided with respect to FIG. 30 as well, but a more thorough description of how to construct Gray code maps to support LDPC coded modulation multi-dimensional space Gray code mapped signals is presented here.

One approach by which a symbol having $mn$ bits (e.g., an $mn$-tuple binary symbol having $mn$ bits) may be mapped to a $2m$-D modulation scheme having $2^n$ constellations signals is, first, to separate the binary symbol into $n$-bit symbols and then independently map the $m$ symbols to $m$ distinct constellation signals. As mentioned above, this approach has already been presented with respect to TCM (Trellis Coded Modulation) by Pietrobon et al. (S. S. Pietrobon, R. H. Deng A. Lafanechere, G. Ungerboeck and D. J. Costello, Jr., "Trellis-Coded Multidimensional phase modulation," *IEEE Trans. Inform. Theory,* Vol. 36, pp. 63-89, Jan. 1990). Pietrobon et al. introduced joint mapping for multi-D modulation based on Euclidean distance. However, for coded modulation employing block codes, this kind of mapping does not work very well to provide for good performance.

However, as shown above with respect to variable signal mapping LDPC coded modulation systems, 1-D Gray code mappings work very well to provide for an improved performance over conventional LDPC coding systems.

However, certain aspects of the invention are operable to extend and to generalize the principles from 1-D Gray code maps to $m$-D (multi-dimensional) Gray code maps.

An $n$-bit Gray code is a scheme for listing all $n$-bit vectors such that successive elements that differ in exactly one bit as presented in W. H. Press, S. A. Teukolsky, W. T. Vetterling and B. P. Flannery, "Chapter 20," *Numerical Recipes in C, The art of scientific computing,* Cambridge University, 1992. That is to say, the Hamming distance, $d_H$, of the two adjacent elements is one. A cycle Gray code is a Gray code such that the first element and the last element also differ in one bit. An example ordered sequence of symbols is provided as follows:

$A_0,...,A_{N-1}$, where $N = 2^n$. One example of which would be where all 8 PSK signals with $N = 8$.

A cycle Gray code map $G$ to this sequence is a map from these $N$ elements to all $n$-bit vectors such that the mapped sequence, $G(A_0),...,G(A_{N-1})$, is a cycle Gray code. Therefore, for any $i \in \{0,...,N-1\}$, then the Hamming distance, $d_H$, of the two adjacent elements of the mapped sequence is as follows:

$$d_H\left(G\left(A_i\right), G\left(A_{(i-1)_N}\right)\right) = d_H\left(G\left(A_i\right), G\left(A_{(i+1)_N}\right)\right) = 1 \qquad \text{(EQ 6)}$$

where $(i)_N = i(\text{mod } N)$.

Since the ordered sequence of symbols, $A_0,...,A_{N-1}$, may be considered as a 1-D sequence, this particular cycle Gray code map may be referred to as a cycle Gray code map. In the remaining discussion, the focus is on cycle Gray code maps, so the term "cycle" is omitted, since all of the Gray code maps of interest are in fact cycle Gray code maps. An $m$-D sequence is considered as follows:

$A_{s_1,...,s_m}$, where $0 \leq s_l \leq N - 1$, and $0 \leq l \leq m$, where $N = 2^n$.

**Definition 1**

A map $G : \{A_{s_1,...,s_m}\} \rightarrow \{0,1\}^{mn}$ is an $m$-D ($m$-dimensional) Gray code if:

1. All $2^{mn}$ $mn$-bit vectors $G(A_{i_1,...,i_m})$ are distinct, i.e.,

$$\{G(A_{s_1,....,s_m})| \, 0 \leq s_l \leq N, 1 \leq l \leq m\} = \{0,1\}^{mn},$$

therefore the map in one to one and onto (or bijection).

2. For any $(s_1,...,s_m) \in \{0,...,N-1\}^m$ and any $1 \leq k \leq m$ $d_H$ $(G(A_{s_1,....,s_k,...,s_m}), G(A_{s_1,...,(s_k-1)_N,...,s_m})) = d_H$ $(G(A_{s_1,...,s_k,...,s_m}), G(A_{s_1,...,(s_k+1)_N,...,s_m})) = 1$.

To present the necessary and sufficient condition of an $m$-D Gray code map, some additional concept and notations are provided below.

1. *Partition:* consider a set of $M$ elements $B = \{B_1,..., B_M\}$. A set of its subsets, $\{T_1,...,T_k\}$, is called a partition of the set of $M$ elements $B$ if

$$\bigcup_{i=1}^{k} T_i = B$$

and $T_i \cap T_j = \emptyset$ if $i \neq j$.

2. *Projection:* let $U = u_1,...,u_L$ be a subset of $\{1,...,K\}$ with $L \leq K$. A *projection* $P$ of a $K$-bit vector $v = (v_1,...,v_k)$ onto L-dimensional binary space with respect to $U$ is defined by $P(v, U) = (v_{u_1},..., v_{u_L})$.

3. N-adic integer ring: let $Z_N = \{0,1,...,N-1\}$ be a $N$-adic integer ring with addition, subtraction, and multiplication all carried out under $\text{mod}(N)$. Consider an $m$-D space, $Z_N^m$. An elementary vector may be defined as, $E_i = (0,...,0,1,0,...,0)$, with 1 in the position $i$ and $0 \leq i \leq m$. Then for any integer $\mu \in Z_N$

$$\mu E_i = (0,...,0,\mu,0,...,0) \qquad \text{(EQ 7)}$$

Moreover, every element $(s_1,...,s_m) \in Z_N^m$ can be represented as follows:

$$\left(s_1,\ldots,s_m\right) = \sum_{i=1}^{m} s_i E_i \qquad\qquad \text{(EQ 8)}$$

The following theorem may be employed subsequently to allow the generation of the Gray code maps that may be employed when generating LDPC coded modulation signals that to be mapped using those multi-dimensional space Gray code maps.

**Theorem 1** Let $G$ be a map of $A_{s_1,\ldots,s_m}$, $s_l \in \{0,\ldots,2^n - 1\}$ to an $n$-bit vector. $G$ is an $m$-D Gray code map if and only if there exists a partition of the set $\{1,2,\ldots, nm\}$ into $m$ sets, $T_1\ldots,T_m$, with $|T_1| =|T_2| =\ldots = |T_m| = n$ such that for any $k \in \{1,\ldots,m\}$

$$P(G(A_0),T_k),\ P(G(A_{E_k}),T_k),\ P(G(A_{2E_k}),T_k),\ldots,\ P(G(A_{(2^n-1E_k)}),T_k), \qquad \text{(EQ 9)}$$

is a 2-D $n$-bit Gray code, where $A_0 = A_{0,\ldots,0}$ ; and if $j \neq k$

$$P(G(A_0),T_j) = P(G(A_{E_k}),\ T_j) =\ldots = P(G(A_{(2^n-1)E_k}),\ T_j), \qquad \text{(EQ 10)}$$

moreover, for any $(s_1,\ldots,s_m) \in Z_{2^n}^{m}$

$$G\left(A_{s_1,\ldots,s_m}\right) = \left(\frac{1+(-1)^m}{2}\right)G(A_0) + \sum_{k=1}^{m} G\left(A_{s_k E_k}\right) \qquad \text{(EQ 11)}$$

That is to say, the Gray code map, $G(A_{s_1,\ldots,s_m})$, may be generated by using the map of the zero vector, $G(A_0)$, and the sums of the maps of the elementary vector, $G(A_{s_k E_k})$.

The proof of the **Theorem 1** is supplied here. In the following, N may be denoted as $2^n$ (e.g., $N = 2^n$).

A sufficient condition is as follows: if $G$ satisfies the condition given in the theorem then

1. It is assumed that there exist two distinct vectors, $(s_1,\ldots,s_m),(t_1,\ldots,t_m) \in Z_N^m$, with $s_j \neq t_j$ for some $j$, such that $G(A_{s_1,\ldots,s_m})= G(A_{t_1,\ldots,t_m})$. Then by EQ 11 shown above, the following relationship may be made.

$$\sum_{i=1}^{m} G\left(A_{s_i E_i}\right) = \sum_{i=1}^{m} G\left(A_{t_i E_i}\right)$$

This relationship then implies the following:

$$\sum_{i=1}^{m} P\left(G\left(A_{s_k E_k}\right),T_k\right) = \sum_{i=1}^{m} P\left(G\left(\left(A_{t_i E_i}\right),T_k\right)\right), \text{ for } k \in \{1,\ldots,m\} \qquad \text{(EQ 12)}$$

On the other hand, by EQ 12 above,

$$P(G(A_{s_k E_k}),\ T_j) = P(G(A_{t_k E_k}),\ T_j) \text{ if } k \neq j$$

Thus, EQ 12 becomes the following:

$$P(G(A_{s_j E_j}),T_j) = P(G(A_{t_j E_j}),\ T_j). \qquad \text{(EQ 13)}$$

Since $s_j \neq t_j$, then EQ 14 contradicts the condition of EQ 9 which states that $P(G(A_{s_j E_j}),T_j)$ and $P(G(A_{t_j E_j}),T_j)$ are two distinct elements in a 1 -D $n$-bit Gray code. This proves the following

relationship:

$$G(A_{s_1,\dots,s_m}) \neq G(A_{t_1,\dots,t_m}) \text{ if } (s_1,\dots,s_m) \neq (t_1,\dots,t_m).$$

2. Let $(s_1,\dots,s_m) \in Z_N^m$ and $1 \leq k \leq m$. With EQ 11 the following relationship is provided.

$$G(A_{s_1,\dots,s_k,\dots,s_m}) + G(A_{s_k E_k}) = G(A_{s_1,\dots,(s_k-1)_N,\dots,s_m}) + G(A_{(s_k-1)_N E_k}).$$

Thus

$$d_H(G(A_{s_1,\dots,s_k,\dots,s_m}), G(A_{s_1,\dots,(s_k-1)_n,\dots,s_m})) = d_H(G(A_{s_k E_k}), G(A_{(s_k-1)_N E_k})) \qquad \text{(EQ 14)}$$

Substituting EQ 10 to this EQ 14, then the following relationship can be made:

$$d_H(G(A_{s_1,\dots,s_k,\dots,s_m}), G(A_{s_1,\dots,(s_k-1)_n,\dots,s_m})) = d_H(P(G(A_{s_k E_k}), T_k), P(G(A_{(s_k-1)_N E_k}), T_k)) = 1 \qquad \text{(EQ 15)}$$

since $P(G(A_{s_k E_k}), T_k)$, $P(G(A_{(s_k-1)_M} E_k), T_k)$ are two adjacent elements in the 1-D Gray code. Similarly, it may also be proven that:

$$d_H(G(A_{s_1,\dots,s_k,\dots,s_m}), G(A_{s_1,\dots,(s_k+1)_n,\dots,s_m})) = 1 \qquad \text{(EQ 16)}$$

The conclusions provided above with respect to 1. and 2. prove that $G$ is an $m$-D Gray code map.
A necessary condition is also described as follows:
Suppose that $G$ is an $m$-D Gray code map. Then, for any $k \in \{1,\dots, m\}$ the adjacent elements of $G(A_0)$, $G(A_{E_k}),\dots, G(A_{(N-1)E_k})$ differ in exactly one bit. A $mn$-bit elementary vector may be defined as follows:

$$e_i = (0, \dots, 0, 1, 0, \dots, 0) \qquad \text{(EQ 17)}$$

where 1 is in the position $k \in \{1,\dots, mn\}$. Then, for any $k \in \{1,\dots, m\}$ there exists $N$-1 elementary vectors, $e_{i_1}^{(k)},\dots,$

$e_{i_{N-1}}^{(k)}$, such that

$$G\left(A_{s_k E_k}\right) = G(A_0) + \sum_{l=1}^{s} e_{i_l}^{(k)}, \text{ where } s \in Z_N /\{0\} \qquad \text{(EQ 18)}$$

where $A_0 = A_{0,\dots,0}$. All of the binary zero vectors may be defined as $e_{i_0}^{(k)} = (0,\dots,0)$ for any $k$. EQ 18 now may be expressed as follows:

$$G\left(A_{s_k E_k}\right) = G(A_0) + \sum_{l=0}^{s} e_{i_l}^{(k)}, \text{ where } s \in Z_N \qquad \text{(EQ 19)}$$

It may now be asserted that for any $(s_1,\dots,s_m) \in Z_N^m$, the following relationship holds true:

$$G\left(A_{s_1,\dots,s_m}\right) = G(A_0) + \sum_{k=1}^{m}\left(\sum_{l=0}^{s_k} e_{i_l}^{(k)}\right) \qquad \text{(EQ 20)}$$

This assertion may be proven using induction as described below:

1. when $(s_1,...,s_m) = sE_k$, then EQ 19 implies EQ 20.
2. consider a vector, $(s_1,...,s_m) \in Z_N^m$, with at least two non-zero components. Without loss of generality, it is supposed that $s_1 \neq 0$ and $s_2 \neq 0$.

2.1 it is assumed that EQ 20 is true for $G(A_{t_1,s_2,...,s_m})$ and $G(A_{s_1,t_2,...,s_m})$ with any $t_1 < s_1$ and any $t_2 < s_2$.

2.2 using the assumption provided above within 2.1, then the following relationships may be made:

$$G(A_{s_1-1,s_2,...,s_m}) = G(A_0) + \sum_{l=0}^{s_1-1} e_{i_l}^{(1)} + \sum_{l=0}^{s_2} e_{i_l}^{(2)} + \sum_{k=3}^{m}\left(\sum_{l=0}^{s_k} e_{i_l}^{(k)}\right) \qquad (EQ\ 21)$$

$$G(A_{s_1,s_2-1,...,s_m}) = G(A_0) + \sum_{l=0}^{s_1} e_{i_l}^{(1)} + \sum_{l=0}^{s_2-1} e_{i_l}^{(2)} + \sum_{k=3}^{m}\left(\sum_{l=0}^{s_k} e_{i_l}^{(k)}\right) \qquad (EQ\ 22)$$

However, since $G(A_{s_l-1,s_2,...,s_m}) \neq G(A_{s_1,s_2-1,...,s_m})$, then EQ 21 and EQ 22 imply the following:

$$e_{i_{s_1}}^{(1)} \neq e_{i_{s_2}}^{(2)} \qquad (EQ\ 23)$$

Since $A_{s_1-1,s_2,...,s_m}$ and $A_{s_1,s_2,...,s_m}$ are adjacent as well as $A_{s_1,s_2-1,...,s_m}$ and $A_{s_1,s_2,...,s_m}$, there exist two elementary vectors, $e_a$ and $e_b$ such that

$$G(A_{s_1-1,s_2,...,s_m}) + e_a = G(A_{s_1,s_2,...,s_m}) = G(A_{s_1,s_2-1,...,s_m}) + e_b \qquad (EQ\ 24)$$

Thus, $e_{i_{s_1}}^{(1)} + e_b = i_{s_2}^{(2)} + e_a$, and by using EQ 21 and EQ 22 as well as EQ 24, this induces the following: $e_a \neq e_b$ (per EQ 23).

Therefore, the following relationship is supported:

either $e_{i_{s_1}}^{(1)} = e_a$ or $i_{s_2}^{(2)} = e_a$

If it is assumed that $e_{i_{s_2}}^{(2)} = e_a$, then by EQ 24 and by the assumption provide above with respect to 2.1, then the following relationship may be made:

$$G(A_{s_1,...,s_m}) = G(A_{s_1-1,s_2,...,s_m}) + e_{i_{s_2}}^{(2)} = G(A_0) + \sum_{l=0}^{s_1-1} e_{i_l}^{(1)} + \sum_{l=0}^{s_2-1} e_{i_l}^{(2)} + \sum_{k=3}^{m}\left(\sum_{l=0}^{s_k} e_{i_l}^{(k)}\right)$$

$$G(A_{s_1,...,s_m}) = G(A_{s_1-1,s_2-1,...,s_m})$$

(EQ 22)

This relationship, however, contradicts the definition of an $m$-D Gray code map. Thus, $e_{i_{s_1}}^{(1)} = e_a$ This conclusion may be combined with the conclusions of EQ 21 and EQ 24 to provide the following relationship:

$$G\left(A_{s_1,s_2,\ldots,s_m}\right)=G\left(A_{s_1,s_2-1,\ldots,s_m}\right)+e_{i_{s_1}}^{(1)}=G(A_0)+\sum_{k=1}^{m}\left(\sum_{l=0}^{s_k}e_{i_l}^{(k)}\right) \qquad \text{(EQ 26)}$$

This is the end of the induction proof.

If EQ 19 is substituted into EQ 20, then the following relationship may be provided:

$$G\left(A_{s_1,s_2,\ldots,s_m}\right)=\left(\frac{1+(-1)^m}{2}\right)G(A_0)+\sum_{i=1}^{m}G\left(A_{s_iE_i}\right)$$

which provides the final part of the necessary condition described above.

To prove the first two parts of the necessary condition, the following two sets of elementary vectors may be considered:

$\{e_{i_t}^{(j)},\ldots,e_{i_{N-1}}^{(j)}\}$ and $\{e_{i_1}^{(k)},\ldots,e_{i_{N-1}}^{(k)}\}$ with $j \neq k$. If there exists $s,t \in Z_N/\{0\}$ such that $e_{i_s}^{(j)} = e_{i_t}^{(j)}$ then by EQ 20, the following relationship may be made:

$$G\left(A_{sE_j+tE_k}\right)=G(A_0)+\sum_{l=0}^{s}e_{i_l}^{(j)}+\sum_{l=0}^{t}e_{i_l}^{(k)}=$$

$$G(A_0)+\sum_{l=0}^{s-1}e_{i_l}^{(j)}+\sum_{l=0}^{t-1}e_{i_l}^{(k)}=G\left(A_{(s-1)E_j+(t-1)E_k}\right) \qquad \text{(EQ 27)}$$

However, this relationship also contradicts the definition of an *m*-D Gray code map. Thus,

$$\{e_{i_1}^{(j)},\ldots,e_{i_{N-1}}^{(j)}\}\cap\{e_{i_l}^{(k)},\ldots,e_{i_{N-1}}^{(k)}\}=\emptyset \text{ , when } j \neq k \qquad \text{(EQ 28)}$$

Therefore, the *m* sets, $\{e_{i_1}^{(k)},\ldots,e_{i_{N-1}}^{(k)}\}$, where $l =1,\ldots,m$ are mutual disjoint.

Although every set, $\{e_{i_1}^{(k)},\ldots,e_{i_{N-1}}^{(k)}\}$, has *N*-1 elementary vectors, these *N*-1 elementary vectors may not be distinct. When $n = (N -1=1)$, the set of elementary vectors only has $n = 1$ element. When considering the situation where $n > 1$, it may then be assumed that among *m* mutual disjoint elementary vector sets, there is a set having more than *n* distinct elements. Then there is another set, e.g., $\{e_{i_1}^{(j)},\ldots,e_{i_{N-1}}^{(j)}\}$, which has at most *n*-1 distinct elements since there are a total of *nm* distinct elementary vectors.

Thus, the $2^n$ -1 vectors,

$$e_{i_l}^{(j)}, \ \sum_{l=1}^{2}e_{i_l}^{(j)},\ldots,\sum_{l=1}^{N-1}e_{i_l}^{(j)}$$

(which are in a subspace generated by those *n*-1 distinct elementary vectors) has at most $2^{n-1} < 2^n$ -1 < *N*-1 distinct vectors. Therefore, there are at least two vectors among $e_{i_t}^{(j)}$,

$$\sum_{l=1}^{2}e_{i_l}^{(j)},\ldots,\sum_{l=1}^{N-1}e_{i_l}^{(j)}$$

that are equal.

This conclusion, along with the relationship provided with respect to EQ 19, implies that there are two equal vectors among the following:

$$G\left(A_{E_j}\right),\ldots,G\left(A_{(N-1)E_j}\right).$$

However, this relationship also contradicts the definition of an *m*-D Gray code map. Therefore, every set, $\{e_{i_1}^{(k)},\ldots,e_{i_{N-1}}^{(k)}\}$, has exactly *n* distinct elements. This set of distinct elementary vectors may be denoted as $V_k$. The following relationship may then be made:

$$\bigcup_{k=1}^{m} V_k = \{e_1, e_2, \ldots, e_{mn}\}, \text{ and } V_k \cap V_j = \emptyset, \text{ if } j \neq k \qquad \text{(EQ 29)}$$

Moreover, the sum of the following elementary vectors,

$$\sum_{l=0}^{s} e_{i_l}^{(k)},$$

is in the space $\langle V_k \rangle$ (a binary subspace by $V_k$) and

$$\bigcup_{k=1}^{m} \langle V_k \rangle = \{0,1\}^{mn}, \text{ and } \langle V_j \rangle \cap \langle V_k \rangle = \{0\}, \text{ if } j \neq k \qquad \text{(EQ 30)}$$

The set of distinct elementary vectors, $V_k$, may be denoted as follows: $V_k = \{e_{i_{k,l}}, \ldots, e_{i_{k,n}}\}$ and $T_k = \{i_{k,1}, \ldots, i_{k,n}\}$. Then, by EQ 29, $T_1, \ldots, T_m$ is a partition of the set $\{1, 2, \ldots, mn\}$ with $|T_k| = n$. Moreover, since

$$P\left(G\left(A_{sE_k}\right), T_j\right) = P\left(G(A_0) + \sum_{l=0}^{s} e_{i_l}^{(k)}, T_j\right) \in \langle V_j \rangle$$

and

$$\sum_{l=0}^{s} e_{i_l}^{(k)} \in \langle V_k \rangle,$$

then the following relationship may be made:

$$P\left(G\left(A_{sE_k}\right), T_j\right) = P\left(G(A_0), T_j\right), \text{ if } j \neq k. \qquad \text{(EQ 31)}$$

This proves the part 2. of the proof provided for the sufficient condition of **Theorem 1** shown above.
In addition, EQ 31 also implies that the nm-tuple binary vectors

$$G(A_0), G\left(A_{E_k}\right), \ldots, G\left(A_{(N-1)E}\right)$$

have the same values at position,

$$\bigcup_{j \neq k} T_j \; .$$

With the conclusion and the fact that

$$d_H\left(G\!\left(A_{sE_k}\right), G\!\left(A_{(s+1)_N E_k}\right)\right) = 1$$

for $s \in Z_N$ given by the definition of $m$-D Gray code maps, it may then be concluded that the following is in fact a 1-D $n$-bit Gray code map.

$$P\!\left(G(A_0), T_k\right), P\!\left(G\!\left(A_{E_k}\right), T_k\right), P\!\left(G\!\left(A_{2E_k}\right), T_k\right), \ldots, P\!\left(G\!\left(A_{(M-1)E_k}\right), T_k\right)$$

This proves the part 1. of the proof provided for the sufficient condition of **Theorem 1** shown above.

It is also noted that the **Theorem 1** provided above may be implemented to present a method to generate all of the possible $m$-D Gray code maps for any $2m$-D M PSK modulation. This is illustrated and described below with respect to the following diagram.

FIG. 30 is a flowchart illustrating an embodiment of a method for $m$-D $(m$-dimensional) Gray code map construction for $2m$-D $M$ PSK modulation (where $m$ and $M$ are integers) according to the invention. The method initially involves generating a 1-D $n$-bit Gray code. This may be performed using any of a variety of means, including that which is described within W. H. Press, S. A. Teukolsky, W. T. Vetterling and B. P. Flannery, "Chapter 20," *Numerical Recipes in C, The art of scientific computing,* Cambridge University, 1992. Regardless of the manner in which the 1-D $n$-bit Gray code is generated, the number of bits within the Gray code (e.g., $n$) meets the following relationship.

$n = \log_2 (M)$, logarithm of $M$ using log base 2. In other words, $n$ is equal to the base 2 logarithm of $M$.

From a plurality of available 1-D $n$-bit Gray codes, one of the 1-D $n$-bit Gray codes may be found such that it starts from the 0 valued vector. Gray codes meeting this condition may be referred to as basic Gray codes.

The method then continues by selecting a given $n$-bit to be mapped according to the mapping of $G(A_0)$; this mapping may be referred to as a cycle Gray code map. The method then continues by selecting a plurality $(m)$ of 1-D Gray codes from the set of basic 1-D Gray codes. The method then involves partitioning of the bit code set $\{1,...,mn\}$ into a plurality $(m)$ of sets $T_1,...,T_m$ that satisfy the Gray code mapping condition (e.g., as described above with respect to **Theorem 1**).

The method then proceeds to assign the selected plurality $(m)$ of basic Gray 1 - D Gray codes to the projection maps (of the corresponding 1-D $n$-bit Gray codes) as indicated in the following :

$$P\!\left(G(A_0), T_k\right), P\!\left(G\!\left(A_{E_k}\right), T_k\right), P\!\left(G\!\left(A_{2E_k}\right), T_k\right), \ldots, P\!\left(G\!\left(A_{(M-1)E_k}\right), T_k\right) \qquad \text{(EQ 32)}$$

where $k=1,...,m$. The initial projection term, $P(G(A_0), T_k)$, may not be the real projection portion of the mapping of $G(A_0)$ if $G(A_0)$ is not an all 0 valued vector. In the instance that the initial projection term, $P(G(A_0), T_k)$, is in fact the real projection portion of the mapping, $G(A_0)$, then the projection vector elements shown above within EQ 32 should each be modified by adding (in binary addition) the real portion of the initial projection term, $P(G(A_0), T_k)$, to every vector therein.

The method then continues by assigning the initial projection, $P(G(A_0), T_j)$, indexed by $j$, to all of the other projection maps (e.g., to all $M$ -1 projection maps). This may be shown mathematically as follows:

$$P(G(A_{E_k}), T_j),..., P(G(A_{(M-1)E_k}), T_j), \text{ for all } j \# k.$$

The method then involves transforming al of the projections back to $mn$-bit vectors according to the partitioning $(T_k)$. In doing this, the vectors generated by the elementary vector Gray code mapping may be generated; that is to say, the vectors, $G(A_{s_kE_k})$, may be generated for $k =1,..., m$ and for $s \in Z_M$ . Then, the method involves generating all of the other Gray code mapped vectors using the vectors generated by the elementary vector Gray code mapping as described with respect to EQ 11.

$$G\!\left(A_{s_1,\ldots,s_m}\right) = \left(\frac{1+(-1)^m}{2}\right)G(A_0) + \sum_{k=1}^{m} G\!\left(A_{s_k E_k}\right) \qquad\text{(EQ 11)}$$

For example, once the vectors, $G(A_{s_k E_k})$, have been generated, and once the mapping of $G(A_0)$ is available, then the remaining Gray code mapped vectors, $G(A_{s1,\ldots,sm})$, may all be generated.

Once the Gray code mapping is provided for use in $m$-D (e.g., multi-dimensional) phase modulation, then it may be applied to LDPC coding to provide for higher performance than is provided by 1-D Gray code mapping. In general, this principle of multi-dimensional Gray code maps, as provided by various aspects of the invention, may be applied to LDPC coding of any code rates. Several following examples are provided wherein a rate 5/6 LDPC code is employed.

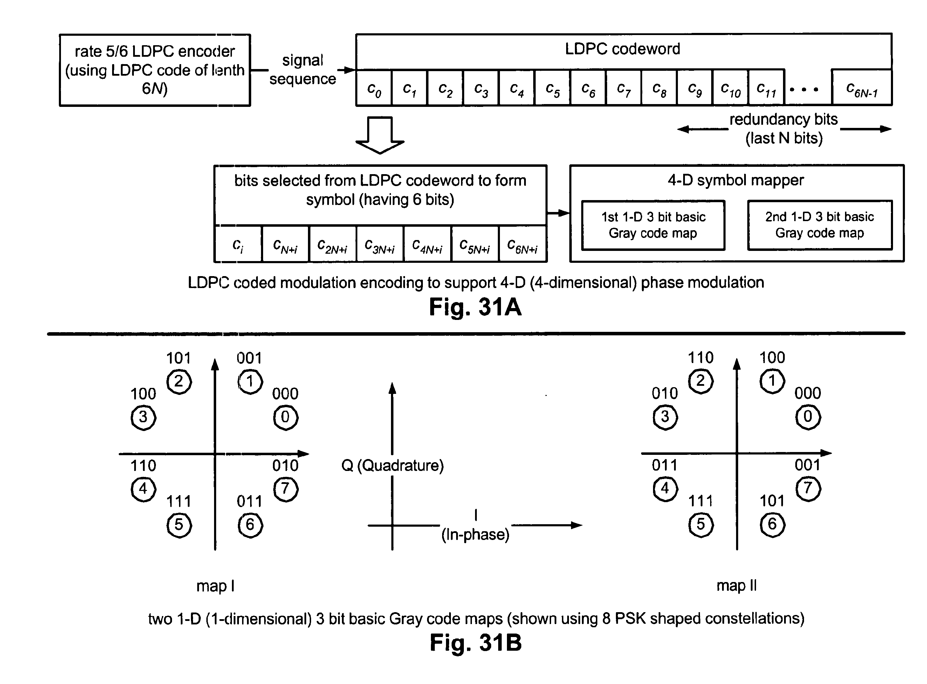

FIG. 31A is a diagram illustrating an embodiment of LDPC coded modulation encoding to support 4-D (4-dimensional) phase modulation according to the invention. as mentioned above, these embodiments employ a rate 5/6 LDPC code. In addition, these embodiments employ a combined 8 PSK coded modulation with the rate 5/6 LDPC code using a 2-D Gray code map. However, again, this approach may be generalized to all other $M$ PSK (where $M$ is an integer) coded modulation with any higher code rate LDPC codes as well without departing from the scope and spirit of the invention.

One approach by which a rate 5/6 LDPC code with an 8 PSK modulation is to group every 3 bits of a codeword together to form 3 bit symbols; these 3 bit symbols are then the appropriate constellation points within a 1-D 3-bit Gray code map. However, as described above with respect to variable signal mapping LDPC coded modulation systems, the use of more than one Gray code map (e.g., the variable signal mapping LDPC coded modulation system of FIG. 18) to map different symbols (e.g., different $n$-bit symbols) based on the bit in the bipartite graph of the LDPC code is yet another way in which this may be done. However, in the instance where the variable signal mapping LDPC coded modulation system operates on 3-bit symbols, then this may present some difficulty to a rate 5/6 LDPC code since this coding approach is uneven; that is to say, some of the 3 bits symbols may contain redundancy information and some may not.

In one approach by which this may be avoided, a new approach is presented such that 6 bits of an LDPC codeword are grouped to form a symbol with one redundancy bit in every symbol. This may be better understood pictorially by viewing FIG. 31A. A rate 5/6 LDPC encoder, using a code of length 6$N$) is employed to generate a signal sequence that include an LDPC codeword shown as having bits, $(c_0, c_1, c_2, \ldots, C_{6N-1})$. The redundancy bits are the last $N$ bits of this codeword. From the LDPC codeword, $(c_0, c_1, c_2, \ldots, c_{6N-1})$, the bits, $c_i, c_{N+1}, c_{2N+i}, c_{3N+i}, c_{4N+i}, c_{5N+i}$, are selected there from to form a symbol having 6 bits. This 6 bit symbol, $c_i, c_{N+1}, c_{2N+i}, c_{3N+i}, c_{4N+i}, c_{5N+i}$, is then mapped according to a 4-D 8 PSK modulation using a 2-D Gray code map. To construct the 2-D Gray code map, the process may begin by identifying two 1-D basic Gray code maps for 8 PSK modulation. Analogously, as described with respect to the method of FIG. 30, the method begins by generating a 1-D $n$-bit Gray code; in this instance, $n$=3.

This approach continues by partitioning the set of 6 bit groups, {1,2,3,4,5,6}, into two sets (e.g., $T_1$ = {1,2,5} and $T_2$ = {3,4,6}) that satisfy the Gray code mapping condition.

FIG. 31B is a diagram illustrating an embodiment of two 1-D (1-dimensional) 3 bit basic Gray code maps (shown using 8 PSK shaped constellation) according to the invention. These 3-bit basic Gray code maps (e.g., map I and map II) satisfy the Gray code mapping condition. The symbol value is shown next to the corresponding constellation points within each of the constellations. For example, the symbol 000=0 is shown next to its corresponding constellation point.

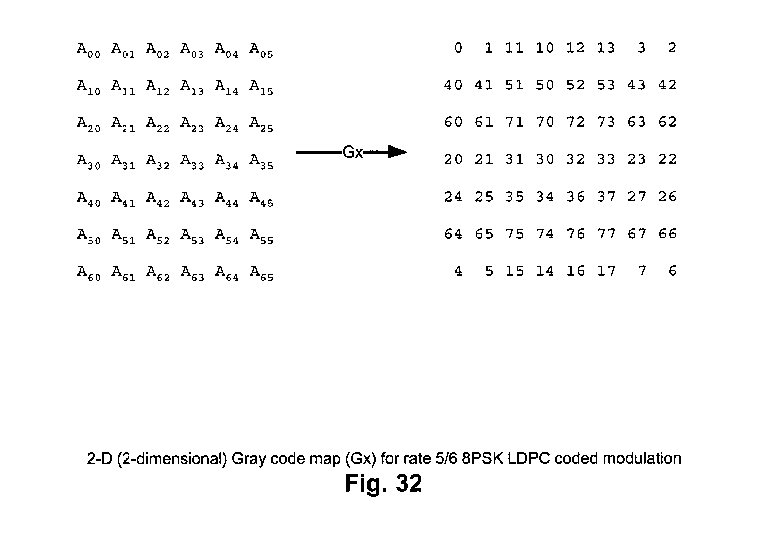

FIG. 32 is a diagram illustrating an embodiment of a 2-D (2-dimensional) Gray code map (Gx) for rate 5/6 8PSK LDPC coded modulation according to the invention. This 2-D Gray code map (Gx) is generated based on the map I and map II of the FIG. 31B. In this embodiment, the values on the left hand side, $A_{i,j}$, are the same as the values,

$A_{i,j} = (S_i^{(1)}, S_j^{(2)})$ (those values having the edge connected together as described with respect to FIG. 29), as described above with respect to 2-d Gray code maps. In this embodiment, however, every 6-bit vector on the right hand side of this diagram is represented by an octal number (e.g., as 2 examples in octal: 33=011011 and 54=101100).

Looking at some specific examples within this 2-D Gray code map (Gx):

6-bit symbol, $A_{0,0}$, is mapped according to Gx to 0=000000 (octal);

6-bit symbol, $A_{0,1}$, is mapped according to Gx to 1=000001 (octal);

6-bit symbol, $A_{0,2}$, is mapped according to Gx to 11=001001 1 (octal);

6-bit symbol, $A_{0,3}$, is mapped according to Gx to 10=001000 (octal); and so on.

As mentioned above with respect to some of the other embodiments, any number of decoding approaches may be employed to decode the LDPC coded modulation decoding of multi-dimensional space Gray code mapped signals. However, there is one additional concern: the bit metric needs to be obtained from the symbol metric obtained.

Looking at the particular embodiment that employs a 4-D 8 PSK modulation using a 2-D Gray code map, the bit metric must be obtained in a 4-D 8 PSK constellation set. Therefore, one hardware modification is that dealing with the symbol metric computation. These computed symbol metrics are then decomposed to bit metrics. With respect to a 2-D Gray code map to a single 8 PSK constellation, 8 symbol metrics need to be computed for a symbol block size of $2N$. However, when using a 2-D Gray code map, then 64 symbol metrics need to be computed for a block of length $N$. While this may appear to be a relatively large increase in computational complexity, it is noted that the symbol metrics need only to be calculated once. Therefore, if the same hardware is used as within any of the other decoding approaches presented above that perform decoding of LDPC coded modulation systems using a 1-D Gray code map, then the latency of computing the bit metrics (which are decomposed from the symbol metrics) in increased. However, as mentioned, this step need only be performed once before the iterative decoding processing continues to decode the signal of interest.

In an alternative embodiment, where such latency in computational processing is undesired, then a small amount of additional hardware may be implemented to carry out these additional computations. It is noted again that this "additional hardware" is in comparison to such a hardware implementation that has been designed originally to perform decoding of LDPC coded modulation systems using a 1-D Gray code map. With the foresight of this type of a system that employs a 2-D Gray code map, a more efficient design may be achieved.

Moreover, with an intelligent selection of the 2-D Gray code map to be employed, the performance improvement provided by such a system (when compared to a system employing a 1-D Gray code map) may be significantly improved. In the following, a comparison of two rate 5/6 8 PSK coded modulation systems with block length 43200 bit LDPC code are presented.

The performances of various decoding approaches of a received symbol block are compared in the following diagram. The following diagram shows the improvement provided by the invention of performing LDPC coded modulation decoding of 2-D space Gray code mapped signals when compared to performing LDPC coded modulation decoding of 1-D space Gray code mapped signals. This performance diagram is described in the context of BER (Bit Error Rate) versus $E_b/N_o$ (ratio of energy per bit $E_b$ to the Spectral Noise Density $N_o$). This term $E_b/N_o$ is the measure of SNR (Signal to Noise Ratio) for a digital communication system. When looking at these performance curves, the BER may be determined for any given $E_b/N_o$ (or SNR) thereby providing a relatively concise representation of the performance of the decoding approach.

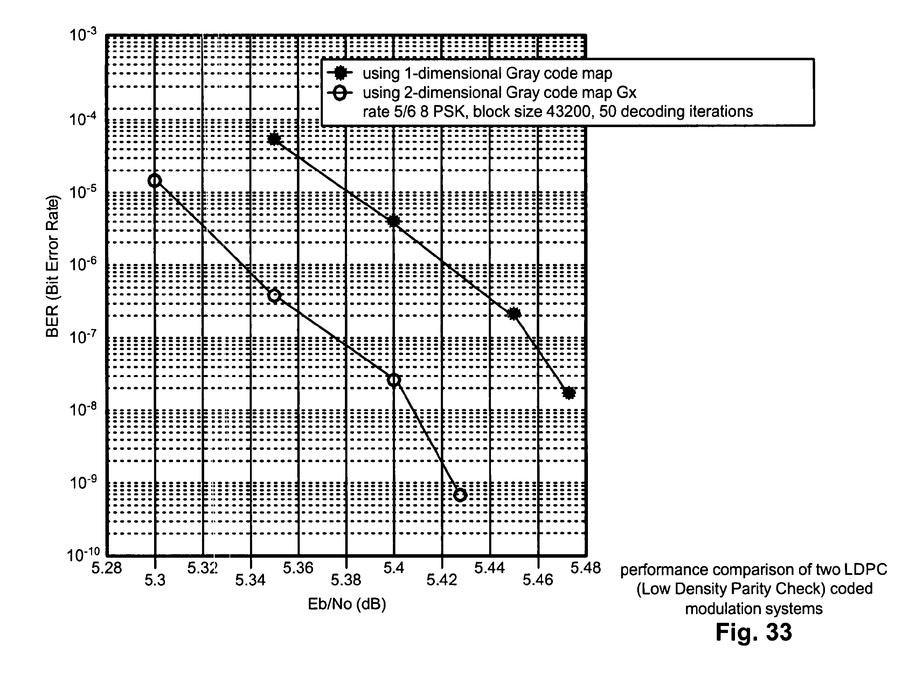

FIG. 33 is a diagram illustrating an embodiment of performance comparison of performance comparison of two LDPC (Low Density Parity Check) coded modulation systems according to the invention. As can be seen within this comparative performance diagram, for a variety of values of $E_b/N_o$ (or SNR), the BER that may be achieved when employing LDPC coded modulation signals that have been mapped using multi-dimensional space Gray code maps. More specifically, the performance improvement provided by using LDPC coded modulation signals that have been mapped using 2-D space Gray code maps when compared to using 1-D space Gray code maps is significant -- typically more than 2 orders of magnitude improved performance.

Two different decoding approaches are compared when decoding LDPC coded modulation signals. Within this comparison, the block size of the LDPC code is 43200, and the signal is a code rate 5/6 8 PSK (8 Phase Shift Key) LDPC coded modulation signal; the decoding processing performs 50 decoding iterations in this illustrative embodiment.

As one example, the worse performing performance curve corresponds to LDPC coded modulation signals that have been mapped using 1-D space Gray code maps; when operating at an $E_b/N_o$ of approximately 5.4 dB (decibels), the BER of the 1-D approach is approximately $4.5 \times 10^{-6}$ .

The better performance curve corresponds to LDPC coded modulation signals that have been mapped using 2-D space Gray code maps; for this decoding approach, when operating at an $E_b/N_o$ of approximately 5.4 dB, the BER of the 2-D approach decreases significantly to approximately $1.25 \times 10^{-8}$.

As can be seen, an improvement of over approximately two orders of magnitude of performance may be achieved when using LDPC coded modulation signals that have been mapped using 2-D space Gray code maps when compared to using 1-D space Gray code maps.

Looking from another perspective, when considering operation of these 2 approaches at a common BER, then the increase of performance, with respect to $E_b/N_o$ (or SNR), provided by the 4-D 8 PSK modulation scheme using a 2-D Gray code map is at least 0.07 dB. Oftentimes, when comparing communication systems, a common BER is selected and it is then determined which system can provide that same BER at the lower $E_b/N_o$ (or SNR). In this case, the 4-D 8 PSK modulation scheme using a 2-D Gray code map provides can operate at a lower $E_b/N_o$ (or SNR) of

approximately 0.07 dB less than the scheme using a 1-D Gray code map while still providing a comparable BER.

Various embodiments have been described herein. For example, a novel encoding approach has been shown that includes combining LDPC encoding and modulation encoding that is operable to generate LDPC variable code rate and/or modulation signals. In addition, a novel decoding approach has also been shown where hybrid decoding processing is employed within the iterative decoding processing of LDPC coded signals.

It is also noted that the methods described within the preceding figures may also be performed within any of the appropriate system and/or apparatus designs (communication systems, communication transmitters, communication receivers, communication transceivers, and/or functionality described therein) that are described above without departing from the scope and spirit of the invention.

In view of the above detailed description of the invention and associated drawings, other modifications and variations will now become apparent. It should also be apparent that such other modifications and variations may be effected without departing from the spirit and scope of the invention.

**Claims**

1. An encoder that is operable to generate an LDPC (Low Density Parity Check) coded modulation signal mapped using a multi-dimensional space Gray code map, the encoder comprising:

   an LDPC encoder that is operable to encode a plurality of information bits and to generate an LDPC codeword having a plurality of codeword bits such that at least one codeword bit is a redundancy bit;

   wherein a predetermined number of codeword bits is selected form the plurality of codeword bits to form an $m$-bit symbol, wherein $m$ is an integer;
   a symbol mapper that maps the $m$-bit symbol according to a $2m$-D ($2m$-dimensional) $M$ PSK modulation using an $m$-D Gray code map, wherein $M$ is an integer; and
   wherein the $2m$-D $M$ PSK modulation is generated using at least two $M$ PSK shaped constellations.

2. The encoder of claim 1, wherein:

   constellation points of a first $M$ PSK shaped constellation of the at least two $M$ PSK shaped constellations are mapped according to a first mapping; and
   constellation points of a second $M$ PSK shaped constellation of the at least two $M$ PSK shaped constellations are mapped according to a second mapping.

3. The encoder of claim 1, wherein:

   $m$ is equal to the base 2 logarithm of $M$.

4. The encoder of claim 1, wherein:

   $m$ is equal to 3; and
   $M$ is equal to 8.

5. The encoder of claim 1, wherein:

   at least one codeword bit of the plurality of codeword bits is a redundancy bit.

6. The encoder of claim 1, wherein:

   the $m$-D Gray code map is partitioned into a plurality of sets that satisfy a Gray mapping condition.

7. The encoder of claim 1, wherein:

   the LDPC coded modulation signal is a variable modulation signal;
   a first symbol of the plurality of symbols is mapped according to a first modulation that includes a first constellation and a corresponding first mapping; and
   a second symbol of the plurality of symbols is mapped according to a second modulation that includes a second constellation and a corresponding second mapping.

8. The encoder of claim 7, wherein:

the first modulation includes an 8 PSK (8 Phase Shift Key) shaped constellation whose constellation points are mapped according to the first mapping; and
the second modulation includes the 8 PSK shaped constellation whose constellation points are mapped according to the second mapping.

9. The encoder of claim 1, wherein:

the LDPC coded modulation signal is a variable code rate signal;
a first symbol of the plurality of symbols is encoded according to a first code rate; and
a second symbol of the plurality of symbols is encoded according to a second code rate.

10. The encoder of claim 1, wherein:

the encoder is implemented within a communication device; and
the communication device is implemented within at least one of a satellite communication system, an HDTV (High Definition Television) communication system, a cellular communication system, a microwave communication system, a point-to-point communication system, a uni-directional communication system, a bi-directional communication system, a one to many communication system, a fiber-optic communication system, a WLAN (Wireless Local Area Network) communication system, and a DSL (Digital Subscriber Line) communication system.

encoding and decoding within various devices may also include processing a variable code rate and/or variable modulation signal

LDPC (Low Density Parity Check) coded modulation encoding with multi-dimensional space Gray code maps

LDPC coded modulation decoding of multi-dimensional space Gray code mapped signals

LDPC coded modulation decoding of multi-dimensional space Gray code mapped signals

satellite dish

satellite

satellite dish

satellite transmitter

encoder

satellite dish

decoder

display

satellite receiver

satellite dish

decoder

display

satellite receiver

satellite communication system

**Fig. 1**

HDTV (High Definition Television) communication system

**Fig. 2**

## Fig. 3A

**base station receiver**

**decoder**

LDPC coded modulation decoding of multi-dimensional space Gray code mapped signals

decoding a variable code rate and/or variable modulation signal

cellular tower

wireless communication channel

local antenna

**mobile transmitter**

**encoder**

LDPC (Low Density Parity Check) coded modulation encoding with multi-dimensional space Gray code maps

encoding a variable code rate and/or variable modulation signal

uni-directional cellular communication system

## Fig. 3B

**base station transmitter**

**encoder**

LDPC (Low Density Parity Check) coded modulation encoding with multi-dimensional space Gray code maps

encoding a variable code rate and/or variable modulation signal

cellular tower

wireless communication channel

local antenna

**mobile receiver**

**decoder**

LDPC coded modulation decoding of multi-dimensional space Gray code mapped signals

decoding a variable code rate and/or variable modulation signal

uni-directional cellular communication system

EP 1 523 099 A1

| mobile transceiver | | base station transceiver |

**encoder**

LDPC (Low Density Parity Check) coded modulation encoding with multi-dimensional space Gray code maps

encoding a variable code rate and/or variable modulation signal

**decoder**

LDPC coded modulation decoding of multi-dimensional space Gray code mapped signals

decoding a variable code rate and/or variable modulation signal

local antenna

wireless communication channel

cellular tower

**decoder**

LDPC coded modulation decoding of multi-dimensional space Gray code mapped signals

decoding a variable code rate and/or variable modulation signal

**encoder**

LDPC (Low Density Parity Check) coded modulation encoding with multi-dimensional space Gray code maps

encoding a variable code rate and/or variable modulation signal

bi-directional cellular communication system

# Fig. 4

| microwave transmitter |
| --- |
| **encoder** |
| LDPC (Low Density Parity Check) coded modulation encoding with multi-dimensional space Gray code maps |
| encoding a variable code rate and/or variable modulation signal |

microwave tower

wireless communication channel

→

microwave tower

| microwave receiver |
| --- |
| **decoder** |
| LDPC coded modulation decoding of multi-dimensional space Gray code mapped signals |
| decoding a variable code rate and/or variable modulation signal |

uni-directional microwave communication system

## Fig. 5

EP 1 523 099 A1

| microwave transceiver | |
| --- | --- |
| **encoder** | |
| LDPC (Low Density Parity Check) coded modulation encoding with multi-dimensional space Gray code maps | |
| encoding a variable code rate and/or variable modulation signal | |

| **decoder** | |
| LDPC coded modulation decoding of multi-dimensional space Gray code mapped signals | |
| decoding a variable code rate and/or variable modulation signal | |

microwave tower

wireless communication channel

microwave tower

| microwave transceiver | |
| --- | --- |
| **decoder** | |
| LDPC coded modulation decoding of multi-dimensional space Gray code mapped signals | |
| decoding a variable code rate and/or variable modulation signal | |

| **encoder** | |
| LDPC (Low Density Parity Check) coded modulation encoding with multi-dimensional space Gray code maps | |
| encoding a variable code rate and/or variable modulation signal | |

bi-directional microwave communication system

# Fig. 6

EP 1 523 099 A1

```
┌─────────────────────────────────────┐              ┌─────────────────────────────────────┐
│        mobile unit transmitter      │              │          mobile unit receiver       │
│  ┌───────────────────────────────┐  │              │  ┌───────────────────────────────┐  │
│  │            encoder            │  │              │  │            decoder            │  │
│  │ ┌───────────────────────────┐ │  │              │  │ ┌───────────────────────────┐ │  │
│  │ │ LDPC (Low Density Parity  │ │  │   wireless   │  │ │ LDPC coded modulation     │ │  │
│  │ │ Check) coded modulation   │ │  │communication │  │ │ decoding of multi-        │ │  │
│  │ │ encoding with multi-      │ │  │   channel    │  │ │ dimensional space Gray    │ │  │
│  │ │ dimensional space Gray    │ │  │              │  │ │ code mapped signals       │ │  │
│  │ │ code maps                 │ │  │              │  │ │                           │ │  │
│  │ │ ┌───────────────────────┐ │ │  │              │  │ │ ┌───────────────────────┐ │ │  │
│  │ │ ┆ encoding a variable   ┆ │ │  │              │  │ │ ┆ decoding a variable   ┆ │ │  │
│  │ │ ┆ code rate and/or      ┆ │ │  │              │  │ │ ┆ code rate and/or      ┆ │ │  │
│  │ │ ┆ variable modulation   ┆ │ │  │              │  │ │ ┆ variable modulation   ┆ │ │  │
│  │ │ ┆ signal                ┆ │ │  │              │  │ │ ┆ signal                ┆ │ │  │
│  │ │ └───────────────────────┘ │ │  │              │  │ │ └───────────────────────┘ │ │  │
│  │ └───────────────────────────┘ │  │              │  │ └───────────────────────────┘ │  │
│  └───────────────────────────────┘  │              │  └───────────────────────────────┘  │
└─────────────────────────────────────┘              └─────────────────────────────────────┘
```

local antenna

local antenna

uni-directional point-to-point radio communication system

## Fig. 7

| mobile unit transceiver |
| --- |
| **encoder** |
| LDPC (Low Density Parity Check) coded modulation encoding with multi-dimensional space Gray code maps |
| encoding a variable code rate and/or variable modulation signal |

| **decoder** |
| --- |
| LDPC coded modulation decoding of multi-dimensional space Gray code mapped signals |
| decoding a variable code rate and/or variable modulation signal |

local antenna

wireless communication channel

local antenna

| mobile unit transceiver |
| --- |
| **decoder** |
| LDPC coded modulation decoding of multi-dimensional space Gray code mapped signals |
| decoding a variable code rate and/or variable modulation signal |

| **encoder** |
| --- |
| LDPC (Low Density Parity Check) coded modulation encoding with multi-dimensional space Gray code maps |
| encoding a variable code rate and/or variable modulation signal |

bi-directional point-to-point radio communication system

## Fig. 8

EP 1 523 099 A1

| transmitter | | receiver |
|---|---|---|

| encoder | decoder |
|---|---|

| LDPC (Low Density Parity Check) coded modulation encoding with multi-dimensional space Gray code maps | LDPC coded modulation decoding of multi-dimensional space Gray code mapped signals |
|---|---|

communication channel

encoding a variable code rate and/or variable modulation signal

decoding a variable code rate and/or variable modulation signal

uni-directional communication system

**Fig. 9**

transceiver

encoder

LDPC (Low Density Parity Check) coded modulation encoding with multi-dimensional space Gray code maps

encoding a variable code rate and/or variable modulation signal

decoder

LDPC coded modulation decoding of multi-dimensional space Gray code mapped signals

decoding a variable code rate and/or variable modulation signal

communication channel

transceiver

decoder

LDPC coded modulation decoding of multi-dimensional space Gray code mapped signals

decoding a variable code rate and/or variable modulation signal

encoder

LDPC (Low Density Parity Check) coded modulation encoding with multi-dimensional space Gray code maps

encoding a variable code rate and/or variable modulation signal

bi-directional communication system

# Fig. 10

transmitter

encoder

LDPC (Low Density Parity Check) coded modulation encoding with multi-dimensional space Gray code maps

encoding a variable code rate and/or variable modulation signal

communication channel

distribution point

receiver 1

decoder

LDPC coded modulation decoding of multi-dimensional space Gray code mapped signals

decoding a variable code rate and/or variable modulation signal

• • •

receiver n

decoder

LDPC coded modulation decoding of multi-dimensional space Gray code mapped signals

decoding a variable code rate and/or variable modulation signal

one to many communication system

## Fig. 11

encoding and decoding within various devices may also include processing a variable code rate and/or variable modulation signal

1 or more WLAN operable devices performs LDPC (Low Density Parity Check) coded modulation encoding with multi-dimensional space Gray code maps

1 or more WLAN operable devices performs LDPC coded modulation decoding of multi-dimensional space Gray code mapped signals

antennae of devices may be integrated into corresponding devices

laptop computer

stationary unit

WANs (Wide Area Networks)

Internet I/F

Internet

television

microwave tower I/F

WLAN (Wireless Local Area Network)

microwave tower

PC

satellite earth station I/F

IEEE 802.11 WLAN

satellite earth station

pen computer

WLAN interactive device

mobile unit

other I/F

other N/W

WLAN (Wireless Local Area Network) communication system

**Fig. 12**

EP 1 523 099 A1

encoding and decoding within various devices
may also include processing a variable code
rate and/or variable modulation signal

1 or more DSL modems performs LDPC (Low
Density Parity Check) coded modulation encoding
with multi-dimensional space Gray code maps and/
or LDPC coded modulation decoding of multi-
dimensional space Gray code mapped signals

CO performs LDPC (Low Density Parity Check) coded
modulation encoding with multi-dimensional space Gray
code maps and/or LDPC coded modulation decoding of
multi-dimensional space Gray code mapped signals

Internet

ISP (Internet
Service
Provider)

CO (Central
Office)

DSL
modem

DSL
modem

DSL
modem

DSL
modem

multiple user
access point or
hub

user device

user device

user device

user device

user device

user devices may include desk-top computers, laptop
computers, servers, and/or hand held devices

DSL (Digital Subscriber Line) communication system

**Fig. 13**

EP 1 523 099 A1

encoding and decoding within various
devices may also include processing
a variable code rate and/or variable
modulation signal

fiber-optic
interfacing

fiber-optic
interfacing

client side

line side

DWDM (Dense Wavelength Division Multiplexing) line card

DWDM transport
processor

transmitter

e/o converter

10G serial
module

encoder

alternatively,
non-fiber-optic
interfacing

decoder

receiver

o/e converter

LDPC coded modulation
decoding of multi-
dimensional space Gray
code mapped signals

LDPC (Low Density Parity Check)
coded modulation encoding with
multi-dimensional space Gray
code maps

fiber-optic communication system

**Fig. 14**

satellite receiver STB (Set Top Box) system

**Fig. 15**

Diagram labels:
- HD video
- audio
- conditional access
- memory
- HDTV MPEG-2 transport demux, audio/video decoder and display engine
- host CPU
- advanced modulation satellite receiver
- decoder
- satellite tuner
- L-band
- I
- Q
- LDPC coded modulation decoding of multi-dimensional space Gray code mapped signals
- decoding may also include processing a variable code rate and/or variable modulation signal

LDPC (Low Density Parity Check) code bipartite graph

**Fig. 16**

EP 1 523 099 A1

bit to m-bit symbol transformation

direct combining of LDPC (Low Density Parity Check) coding and modulation

## Fig. 17A

bit to m-bit symbol transformation

BICM (Bit Interleaved Coded Modulation)

## Fig. 17B

multilevel coded modulation

## Fig. 17C

EP 1 523 099 A1

map I1

map I2

map IN

symbols
satisfying
condition 1

symbols
satisfying
condition 2

symbols
satisfying
condition N

· · ·

· · ·

· · ·

· · ·

may be a variable code
rate and/or variable
modulation signal

signal
sequence

e.g., modulation having 8 PSK
shaped constellation with
different symbol mappings

m-bit symbol

part 1 of codeword

part 2 of codeword

part m of codeword

· · ·

**Fig. 18**

variable signal mapping LDPC (Low Density Parity Check) coded modulation system

53

iterative processing repeated repeated n times or until syndromes equal zero (within certain degree of precision)

LDPC (Low Density Parity Check) coded modulation decoding functionality using bit metric

**Fig. 19**

iterative decoding processing (for iterations 1 to n-1)

edge messages

bit metrics

bit node calculator

update edge messages
with bit metrics and
edge message

check node operator

receive edge messages
from bit nodes and edge
message update

edge messages

iterative decoding processing (for last iteration n)

bit metrics

soft output

compute soft information
of bits using bit metrics
and edge messages

bit node calculator

hard limiter

bit estimates
(based on bit soft
information)

alternative LDPC coded modulation decoding functionality using bit metric (when performing n number of iterations)

**Fig. 20**

EP 1 523 099 A1

EP 1 523 099 A1

iterative processing repeated repeated n times or until
syndromes equal zero (within certain degree of precision)

for bit metric
updating

I,Q values

**m-bit symbol metric computer**

**symbol node calculator**

bit metric update

bit metric calculator (uses symbol metrics)

**bit node calculator**

update edge messages with soft message and edge message

soft output

compute soft information of bits using bit metrics and edge messages

edge messages

**check node operator**

receive edge messages from bit nodes and edge message update

hard limiter

**syndrome calculator**

bit estimates (based on bit soft information)

bit metrics

edge messages

iterative decoding processing

LDPC (Low Density Parity Check) coded modulation decoding functionality using bit metric (with bit metric updating)

## Fig. 21

alternative LDPC coded modulation decoding functionality using bit metric (with bit metric updating)
(when performing n number of iterations)

**Fig. 22**

EP 1 523 099 A1

LDPC (Low Density Parity Check) code bipartite graph

check nodes

edge information

bit nodes

bit metric

I,Q values

m-bit symbol node

bit decoding using bit metric (shown with respect to LDPC code bipartite graph)

**Fig. 23A**

LDPC (Low Density Parity Check) code bipartite graph

check nodes

edge information

bit nodes

bit metric

I,Q values

m-bit symbol node

bit metric updating

bit decoding using bit metric updating (shown with respect to LDPC code bipartite graph)

**Fig. 23B**

check nodes

bit nodes (obviated)

symbol nodes

may also out-perform decoding based on bit bipartite graph with updating bit metrics

also obviates need to update metric (memory savings)

symbol bipartite graph employs symbol metrics instead of bit metrics

LDPC coded modulation bipartite graph (or symbol bipartite graph) with symbol nodes connected directly to check nodes (with labeled edges)

**Fig. 24B**

check nodes

bit nodes

symbol nodes

symbols solely determined by bits connected to symbol

$s_0 \leftrightarrow (b_0, b_3, b_6)$    $s_1 \leftrightarrow (b_1, b_4, b_7)$

$s_2 \leftrightarrow (b_2, b_5, b_8)$    EQ 1

LDPC (Low Density Parity Check) coded modulation tripartite graph (or bit bipartite graph) with symbol nodes connected to bit nodes

**Fig. 24A**

symbol nodes   edge information   check nodes

I,Q values

LDPC coded
modulation
bipartite graph

symbol decoding (shown with respect to LDPC (Low Density Parity Check) coded modulation bipartite graph)

## Fig. 25A

input

may implement decoding
functionality in log domain

### check node update

use forward-backward
procedure to calculate
alphas, betas

update edge
messages
using alphas,
betas

### symbol sequence estimate and symbol node update

compute possible soft symbol estimates

during last iteration

update edge
messages using older
edge messages

estimate symbols using
possible soft symbol
estimates (hard limiting)

may be implemented
using min* processing

may be implemented using min* processing

best estimates of symbols

symbol decoding functionality (supported with LDPC (Low Density Parity Check) coded modulation bipartite graph)

## Fig. 25B

I,Q values

symbol metric

may be implemented using min* processing

initialized LLR bit edge message and symbol metric (during 1st iteration)

operates similar to check node operator (e.g., see Fig. 19)

during 1st iteration

**m-bit symbol metric computer**

**check node update**

update edge messages

update bit edge messages using updated bit edge messages passed by last iteration

**symbol sequence estimate and symbol node update**

compute possible soft symbol estimates

update bit edge messages using symbol metric combined with bit edge messages passed by last iteration

during last iteration

bit estimates (based on soft symbol estimate)

estimate symbols using possible soft symbol estimates

hard limiter

**LLR bit edge message initial-ization (for 1st iteration)**

initialized LLR bit edge message

iterative decoding processing

hybrid decoding functionality (having reduced complexity of symbol decoding) of LDPC coded modulation signals

## Fig. 26

may be implemented using min* processing

I,Q values

symbol metric

initialized LLR bit edge message and symbol metric (during 1st iteration)

operates similar to check node operator (e.g., see Fig. 19)

during 1st iteration

m-bit symbol metric computer

check node update

symbol sequence estimate and symbol node update

update edge messages

estimate symbols using possible soft symbol estimates

syndrome check passes (or last iteration)

update bit edge messages using updated bit edge messages passed by last iteration

compute possible soft symbol estimates

hard limiter

syndrome calculator

LLR bit edge message initial-ization (for 1st iteration)

bit estimates (based on soft symbol estimate)

update bit edge messages using symbol metric combined with bit edge messages passed by last iteration

syndrome check failed (and not last iteration)

initialized LLR bit edge message

iterative decoding processing

EP 1 523 099 A1

hybrid decoding functionality (having reduced complexity of symbol decoding) of LDPC coded modulation signals

**Fig. 27**

4-D (4-dimensional) QPSK constellation
**Fig. 28A**

4-D (4-dimensional) 8 PSK constellation
**Fig. 28B**

alternative representation of 4-D 8 PSK constellation set

Fig. 29

EP 1 523 099 A1

```
                              ┌──────────┐
                              │  begin   │
                              └────┬─────┘
                                   ▼
┌─────────────────────────────────────────────────────────────────────────────────┐
│                      generating 1-D n-bit Gray code                               │
│  ┌──────────────┐  ┌───────────────────────────────────────────────────────────┐ │
│  │  n=log(M)    │  │ find set of basic Gray codes (e.g., 1-D Gray codes         │ │
│  │              │  │ starting from all 0 vector)                                │ │
│  └──────────────┘  └───────────────────────────────────────────────────────────┘ │
└─────────────────────────────────────┬─────────────────────────────────────────────┘
                                       ▼
┌───────────────────────────────────────────────────────────────────────────────────┐
│   selecting one of the n-bit symbols to be mapped to Gray code map ($G(A_0)$)        │
└─────────────────────────────────────┬─────────────────────────────────────────────┘
                                       ▼
┌───────────────────────────────────────────────────────────────────────────────────┐
│ selecting a plurality (m) of 1-D (1-Dimensional) Gray codes from the set of basic   │
│ 1-D Gray codes                                                                      │
└─────────────────────────────────────┬─────────────────────────────────────────────┘
                                       ▼
┌───────────────────────────────────────────────────────────────────────────────────┐
│ partitioning of the bit-code set {1,...,mn} into a plurality (m) of sets ($T_m$)    │
│ that satisfy Gray mapping condition                                                 │
└─────────────────────────────────────┬─────────────────────────────────────────────┘
                                       ▼
┌───────────────────────────────────────────────────────────────────────────────────┐
│ assigning the selected plurality (m) of 1-D Gray codes (e.g., selected from the set │
│ of basic Gray codes) to the projection maps (of corresponding 1-D n-bit Gray codes) │
└─────────────────────────────────────┬─────────────────────────────────────────────┘
                                       ▼
┌───────────────────────────────────────────────────────────────────────────────────┐
│ assigning initial projection map to all other (e.g., M-1) projection maps           │
└─────────────────────────────────────┬─────────────────────────────────────────────┘
                                       ▼
┌───────────────────────────────────────────────────────────────────────────────────┐
│ transforming all projections back to mn-bit vectors according to partitioning       │
│ ($T_k$) thereby obtaining the vectors generated by the elementary vector Gray code  │
│ mapping                                                                             │
└─────────────────────────────────────┬─────────────────────────────────────────────┘
                                       ▼
┌───────────────────────────────────────────────────────────────────────────────────┐
│ generating all other Gray code mapped vectors using vectors generated by the        │
│ elementary vector Gray code mapping                                                 │
└─────────────────────────────────────┬─────────────────────────────────────────────┘
                                       ▼
                              ┌──────────┐
                              │   end    │
                              └──────────┘
```

method for m-D (m-dimensional) Gray code map construction for 2m-D M PSK modulation (M is an integer)

## Fig. 30

LDPC coded modulation encoding to support 4-D (4-dimensional) phase modulation

**Fig. 31A**

map I

map II

two 1-D (1-dimensional) 3 bit basic Gray code maps (shown using 8 PSK shaped constellations)

**Fig. 31B**

$$
\begin{array}{llllll}
A_{00} & A_{01} & A_{02} & A_{03} & A_{04} & A_{05} \\
A_{10} & A_{11} & A_{12} & A_{13} & A_{14} & A_{15} \\
A_{20} & A_{21} & A_{22} & A_{23} & A_{24} & A_{25} \\
A_{30} & A_{31} & A_{32} & A_{33} & A_{34} & A_{35} \\
A_{40} & A_{41} & A_{42} & A_{43} & A_{44} & A_{45} \\
A_{50} & A_{51} & A_{52} & A_{53} & A_{54} & A_{55} \\
A_{60} & A_{61} & A_{62} & A_{63} & A_{64} & A_{65}
\end{array}
$$

$\longrightarrow$ Gx $\longrightarrow$

| 0 | 1 | 11 | 10 | 12 | 13 | 3 | 2 |
|----|----|----|----|----|----|----|----|
| 40 | 41 | 51 | 50 | 52 | 53 | 43 | 42 |
| 60 | 61 | 71 | 70 | 72 | 73 | 63 | 62 |
| 20 | 21 | 31 | 30 | 32 | 33 | 23 | 22 |
| 24 | 25 | 35 | 34 | 36 | 37 | 27 | 26 |
| 64 | 65 | 75 | 74 | 76 | 77 | 67 | 66 |
| 4 | 5 | 15 | 14 | 16 | 17 | 7 | 6 |

2-D (2-dimensional) Gray code map (Gx) for rate 5/6 8PSK LDPC coded modulation

**Fig. 32**

performance comparison of two LDPC (Low Density Parity Check) coded modulation systems

**Fig. 33**

**European Patent Office**

**EUROPEAN SEARCH REPORT**

Application Number

EP 04 00 9996

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| Y | EP 0 836 305 A (BRITISH TELECOMM) 15 April 1998 (1998-04-15) * page 2, line 20 - page 3, line 47 * * page 2, line 58 * * claims 1-3 * * abstract * | 1-10 | H03M13/05 H03M13/15 H03M13/25 G06N3/02 H03M13/00 H04L1/00 H04L27/26 H03M13/31 |
| Y | FORNEY G D ET AL: "EFFICIENT MODULATION FOR BAND-LIMITED CHANNELS" IEEE JOURNAL ON SELECTED AREAS IN COMMUNICATIONS, IEEE INC. NEW YORK, US, vol. 2, no. 5, September 1984 (1984-09), pages 632-647, XP002058648 ISSN: 0733-8716 * the whole document * * page 637, column 1, paragraph B * * page 638, column 1, line 1 - line 14 * | 1-10 | |
| Y | WADAYAMA T: "A CODED MODULATION SCHEME BASED ON LOW DENSITY PARITY CHECK CODES" IEICE TRANSACTIONS ON FUNDAMENTALS OF ELECTRONICS, COMMUNICATIONS AND COMPUTER SCIENCES, INSTITUTE OF ELECTRONICS INFORMATION AND COMM. ENG. TOKYO, JP, vol. E84A, no. 10, October 2001 (2001-10), pages 2523-2527, XP001107784 ISSN: 0916-8508 * figure 1 * * the whole document * * page 2526 * * page 2526, column 2, line 8 - line 17 * | 1-10 | TECHNICAL FIELDS SEARCHED (Int.Cl.7) H03M G06N H04L |
| Y | US 2002/042899 A1 (COOKLEV TODOR ET AL) 11 April 2002 (2002-04-11) * abstract * * figure 3 * * paragraph [0007] * * paragraph [0001] - paragraph [0019] * | 1-10 | |

-/--

The present search report has been drawn up for all claims

| Place of search | Date of completion of the search | Examiner |
|---|---|---|
| The Hague | 7 January 2005 | Rydyger, K |

EPO FORM 1503 03.82 (P04C01)

**European Patent Office**

## EUROPEAN SEARCH REPORT

Application Number

EP 04 00 9996

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 2003/074626 A1 (ELEFTHERIOU EVANGELOS S ET AL) 17 April 2003 (2003-04-17) <br> * abstract * <br> * paragraph [0010] * <br> * paragraph [0028] * <br> * paragraph [0031] * <br> * paragraphs [0051] - [0070] * <br> * paragraph [0074] * <br> * paragraph [0064] * <br> ----- | 1-10 | |
| Y | WEI L-F: "TRELLIS-CODED MODULATION WITH MULTIDIMENSIONAL CONSTELLATIONS" IEEE TRANSACTIONS ON INFORMATION THEORY, IEEE INC. NEW YORK, US, vol. IT-33, no. 4, July 1987 (1987-07), pages 483-501, XP000979357 ISSN: 0018-9448 * the whole document * <br> ----- | 1-10 | |
| A | ELEFTHERIOU E ET AL: "Low-density parity-check codes for digital subscriber lines" ICC 2002. 2002 IEEE INTERNATIONAL CONFERENCE ON COMMUNICATIONS. CONFERENCE PROCEEDINGS. NEW YORK, NY, APRIL 28 - MAY 2, 2002, IEEE INTERNATIONAL CONFERENCE ON COMMUNICATIONS, NEW YORK, NY : IEEE, US, vol. VOL. 1 OF 5, 28 April 2002 (2002-04-28), pages 1752-1757, XP010589787 ISBN: 0-7803-7400-2 * the whole document * * figure 2 * <br> ----- | 1-10 | TECHNICAL FIELDS SEARCHED (Int.Cl.7) |

The present search report has been drawn up for all claims

| Place of search | Date of completion of the search | Examiner |
|---|---|---|
| The Hague | 7 January 2005 | Rydyger, K |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 04 00 9996

This annex lists the patent family members relating to the patent documents cited in the above-mentioned European search report.
The members are as contained in the European Patent Office EDP file on
The European Patent Office is in no way liable for these particulars which are merely given for the purpose of information.

07-01-2005

| Patent document cited in search report | | Publication date | Patent family member(s) | | Publication date |
|---|---|---|---|---|---|
| EP 0836305 | A | 15-04-1998 | EP | 0836305 A2 | 15-04-1998 |
| | | | CA | 2106844 A1 | 29-09-1992 |
| | | | CA | 2106848 A1 | 29-09-1992 |
| | | | DE | 69226361 D1 | 27-08-1998 |
| | | | DE | 69226361 T2 | 24-12-1998 |
| | | | DE | 69233373 D1 | 29-07-2004 |
| | | | DK | 577672 T3 | 26-04-1999 |
| | | | EP | 0577670 A1 | 12-01-1994 |
| | | | EP | 0577672 A1 | 12-01-1994 |
| | | | WO | 9217971 A1 | 15-10-1992 |
| | | | WO | 9217972 A1 | 15-10-1992 |
| | | | HK | 1013548 A1 | 19-05-2000 |
| | | | JP | 3253958 B2 | 04-02-2002 |
| | | | JP | 6506328 T | 14-07-1994 |
| | | | JP | 6506329 T | 14-07-1994 |
| | | | US | 5493586 A | 20-02-1996 |
| | | | US | 5623516 A | 22-04-1997 |
| US 2002042899 | A1 | 11-04-2002 | AU | 6709601 A | 24-12-2001 |
| | | | CA | 2409179 A1 | 20-12-2001 |
| | | | EP | 1290802 A1 | 12-03-2003 |
| | | | JP | 2004503979 T | 05-02-2004 |
| | | | WO | 0197387 A1 | 20-12-2001 |
| US 2003074626 | A1 | 17-04-2003 | NONE | | |

EPO FORM P0459